# EUROPEAN PATENT APPLICATION

(11) **EP 2 090 933 A1**
(43) Date of publication of application: **19.08.2009**
(21) Application number: 09152136.9
(22) Date of filing: 05.02.2009
(51) Int. Cl.: G03F 7/11, B41C 1/10, B41M 5/36, G03F 7/30

(54) **Lithographic printing plate precursor and printing method**

(30) Priority: 05.02.2008 JP 2008025228
(71) Applicant: FUJIFILM Corporation, Minato-ku Tokyo (JP)
(72) Inventor: Iwai, Yu c/o FUJIFILM Corporation, Shizuoka (JP); Araki, Katsumi c/o FUJIFILM Corporation, Shizuoka (JP); Sonokawa, Koji c/o FUJIFILM Corporation, Shizuoka (JP)
(74) Representative: HOFFMANN EITLE

(57) **Abstract**

A lithographic printing plate precursor includes a support, an image-recording layer and a protective layer in this order, wherein the protective layer contains a stratiform compound and the image-recording layer contains a polymer compound having a phosphonium structure in a side chain.

## Description

### FIELD OF THE INVENTION

The present invention relates to a lithographic printing plate precursor. More specifically, it relates to a lithographic printing plate precursor which can be used in the laser image recording and on-machine development (on-press development) and a printing method using this lithographic printing plate precursor.

### BACKGROUND OF THE INVENTION

In general, a lithographic printing plate is composed of an oleophilic image area accepting ink and a hydrophilic non-image area accepting dampening water in the process of printing. Lithographic printing is a printing method utilizing the nature of water and an oily ink to repel with each other and comprising rendering the oleophilic image area of the lithographic printing plate to an ink-receptive area and the hydrophilic non-image area thereof to a dampening water-receptive area (ink-unreceptive area), thereby making a difference in adherence of the ink on the surface of the lithographic printing plate, depositing the ink only to the image area, and then transferring the ink to a printing material, for example, paper.

In order to produce the lithographic printing plate, a lithographic printing plate precursor (PS plate) comprising a hydrophilic support having provided thereon an oleophilic photosensitive resin layer (image-recording layer) has heretofore been broadly used. Ordinarily, the lithographic printing plate is obtained by conducting plate-making according to a method of exposing the lithographic printing plate precursor through an original, for example, a lith film, and then while leaving the part forming the image area of the image-recording layer, removing the unnecessary image-recording layer in other parts by dissolving with an alkaline developer or an organic solvent to reveal the hydrophilic surface of support to form the non-image area.

In the hitherto known plate-making process of lithographic printing plate precursor, after exposure, the step of removing the unnecessary image-recording layer by dissolving, for example, with a developer is required. However, it is one of the subjects to save or simplify such an additional wet treatment described above. Particularly, since disposal of liquid wastes discharged resulting from the wet treatment has become a great concern throughout the field of industry in view of the consideration for global environment in recent years, the demand for the solution of the above-described subject has been increased more and more.

As one of simple plate-making methods in response to the above-described requirement, a method referred to as on-machine development has been proposed wherein a lithographic printing plate precursor having an image-recording layer capable of being removed in the unnecessary areas during a conventional printing process is used and after exposure, the unnecessary area of the image-recording layer is removed on a printing machine to prepare a lithographic printing plate.

Specific methods of the on-machine development include, for example, a method of using a lithographic printing plate precursor having an image-recording layer that can be dissolved or dispersed in dampening water, an ink solvent or an emulsion of dampening water and ink, a method of mechanically removing an image-recording layer by contact with rollers or a blanket cylinder of a printing machine, and a method of lowering the cohesion force of an image-recording layer or adhesion between an image-recording layer and a support upon penetration of dampening water, ink solvent or the like and then mechanically removing the image-recording layer by contact with rollers or a blanket cylinder of a printing machine.

In the invention, unless otherwise indicated particularly, the term "development processing step" means a step of using an apparatus (ordinarily, an automatic developing machine) other than a printing machine and removing an unexposed area to infrared laser in an image-recording layer of a lithographic printing plate precursor upon contact with liquid (ordinarily, an alkaline developer) thereby revealing a hydrophilic surface of support, The term "on-machine development" means a method or a step of removing an unexposed area in an image-recording layer of a lithographic printing plate precursor upon contact with liquid (ordinarily, printing ink and/or dampening water) by using a printing machine thereby revealing a hydrophilic surface of support.

On the other hand, digitalization techniques of electronically processing, accumulating and outputting image information using a computer have been popularized in recent years, and various new image-outputting systems responding to the digitalization techniques have been put into practical use. Correspondingly, attention has been drawn to the computer-to-plate (CTP) technique of carrying digitalized image information on highly converging radiation, for example, a laser beam and conducting scanning exposure of a lithographic printing plate precursor with the radiation thereby directly preparing a lithographic printing plate without using a lith film. Thus, it is one of the important technical subjects to obtain a lithographic printing plate precursor adaptable to the technique described above. As described above, in recent years, the simplification of plate-making operation and the realization of dry system and non-processing system have been further strongly required from both aspects of the consideration for global environment and the adaptation for digitization.

As a lithographic printing plate precursor meeting the above-described requirement, use has been made of lithographic printing plate precursors having a photo- and/or heat-polymerizable image-recording layer. These lithographic printing plate precursors are provided with a protective layer (overcoat layer) on the image-recording layer in order to impart oxygen blocking properties, prevent the image-recording layer from scratch formation, and prevent abrasion which might occur at high-illuminance laser exposure. Examples of the material for the protective layer include polyvinyl alcohol, polyvinylpyrrolidone, polyvinyl imidazole, water-soluble acrylic resins such as polyacrylic acid, gelatin, gum arabic and cellulose-based polymers (for example, carboxymethylcellulose). It is known that, by further adding a stratiform compound such as mica thereto, the oxygen blocking properties can be further improved and scratch formation can be moreover prevented (see, for example, JP-A-2001-171250 and JP-A-2005-119273 (corresponding to US2005/0069811A1)).

In the case of using a stratiform compound in the protective layer, it is sometimes observed that one or more of the performances such as ink deposition properties at the early stage of printing, ink deposition properties in the course of printing, on-machine developability and so on are lowered. In the case of adding a stratiform compound such as mica to a water-soluble polymer appropriately usable as the protective layer such as polyvinyl alcohol, polyvinylpyrrolidone, polyacrylic acid or a cellulose-based polymer, in particular, it is frequently observed that developability and ink deposition properties are lowered, though favorable oxygen blocking properties contributes to the progress of the polymerization and thus improves printing durability. Thus, it is an important technical problem to overcome these difficulties.

To prevent the lowering in ink deposition properties, it has been proposed to add a phosphonium compound to an image-recording layer or a protective layer (see, for example, JP-A-2006-297907 (corresponding to US2006/0194150A1) and JP-A-2007-50660 (corresponding to US2007/0042293A1)). However, these methods are still insufficient from the standpoint of achieving printing durability, on-machine developability and ink deposition properties all at excellent levels.

### SUMMARY OF THE INVENTION

An object of the present invention is to provide a lithographic printing plate precursor which contains a stratiform compound in the protective layer, allows efficient image formation upon laser exposure and is yet excellent in printing durability, ink deposition properties and on-machine developability and a lithographic printing method using the same.

To achieve the above-described object, the present inventors examined various polymer compounds. As a result, they have found out that the above problem can be solved by using a polymer compound having a phosphonium structure in its side chain, thus completing the invention.

Accordingly, the invention includes the following items.
1. A lithographic printing plate precursor comprising in the following order; a support; an image-recording layer; and a protective layer, wherein the protective layer contains a stratiform compound and the image-recording layer contains a polymer compound having a phosphonium structure in its side chain.
2. The lithographic printing plate precursor as described in 1 above, wherein the phosphonium structure is represented by the following formula (1): 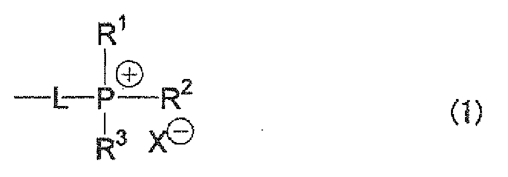 In the formula (1), R¹ to R³ each independently represents an alkyl group, an alkenyl group, an alkynyl group, an aryl group or a heterocyclic group, or at least two of R¹ to R³ may be bonded together to form a cyclic structure. X⁻ represents an anion. L represents a linking group bonded to the main chain of the polymer.
3. The lithographic printing plate precursor as described in 1 or 2 above, wherein the image-recording layer contains a sensitizing dye, a radical generator and a polymerizable monomer.
4. The lithographic printing plate precursor as described in any of 1 to 3 above, wherein the image recording layer allows image formation by, after exposure, supplying a printing ink and dampening water to the lithographic printing plate precursor on a printing machine and thus removing the image-recording layer in an unexposed area.
5. A printing method comprising the step of imagewisely exposing the lithographic printing plate precursor as described in 4 above, and the printing step of supplying an oily ink and dampening water to the exposed lithographic printing plate precursor without conducting any development treatment, wherein the image-recording layer in an unexposed area is removed during the printing step.

According to the invention, a lithographic printing plate precursor which is excellent in ink deposition properties and on-machine developability while sustaining good printing durability can be obtained by adding a polymer compound having a phosphonium structure in its side chain.

Although it is not clarified how the excellent effects are established on ink deposition properties and on-machine developability by adding a polymer compound having a phosphonium structure in its side chain (hereinafter, called "specific polymer compound"), the function mechanism is estimated as follows.

Namely, it is considered that in the case where the image-recording layer has the specific polymer compound, the phosphonium structure site of the specific polymer compound adsorbs to the stratiform compound in the protective layer or the stratiform compound having migrated from the protective layer into the image recording layer, which makes it possible to prevent a decrease in ink deposition properties or lowering in on-machine developability caused by the stratiform compound. Moreover, it is considered that because of being a high-molecular compound, the specific polymer compound can more strongly adsorb to the stratiform compound than a low-molecular compound and thus the above-described effect can be further improved.

In the case of attempting to add such a specific polymer compound to the protective layer, it is frequently observed that the specific polymer compound aggregates together with the stratiform compound and settles out in the coating solution, which makes the coating impossible. In the invention, the specific polymer compound is added to the image-recording layer and thus coating can be conducted without causing such aggregation or settling out, thereby overcoming the problem as described above. Namely, the addition of the specific polymer compound to the photosensitive layer brings about a surprising result that the troubles caused by the stratiform compound contained in the protective layer can be prevented thereby.

### BRIEF DESCRIPTION OF THE DRAWING

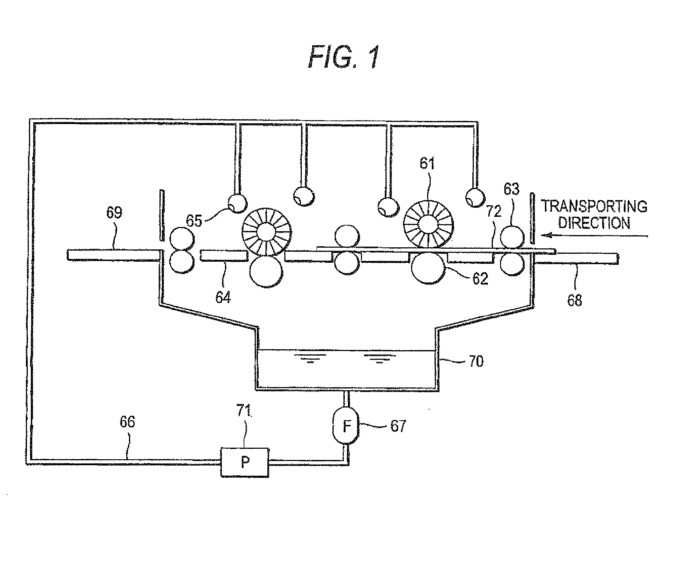

Fig. 1 is a diagram which illustrates the structure of an automatic developing machine.

### [Description of the Reference Numerals]

61: Rotating brush roll
62: Receiver roll
63: Transporting roll
64: Transport guide plate
65: Spray pipe
66: Pipe line
67: Filter
68: Plate feed tray
69: Plate discharge tray
70: Developer tank
71: Circulation pump
72: Plate

### DETAILED DESCRIPTION OF THE INTENTION

### «Lithographic printing plate precursor»

The lithographic printing plate precursor according to the invention comprises a hydrophilic support, an image-recording layer and a protective layer in this order, wherein the protective layer contains a stratiform compound and the image-recording layer contains a polymer compound having a phosphonium structure in its side chain. In particular, it is preferable that, in the lithographic printing plate precursor according to the invention, the image recording layer allows image formation by, after exposure, supplying a printing ink and dampening water (fountaion solution) to the lithographic printing plate precursor on a printing machine and thus removing the image-recording layer in an unexposed area (i.e., being on-machine developable).

Next, the lithographic printing plate precursor according to the invention will be described in greater detail.

### <Image-recording layer>

To improve the film characteristics of the image-recording layer and ink deposition properties and on-machine developability, the image-recording layer according to the invention contains (C) a polymer compound having a phosphonium structure in its side chain (hereinafter, optionally called "specific polymer compound").

It is preferable that the image-recording layer according to the invention contains (A) a sensitizing dye, (B) a radical generator and (D) a polymerizable monomer. It is still preferable that the image-recording layer allows image formation with a laser, in particular, an infrared laser or a blue laser.

In addition to these constituents, the image-recording layer according to the invention may further contain other components if required.

Next, the components of the image-recording layer and the formation of the image-recording layer will be illustrated.

### [(C) Specific polymer compound]

The specific polymer compound of the invention is not particularly restricted so long as being a polymer having a phosphonium structure in its side chain. As the phosphonium structure, a structure represented by the following formula (1) is preferred.

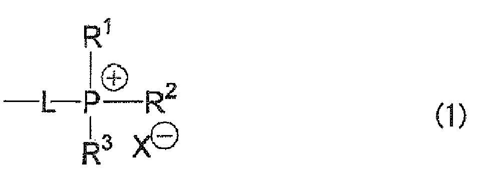

In the formula (I), R¹ to R³ each independently represents an alkyl group, an alkenyl group, an alkynyl group, an aryl group or a heterocyclic group, or at least two of R¹ to R³ may be bonded together to form a cyclic structure. X⁻ represents an anion. L represents a linking group bonded to the main chain of the polymer.

As the alkyl groups R¹ to R³ in the formula (1), straight-chain, branched or cyclic alkyl groups may be cited. Among them, straight-chain alkyl groups having 1 to 20 carbon atoms, branched alkyl groups having 3 to 12 carbon atoms and cyclic alkyl groups having 5 to 10 carbon atoms are more preferable. Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group and a 2-norbornyl group.

As the alkenyl groups represented by R¹ to R³, alkenyl groups having 2 to 20 carbon atoms may be cited. Among them, alkenyl groups having 2 to 10 carbon atoms are more preferable and alkenyl groups having 2 to 8 carbon atoms are still more preferable. These alkenyl groups may have a substituent. Examples of the substituent that can be introduced include a halogen atom, an alkyl group, a substituted alkyl group, an aryl group and a substituted aryl group, and halogen atom and a straight-chain, branched or cyclic alkyl group having I to 10 carbon atoms are preferred.

Specific examples of the alkenyl groups include a vinyl group, a 1-propenyl group, a 1-butenyl group, a cinnamyl group, a 1-pentenyl group, a 1-hexenyl group, a 1-octenyl group, a 1-methyl-1-propneyl group, a 2-methyl-1-propenyl group, a 2-methyl-1-butenyl group, a 2-phenyl-1-ethenyl group, a 2-chloro-1-ethenyl group, an allyl group, a 2-butenyl group, a 2-methylallyl group, a 2-methyl-3-butenyl group, and a 3-methyl-2-butenyl group.

As the alkynyl groups represented by R¹ to R³, alkynyl groups having 2 to 20 carbon atoms may be cited. Among them, alkynyl groups having 2 to 10 carbon atoms are more preferable and alkynyl groups having 2 to 8 carbon atoms are still more preferable. Specific examples thereof include an ethynyl group, a 1-propynyl group, a 1-butynyl group, a phenylethynyl group, a trimethylsilylethynyl group, a 2-propynyl group, a 2-butynyl group and a 3-butynyl group.

Appropriate examples of the aryl groups represented by R¹ to R³ include a phenyl group, a naphthyl group, a tolyl group, a xylyl group, a fluorophenyl group, a chlorophenyl group, a bromophenyl group, a methoxyphenyl group, an ethoxyphenyl group, a dimethoxyphenyl group, a methoxycarbonylphenyl group and a dimethylaminophenyl group.

Examples of the heterocyclic groups include a pyridyl group, a quinolyl group, a pyrimidinyl group, a thienyl group and a furyl group.

From the viewpoint of ink deposition properties, it is preferable that at least one of R¹ to R³ is an aryl group, in particular, a phenyl group. Among all, it is preferable that all of R¹ to R³ are phenyl groups.

As X⁻, F⁻, Cl⁻ Br⁻, I⁻, a benzenesulfonate anion, a methylsulfate anion, an ethylsulfate anion, a propylsulfate anion, an optionally branched butylsulfate anion, an optionally branched amylsulfate anion, which may each have a substituent, PF₆⁻, BF₄⁻ and B(C₆F₅)₄⁻ are preferred. Among them, F⁻, Cl⁻, Br⁻, I⁻, a benzenesulfonate anion, a toluenesulfonate anion, a methylsulfate anion, an ethylsulfate anion, a propylsulfate anion, an optionally branched butylsulfate anion, PF₆⁻, BF₄⁻ and B(C₆F₅)₄⁻ are still preferred, and Cl⁻, Br⁻, a benzenesulfonate anion, a toluenesulfonate anion, a methylsulfate anion, an methylsulfate anion, a propylsulfate anion, PF₆⁻, BF₄⁻ and B(C₆F₅)₄⁻ are particularly preferred.

L represents a monovalent or divalent linking group bonded to the main chain of the polymer. In the case where the divalent linking group represented by L is a divalent organic linking group, the divalent organic linking group preferably consists of I to 60 carbon atoms, 0 to 10 nitrogen atoms, 0 to 50 oxygen atoms, 1 to 100 hydrogen atoms and 0 to 20 sulfur atoms.

Specific examples of the divalent linking group represented by L include the following divalent groups or groups formed by appropriately combining the same.

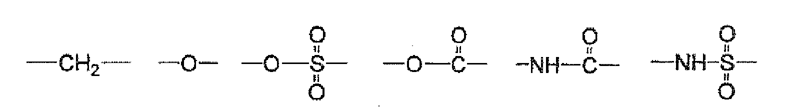

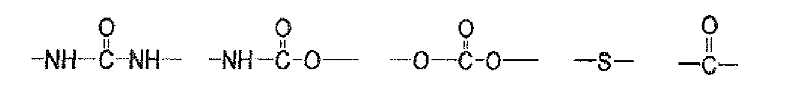

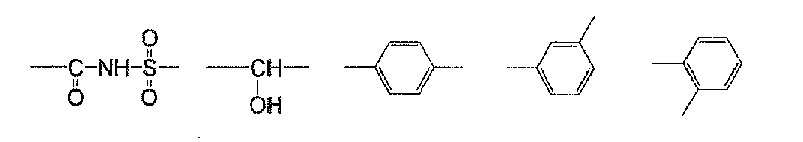

More specifically, it is preferable that the divalent linking group represented by L is a divalent group represented by any one of the following structural formulae.

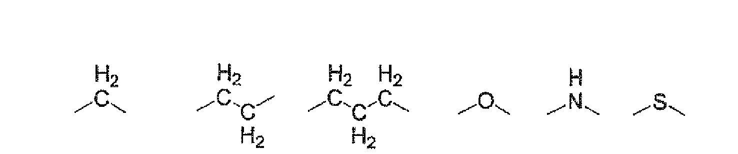

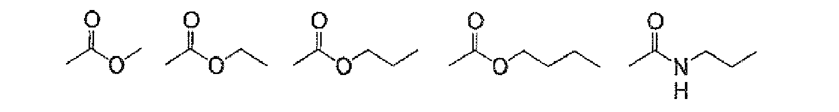

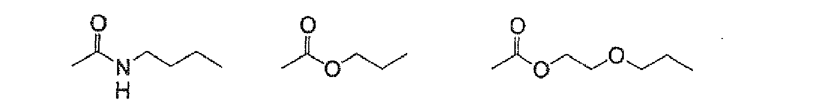

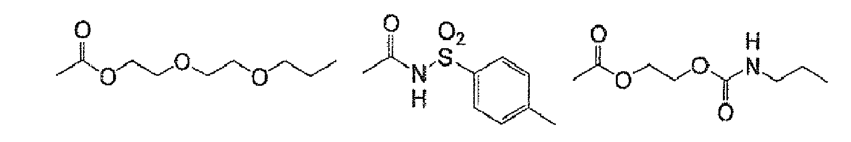

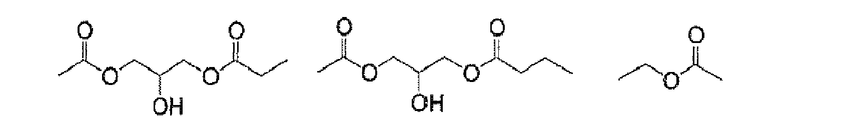

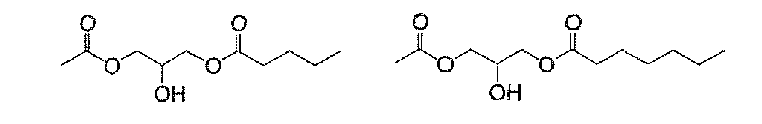

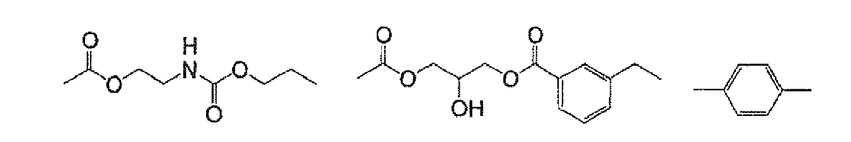

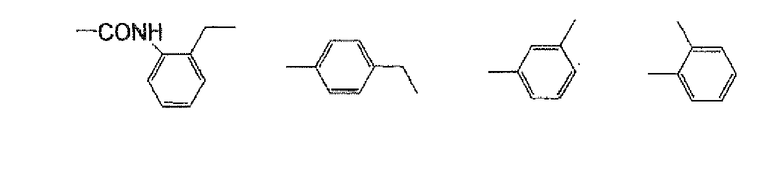

The specific polymer compound according to the invention (a polymer compound having a phosphonium structure in its side chain) is not particularly restricted so long as being a polymer having a phosphonium structure in its side chain. The polymer chain may be formed by any of addition polymerization, polycondensation, ring-opening polymerization and polyaddition. The phosphonium structure may be introduced as a side chain into the main chain by either a polymerizing reaction or a polymer-forming reaction with the use of a monomer having the phosphonium structure in its side chain.

Among all, a polymer compound having a structural unit represented by the following formula (2) can be cited as a preferred specific polymer compound.

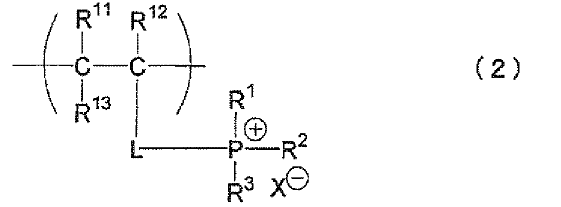

In the formula (2), R¹ to R³, L and X⁻ respectively have the same meanings as defined in the formula (1). R¹¹ to R¹³ each independently represents a hydrogen atom, an alkyl group having 1 to 6 carbon atoms which may have a substituent or a halogen atom. It is particularly preferred that R¹¹ and R¹³ are hydrogen atoms while R¹² is a hydrogen atom or a methyl group.

To improve various properties such as image strength, the specific polymer compound having the structural unit represented by the above formula (2) may contain another copolymerizable component so long as the advantage of the invention is not damaged thereby.

As the other copolymerizable component, a structural unit represented by the following formula (3) may be cited.

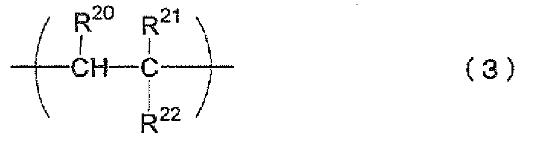

In the formula (3), R²⁰ represents a hydrogen atom or a substituent. It is preferable that R²⁰ represents a hydrogen atom, an alkyl group or a carboxyl group, more preferably a hydrogen atom, a methyl group or a carboxyl group. R²¹ represents a hydrogen atom or an alkyl group which may have a substituent. More preferably, R²¹ represents a hydrogen atom, a methyl group or a carboxymethyl group. R²² represents a hydrogen atom or a substituent. R²² and R²⁰ may be bonded together to form a ring.

Examples of the substituent represented by R²² include an alkyl group, an aryl group, a heterocyclic group, an ester group, an amido group, a cyano group, a carboxyl group, a substituted carbonyl group, a substituted oxy group and a halogen atom. Among these groups, those capable of having a substituent may further have a substituent.

As preferable examples of the alkyl group represented by R²², straight-chain, branched or cyclic alkyl groups having 1 to 20 carbon atoms may be cited. Among them, straight-chain alkyl groups having 1 to 20 carbon atoms, branched alkyl groups having 3 to 12 carbon atoms and cyclic alkyl groups having 5 to 10 carbon atoms are more preferable. Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group and a 2-norbomyl group.

The aryl group represented by R²² is preferably a substituted or unsubstituted aryl group having 5 to 20 carbon atoms, more preferably 6 to 18 carbon atoms and particularly preferably 6 to 12 carbon atoms. The aryl group represented by R²² may further have a substituent.

Preferable examples thereof include a phenyl group, a 4-methylphenyl group, a 4-methoxyphenyl group, a 4-chlorophenyl group, a 4-(dimethylamino) group, a 1-naphthyl group, a 2-naphthyl group, a biphenyl group, a xylyl group, a mesityl group, a cumenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxyphenylcarbonyl group, a phenoxycarbonylphenyl group, an N-phenylcarbamoylphenyl group, a cyanophenyl group, a sulfophenyl group, a sulfonatophenyl group, a phosphonophenyl group and a phosphonatophenyl group.

The heterocyclic group represented by R²² is preferably a 3- to 8-membered ring, more preferably a 3- to 6-membered ring and particularly preferably a 5- to 6-membered ring. With respect to the kind of the hetero atom constituting the heterocycle, it is preferable to contain a nitrogen atom, an oxygen atom or a sulfur atom. The heterocyclic group represented by R²² may further have a substituent.

Preferable examples thereof include a pyrrole ring group, a furan ring group, a thiophene ring group, a benzopyrrole ring group, a benzofuran ring group, a benzothiophene ring group, a pyrazole ring group, a pyrrolidine ring group, a pyrrolidone ring group, an isoxazole ring group, an isothiazole ring group, an imidazole ring group, a benzoisoxazole ring group, a benzoisothiazole ring group, an oxazole ring group, a thiazole ring group, a triazole ring group, a benzoimidazole ring group, a benzooxazole ring group, a benzothiazole ring group, a pyridine ring group, a quinoline ring group, an isoquinoline ring group, a pyridazine ring group, a pyrimidine ring group, a pyrazine ring group, a phthaladine ring group, a quinazoline ring group, a quinoxaline ring group, an acylidine ring group, a phenantridine ring group, a carbazole ring group, a purine ring group, a pyran ring group, a piperidine ring group, a piperazine ring group, a morpholine ring group, an indole ring group, an indolidine ring group, a cromene ring group, a cinnoline ring group, an acridine ring group, a phenothiazine ring group, a tetrazole ring group and a triazine ring group.

The substituted carbonyl group represented by R²² is preferably a group represented by (R¹⁵-CO-). R¹⁵ represents a hydrogen atom or a substituent. Preferable examples of R²² include a formyl group, an acyl group, a carboxyl group, an alkoxycarbonyl group, an allyloxycarbonyl group, a carbamoyl group, an N-alkylcarbamoyl group, an N-N-dialkylcarbamoyl group, an N-arylcarbamoyl group, an N,N-diarylcarbamoyl group and an N-alkyl-N'-arylcarbamoyl group. As the alkyl and aryl groups in these groups, there can be enumerated those which are cited above with respect to the alkyl and aryl groups. Among them, more preferable examples of the substituted carbonyl group include a formyl group, an acyl group, a carboxyl group, an alkoxycarbonyl group, an aryloxycarbonyl group, a carbamoyl group, an N-alkylcarbamoyl group, an N,N-dialkylcarbamoyl group and an N-arylcarbamoyl group. Particularly preferable examples thereof include a formyl group, an acyl group, an alkoxycarbonyl group and an aryloxycarbonyl group.

Specifically preferable examples of R²² include a formyl group, an acetyl group, a benzoyl group, a carboxyl group, a methoxycarbonyl group, an ethoxycarbonyl group, an allyloxycarbonyl group, a dimethylaminophenylethenylcarbonyl group, a methoxycarbonylmethoxycarbonyl group, an N-methylcarbamoyl group, an N-phenylcarbamoyl group, an N,N-diethylcarbamoyl group and a morpholinocarbamoyl group.

As the substituted oxy group represented by R²², a group represented by (R¹⁶O-) is preferable. R¹⁶ represents a hydrogen atom or a substituent. Preferable examples of the substituted oxy group include a hydroxyl group, an alkoxy group, an aryloxy group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, a phosphonooxy group and a phosphonatoxy group. As the alkyl and aryl groups in these groups, there can be enumerated those which are cited above with respect to the alkyl and aryl groups. In the case where the substituted oxy group represented by R²² is an acyloxy group, specific examples of the acyl group include those cited above with respect to the substituted carbonyl group represented by R²². Among these substituents, an alkoxy group, an aryloxy group, an acyloxy group and an arylsulfoxy group are more preferable.

Preferable specific examples of the substituted oxy group include a methoxy group, an ethoxy group, a propyloxy group, an isopropyloxy group, a butyloxy group, a pentyloxy group, a hexyloxy group, a dodecyloxy group, a benzyloxy group, an allyloxy group, a phenethyloxy group, a cabroxyethyloxy group, a methoxycarbonylethyloxy group, an ethoxycarbonylethyloxy group, a methoxyethoxy group, a phenoxyethoxy group, a methoxyethoxyethoxy group, an ethoxyethoxyethoxy group, a morpholinoethoxy group, a morpholinopropoxy group, an allyloxyethoxyethoxy group, a phenoxy group, a tolyloxy group, a xylyloxy group, a mesityloxy group, a cumenyloxy group, a methoxyphenyloxy group, an ethoxyphenyloxy group, a chlorophenyloxy group, a bromophenyloxy group, an acetyloxy group, a benzoyloxy group, a naphthyloxy group, a phenylsulfonyloxy group, a phosphonooxy group and a phosphonatoxy group.

As the halogen atom represented by R²², a fluorine atom, a chlorine atom, a bromine atom and an iodine atom are preferable, and a fluorine atom, a chlorine atom and a bromine atom are more preferable.

As the ester group represented by R²², a group represented by (COOR¹⁷) is preferable. R¹⁷ represents an alkyl group, an aryl group or a heterocyclic group. As the alkyl, aryl or heterocyclic group therein, there can be enumerated those which are cited above with respect to the alkyl, aryl and heterocyclic groups in R²².

In the case where the group represented by R²² is capable of having a substituent, it may have further a substituent. Any group available as a substituent may be used and examples thereof include an alkyl group, an alkynyl group, a halogen atom (a fluorine atom, a chlorine atom, a bromine atom or an iodine atom), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an aryloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formal group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and its conjugated base group (hereinafter referred to as a "phosphonato group"), a dialkylphosphono group (-PO₃(alkyl)₂; "alkyl" means an alkyl group, the same applies hereinafter), a diarylphosphono group (-PO₃(aryl)₂; "aryl" means an aryl group, the same applies hereinafter), an alkylarylphosphono group (-PO₃(alkyl)(aryl)), a monoalkylphosphono group (-PO₃H(alkyl)) and its conjugated base group (hereinafter referred to as an "alkylphosphonato group"), a monoarylphosphono group (-PO₃H(aryl)) and its conjugated base group (hereinafter referred to as an "arylphosphonato group"), a phosphonooxy group (-OPO₃H₂) and its conjugated base group (hereinafter referred to as a "phosphonatoxy group"), a dialkylphosphonooxy group (-OPO₃(alkyl)₂), a diarylphosphonooxy group (-OPO₃(aryl)₂), an alkylarylphosphonooxy group (-OPO₃(alkyl)(aryl)), a monoalkylphosphonooxy group (-OPO₃H(alkyl)) and its conjugated base group (hereinafter referred to as an "alkylphosphonatoxy group"), a monoarylphosphonooxy group (-OPO₃H(aryl)) and its conjugated base group (hereinafter referred to as an "arylphosphonatoxy group"), a cyano group, a nitro group, a heterocyclic group and a silyl group.

These groups may be further bonded together to form a complex substituent.

Among all, an ester group, an amido group, a cyano group, a carboxyl group, an aryl group and a heterocyclic group are particularly preferred as R²².

Examples of the copolymerizable component forming the structural unit represented by the formula (3) include acrylic acid esters, methacrylic acid esters, acrylamides, methacrylamides, N-substituted acrylamides, N-substituted methacrylamides, N,N-di-substituted acrylamides, N,N-di-substituted methacrylamides, aromatic hydrocarbons having vinyl group, heterocyclic compounds having vinyl group, acrylic acid, methacrylic acid, itaconic acid, maleic acid, maleic anhydride, maleic amides, partially esterified maleic acid, partially amidified maleic acid, acrylonitriles, methacrylonitriles, vinyl ethers and vinyl ketones.

More specifically speaking, use is preferably made of alkyl acrylates (wherein the alkyl group preferably has 1 to 20 carbon atoms; for example, methyl acrylate, ethyl acrylate, propyl acrylate, butyl acrylate, amyl acrylate, ethylhexyl acrylate, octyl acrylate, t-octyl acrylate, chloroethyl acrylate, 2,2-dimethylhydroxypropyl acrylate, 5-hydroxypentyl acrylate, trimethylolpropane monoacrylate, pentaerythritol monoacrylate, glycidyl acrylate, benzyl acrylate, methoxybenzyl acrylate, furfuryl acrylate, tetrahydrofurfuryl acrylate, etc.), aryl acrylate (for example, phenyl acrylate, etc.), methacrylic acid esters, for example, alkyl methacrylate (wherein the alkyl group preferably has 1 to 20 carbon atoms; for example, methyl methacrylate, ethyl methacrylate, propyl methacrylate, isopropyl methacrylate, amyl methacrylate, hexyl methacrylate, cyclohexyl methacrylate, benzyl methacrylate, chlorobenzyl methacrylate, octyl methacrylate, 4-hydroxybutyl methacrylate, 5-hydroxypentyl methacrylate, 2,2-dimethyl-3-hydroxypropyl methacrylate, trimethylolpropane monomethacrylate, pentaerythritol monomethacrylate, glycidyl methacrylate, furfuryl methacrylate, tetrahydrofurfuryl methacrylate, etc.), aryl methacrylate (for example, phenyl methacrylate, cresyl methacrylate, naphthyl methacrylate, etc.), styrene, alkylstyrene (for example, methylstyrene, dimethylstyrene, trimethylstyrene, ethylstyrene, diethylstyrene, isopropylstyrene, butylstyrene, hexylstyrene, cyclohexylstyrene, decylstyrene, benzylstyrene, chloromethylstyrene, trifluoromethylstyrene, ethoxymethylstyrene, acetoxymethylstyrene, etc.), alkoxystyrene (for example, methoxystyrene, 4-methoxy-3-methylstyrene, dimethoxystyrene, etc.), halogenostyrene, (for example, chlorostyrene, dichlorostyrene, trichlorostyrene, tetrachlorostyrene, pentachlorostyrene, bromostyrene, dibromostyrene, iodostyrene, fluorostyrene, trifluorostyrene, 2-bromo-4-trifluoromethylstyrene, 4-fluoro-3-trifluoromethylstyrene, etc.), acrylonitrile, methacrylonitrile, vinylpyrrolidone, vinylcarbazole, vinylimidazole, vinyltriazole, radical-polymerizable compounds having carboxylate (for example, acrylic acid, methacrylic acid, itaconic acid, crotonic acid, isocrotonic acid, maleic acid, p-carboxylstyrene and metal salts of these acidic groups, ammonium salt compounds, etc.), methyl vinyl ketone, ethyl vinyl ketone, butyl vinyl ketone, isobutyl vinyl ketone, butyl vinyl ether, hexyl vinyl ether, phenoxyethyl vinyl ether, monomethyl maleate, monomethyl maleate, adamantyl (meth)acrylate, isobornyl (meth)acrylate, norbornane methyl (meth)acrylate, norbornene methyl (meth)acrylate, (meth)acrylamides having bicyclic structure such as adamantyl (meth)acrylamide, isobornyl (meth)acrylamide and norbornane methyl (meth)acrylamide, and monomers having bicyclic structure such as adamantyl itaconate and isobornyl (meth)itaconate.

It is also preferable that the structural unit of the formula (3) has a polyoxyalkylene group in its molecule. Examples of the polyoxyalkylene group include those represented by -O-(CH₂CH₂-O-)ₙ-R²³, -O-(CH(CH₃)CH₂-O-)ₙ-R²³ and -O-(CH₂CH(CH₃)-O)ₙ-R²³, wherein n is preferably from 1 to 10, more preferably from 1 to 6, still more preferably from 1 to 4 and particularly preferably from 1 to 2, n may be either a single numerical value or a mixture of two or more numerical values. In the case of such a mixture, n indicates the average. R²³ represents a substituent preferably having 1 to 30 carbon atoms, more preferably 1 to 20 carbon atoms, still more preferably 1 to 10 carbon atoms and particularly preferably 1 to 10 carbon atoms.

Examples of R²³ include a methyl group, an ethyl group, an n-propyl group, an i-propyl group, a cyclopropyl group, an n-butyl group, an i-butyl group, a sec-butyl group, a t-butyl group, a cyclobutyl group, an n-pentyl group, an i-pentyl group, a sec-pentyl group, a t-pentyl group, a neo-pentyl group, a cyclopentyl group, an n-hexyl group, an i-hexyl group, a sec-hexyl group, a t-hexyl group, a cyclohexyl group, a cyclohexylmethyl group, a cyclopentyl group, a cyclopropylmethyl group, a cyclohexylmethyl group, a cyclobutylmethyl group, a straight-chain or branched heptyl group, a cyclopentylethyl group, a straight-chain or branched octyl group, a straight-chain or branched nonyl group, a straight-chain or branched decyl group, a dodecyl group, a tetradecyl group, a hexadecyl group, an octadecyl group and an icosyl group. More preferable examples thereof include a methyl group, an ethyl group, an n-propyl group, an i-propyl group, a cyclopropyl group, an n-butyl group, an i-butyl group, a sec-butyl group, a t-butyl group, a cyclobutyl group, an n-pentyl group, an i-pentyl group, a sec-pentyl group, a t-pentyl group, a neo-pentyl group, a cyclopentyl group, an n-hexyl group, an i-hexyl group, a sec-hexyl group, a t-hexyl group, a cyclohexyl group, a cyclohexylmethyl group, a straight-chain or branched heptyl group, a cyclopentylethyl group, and a straight-chain or branched octyl group. Still preferable examples thereof include a methyl group, an ethyl group, an n-propyl group, an i-propyl group, an n-butyl group, an i-butyl group, a sec-butyl group, an n-hexyl group and a straight-chain or branched octyl group.

The specific polymer compound of the invention can contain multiple kinds of structural units having a phosphonium structure, Moreover, it can contain multiple kinds of structural units derived from a copolymerizable component.

In the specific polymer compound of the invention, the molar ratio of the structural unit(s) having a phosphonium structure to the structural unit(s) derived from the copolymerizable component preferably ranges from 1:99 to 100:0, more preferably from 10:90 to 100:0 and still more preferably from 30:70 to 90:10, though the invention is not particularly restricted thereto. Within this range, the advantage of the invention of achieving excellent ink deposition properties and on-machine developability while sustaining good printing durability becomes remarkable.

It is preferable that the specific polymer compound according to the invention has a mass-average molecular weight (Mw) of 2,000 or more. From the viewpoint of printing durability, it is more preferable that the mass-average molecular weight is from 10,000 to 300,000. From the viewpoint of developability, it is most preferable that the mass-average molecular weight is from 10,000 to 90,000. The specific polymer compound of the invention may contain an unreacted monomer. In this case, it is desirable that the content of the monomer in the specific polymer compound is 15% by mass or less.

The lithographic printing plate precursor may contain two or more kinds the specific polymer compound according to the invention.

Although the specific polymer compound of the invention is contained in the image-recording layer, it may be contained in the protective layer too. Furthermore, it may be contained in the undercoat layer.

The content of the specific polymer compound of the invention is preferably from 0.0005% by mass to 30.0% by mass based on the total solid matters in the image-recording layer, more preferably from 0.001% by mass to 20.0% by mass and most preferably from 0.002% by mass to 15.0% by mass. Within this range, excellent ink deposition properties can be obtained.

Next, specific examples of the specific polymer compound according to the invention will be presented. However, it is to be understood that the specific polymer compound of the invention is not restricted to the following examples and the structure and content thereof can be appropriately altered depending on the components of coating solutions to be used in preparing the printing plate precursor.
(1) 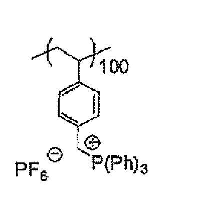
(2) 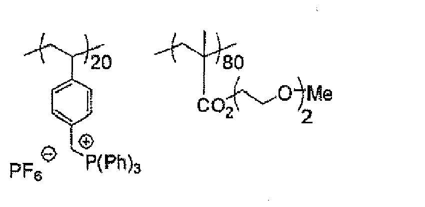
(3) 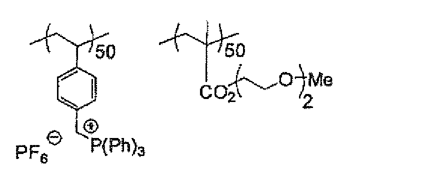
(4) 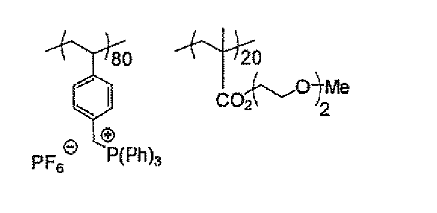
(5) 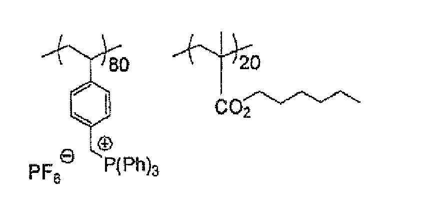
(6) 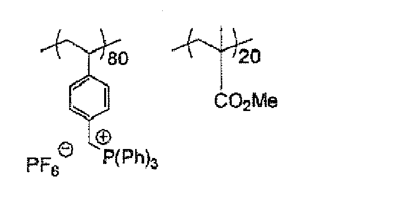
(7) 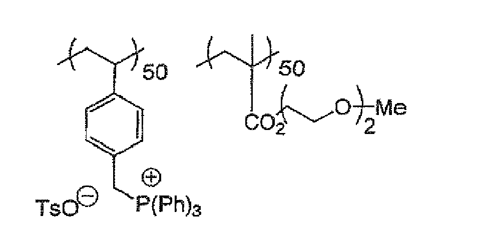
(8) 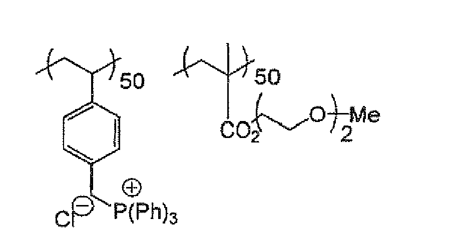
(9) 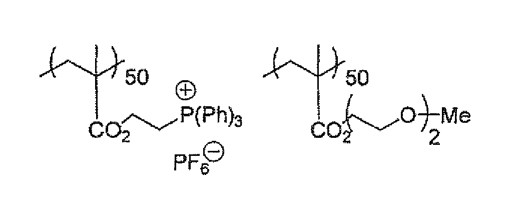
(10) 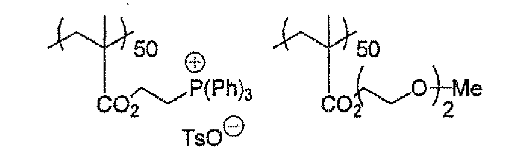
(11) 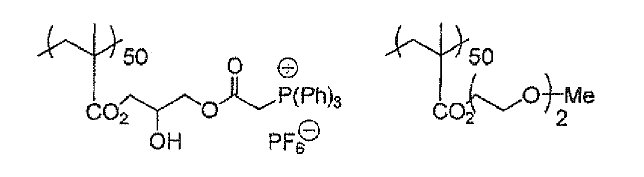
(12) 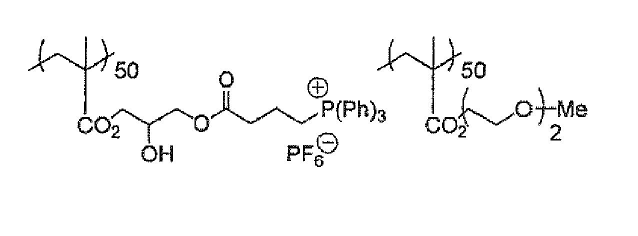
(13) 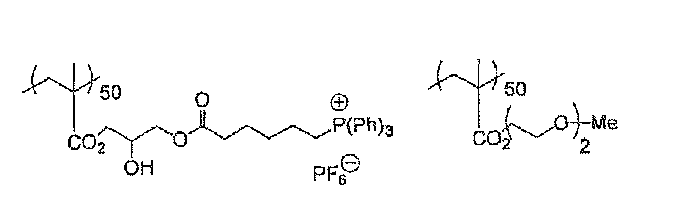
(14) 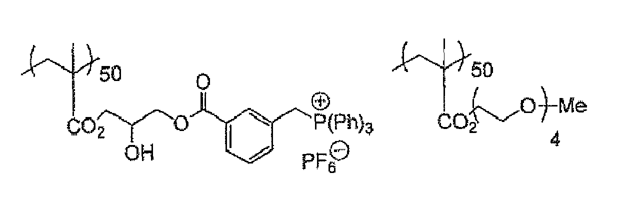
(15) 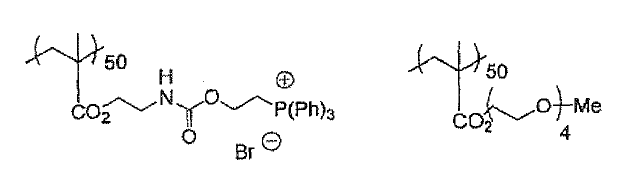
(16) 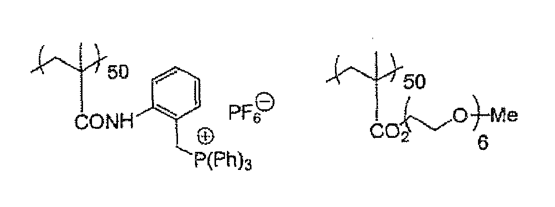
(17) 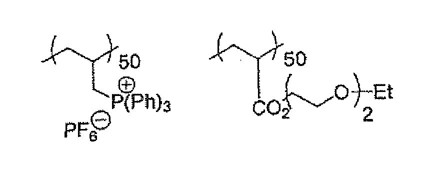
(18) 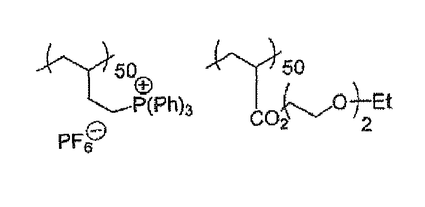
(19) 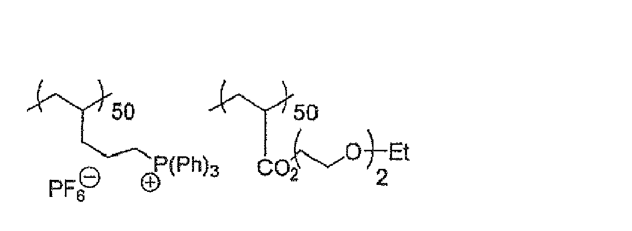
(20) 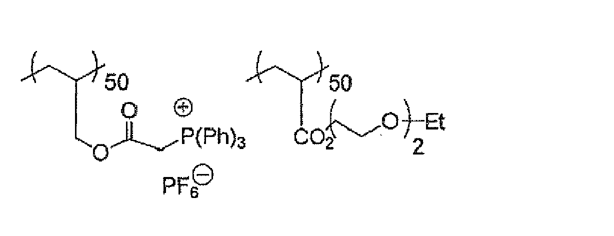
(21) 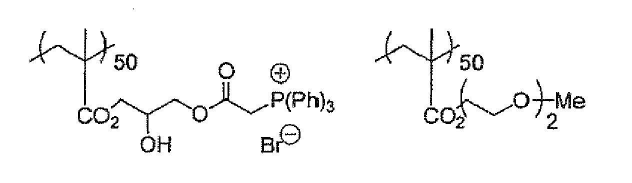
(22) 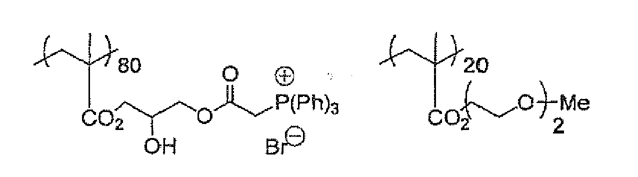
(23) 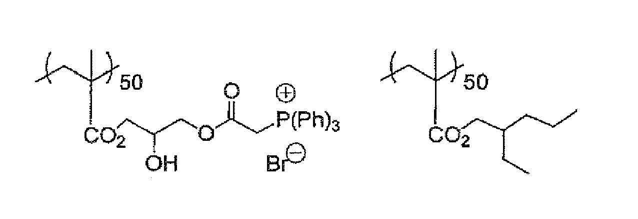
(24) 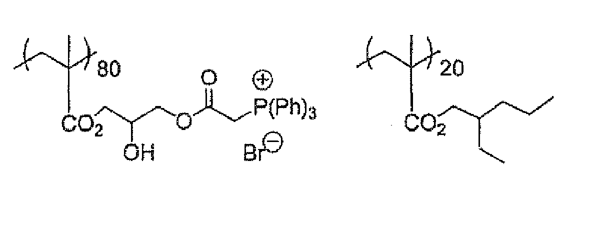
(25) 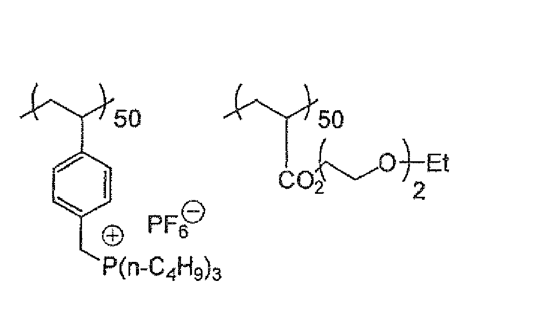
(26) 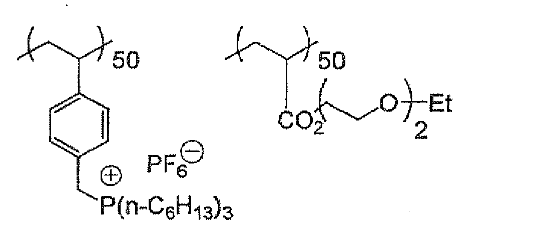
(27) 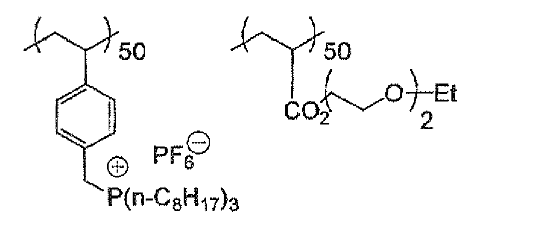
(28)

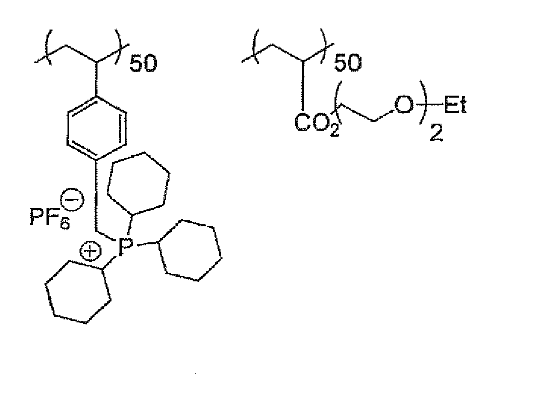

### [(A) Sensitizing dye]

As the sensitizing dye to be contained in the image-recording layer of the invention, one having an absorption peak at 300 to 1200 nm is preferable and one having an absorption peak at 360 to 850 nm is more preferable. Examples of the sensitizing dye include a spectral sensitizing dye and a dye or a pigment absorbing the light from light source and interacting with a radical generator.

Preferable examples of the spectral sensitizing dye or dye include polynuclear aromatic compounds (for example, pyrene, perylene and triphenylene), xanthenes (for example, fluorescein, eosin, erythrosine, Rhodamine B and rose bengal), cyanines (for example, thiacarbocyanine and oxacarbocyanine), merocyanines (for example, merocyanine and carbomerocyanine), thiazines (for example, thionine, methylene blue and toluidine blue), acridines (for example, acridine orange, chloroflavin and acriflavin), phthalocyanines (for example, phthalocyanine and metal phthalocyanine), porphyrines (for example, tetraphenyl porphyrine and central metal-substituted porphyrine), chlorophyls (for example, chlorophyl, chlorophyline, central metal-substituted cblorophyl), metal complexes, anthraquinones (for example, anthraquinone) and squariums (for example, squarium).

In the case wherein the lithographic printing plate precursor according to the invention is subjected to the image formation using as a light source, a laser emitting an infrared ray of 760 to 1,200 nm, it is ordinarily essential to use an infrared absorbing agent. The infrared absorbing agent has a function of converting the infrared ray absorbed to heat and a function of being excited by the infrared ray to perform electron transfer/energy transfer to a polymerization initiator (radical generator) described hereinafter. The infrared absorbing agent for use in the invention includes a dye and pigment each having an absorption maximum in a wavelength range of 760 to 1,200 nm.

In the case where image formation is carried out by using blue laser beam having a wavelength of 360 nm to 450 nm as the light source, use of a sensitizing dye absorbing light of 360 nm to 450 nm contributes to the achievement of excellent image formability.

### <Infrared absorbing agent having absorption peak at 760 to 1,200 nm>

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Examples of preferable dye include cyanine dyes described, for example, in JP-A-58-125246, JP-A-59-84356 and JP-A-60-78787, methine dyes described, for example, in JP-A-58-173696, JP-A-58-181690 and JP-A-58-194595, naphthoquinone dyes described, for example, in JP-A-58-112793, JP-A-58-224793, JP-A-59-48187, JP-A-59-73996, JP-A-60-52940 and JP-A-60-63744, squarylium dyes described, for example, in JP-A-58-112792, and cyanine dyes described, for example, in British Patent 434,875.

Also, near infrared absorbing sensitizers described in U.S. Patent 5,156,938 are preferably used. Further, substituted arylbenzo(thio)pyrylium salts described in U.S. Patent 3,881,924, trimethinethiapyrylium salts described in JP-A-57-142645 (corresponding to U.S. Patent 4,327,169), pyrylium compounds described in JP-A-58-181051, JP-A-58-220143, JP-A-59-41363, JP-A-59-84248, JP-A-59-84249, JP-A-59-146063 and JP-A-59-146061, cyanine dyes described in JP-A-59-216146, pentamethinethiopyrylium salts described in U.S. Patent 4,283,475, and pyrylium compounds described in JP-B-5-13514 and JP-B-5-19702 are also preferably used. Other preferred examples of the dye include near infrared absorbing dyes represented by formulae (I) and (II) in U.S. Patent 4,756,993.

Other preferable examples of the infrared absorbing dye according to the invention include specific indolenine cyanine dyes described in JP-A-2002-278057 as illustrated below.

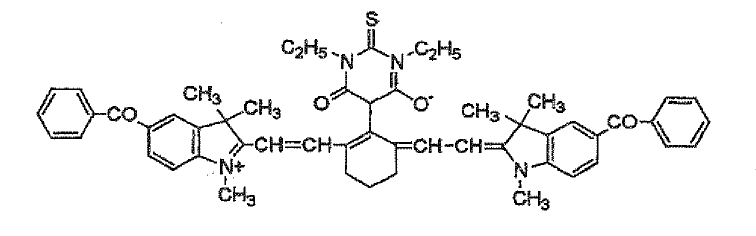

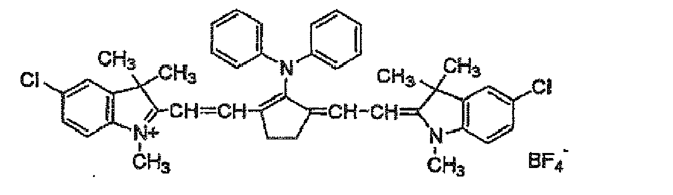

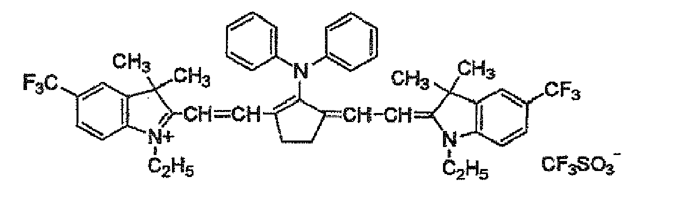

Among these dyes, cyanine dyes, squarylium dyes, pyrylium salts, nickel thiolate complexes and indolenine cyanine dyes are particularly preferred. Further, cyanine dyes and indolenine cyanine dyes are more preferred. As a particularly preferable example of the dye, a cyanine dye represented by the following formula (i) is exemplified. Formula (i):

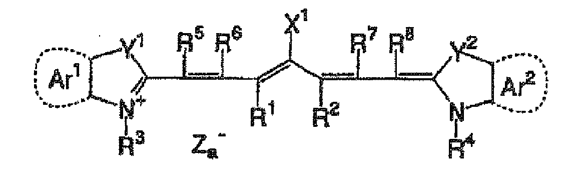

In the formula (i), X¹ represents a hydrogen atom, a halogen atom, -NPh₂, X²-L¹ or a group represented by the following structural formula. X² represents an oxygen atom, a nitrogen atom or a sulfur atom, L¹ represents a hydrocarbon group having from 1 to 12 carbon atoms, an aromatic ring containing a hetero atom or a hydrocarbon group having from 1 to 12 carbon atoms and containing a hetero atom. The hetero atom indicates here a nitrogen atom, a sulfur atom, an oxygen atom, a halogen atom or a selenium atom. R^{a} represents a substituent selected from a hydrogen atom, an alkyl group, an aryl group, a substituted or unsubstituted amino group and a halogen atom. Xa" has the same meaning as Za⁻ as will be defined hereinafter.

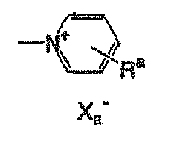

R¹ and R² each independently represents a hydrocarbon group having from 1 to 12 carbon atoms. In view of the storage stability of a coating solution for image-recording layer, it is preferred that R¹ and R² each represents a hydrocarbon group having two or more carbon atoms, and it is particularly preferred that R¹ and R² are bonded to each other to form a 5-membered or 6-membered ring.

Ar¹ and Ar², which may be the same or different, each represents an aromatic hydrocarbon group which may have a substituent. Preferable examples of the aromatic hydrocarbon group include a benzene ring and a naphthalene ring. Also, preferable examples of the substituent include a hydrocarbon group having 12 or less carbon atoms, a halogen atom and an alkoxy group having 12 or less carbon atoms, and a hydrocarbon group having 12 or less carbon atoms and an alkoxy group having 12 or less carbon atoms are most preferable. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms, which may have a substituent. Preferable examples of the substituent include an alkoxy group having 12 or less carbon atoms, a carboxyl group and a sulfo group, and an alkoxy group having 12 or less carbon atoms is most preferable. R⁵, R⁶, R⁷ and R⁸, which may be the same or different, each represents a hydrogen atom or a hydrocarbon group having 12 or less carbon atoms. In view of the availability of starting materials, a hydrogen atom is preferred. Za⁻ represents a counter anion. However, Za⁻ is not necessary in the case where the cyanine dye represented by formula (i) has an anionic substituent in the structure thereof and neutralization of charge is not needed. Preferable examples of the counter anion for Za⁻ include a halogen ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion in view of the storage stability of a coating solution for image-recording layer.

Specific examples of the cyanine dye represented by formula (i), which can be preferably used in the invention, include those described in Paragraph Nos. [0017] to [0019] of JP-A-2001-133969.

Further, other particularly preferable examples include specific indolenine cyanine dyes described in JP-A-2002-278057 that is cited above.

Examples of the pigment for use in the invention include commercially available pigments and pigments described in Colour Index (C.I.), Saishin Ganryo Binran (Handbook of the Newest Pigments) compiled by Pigment Technology Society of Japan (1977), Saishin Ganryo Oyou Gijutsu (Newest Application on Technologies for Pigments), CMC Publishing Co., Ltd. (1986) and Insatsu Ink Gijutsu (Printing Ink Technology), CMC Publishing Co., Ltd. (1984).

Examples of the pigment include black pigments, yellow pigments, orange pigments, brown pigments, red pigments, purple pigments, blue pigments, green pigments, fluorescent pigments, metal powder pigments and polymer-bonded dyes. Specific examples of usable pigment include insoluble azo pigments, azo lake pigments, condensed azo pigments, chelated azo pigments, phthalocyanine pigments, anthraquinone pigments, perylene and perynone pigments, thioindigo pigments, quinacridone pigments, dioxazine pigments, isoindolinone pigments, quinophthalone pigments, dying lake pigments, azine pigments, nitroso pigments, nitro pigments, natural pigments, fluorescent pigments, inorganic pigments and carbon black. Of the pigments, carbon black is preferred.

The pigment may be used without undergoing surface treatment or may be used after the surface treatment. For the surface treatment, there can be enumerated a method of coating a resin or wax on the surface, a method of attaching a surfactant and a method of bonding a reactive substance (for example, a silane coupling agent, an epoxy compound or polyisocyanate) to the pigment surface. The surface treatment methods are described in Kinzoku Sekken no Seishitsu to Oyo (Properties and Applications of Metal Soap), Saiwai Shobo, Insatsu Ink Gijutsu (Printing Ink Technology), CMC Publishing Co., Ltd. (1984), and Saishin Ganryo Oyo Gijutsu (Newest Application on Technologies for Pigments), CMC Publishing Co., Ltd. (1986).

The pigment has a particle size of preferably from 0.01 to 10 µm, more preferably from 0.05 to 1 µm, and particularly preferably from 0.1 to 1 µm. In the above-described range, good stability of the pigment dispersion in the coating solution for image-recording layer and good uniformity of the image-recording layer can be obtained.

For dispersing the pigment, a known dispersion technique for use in the production of inks or toners may be used. Examples of the dispersing machine include an ultrasonic dispersing machine, a sand mill, an attritor, a pearl mill, a super-mill, a ball mill, an impeller, a disperser, a KD mill, a colloid mill, a dynatron, a three roll mill and a pressure kneader. The dispersing machines are described in detail in Saishin Ganryo Oyo Gijutsu (Newest Application on Technologies for Pigments), CMC Publishing Co., Ltd. (1986).

The infrared absorbing agent may be added together with other components to one layer or may be added to a different layer separately provided. With respect to the amount of the infrared absorbing agent added, in the case of preparing a negative-working lithographic printing plate precursor, the amount is so controlled that absorbance of the image-recording layer at the maximum absorption wavelength in the wavelength region of 760 to 1,200 nm measured by reflection measurement is in a range of 0.3 to 1.2, preferably in a range of 0.4 to 1.1. In the above-described range, the polymerization reaction proceeds uniformly in the thickness direction of the image-recording layer and good film strength of the image area and good adhesion property of the image area to a support are achieved.

The absorbance of the image-recording layer can be controlled depending on the amount of the infrared absorbing agent added to the image-recording layer and the thickness of the image-recording layer. The measurement of the absorbance can be carried out in a conventional manner. The method for measurement includes, for example, a method of forming an image-recording layer having a thickness determined appropriately in the range necessary for the lithographic printing plate precursor on a reflective support, for example, an aluminum plate, and measuring reflection density of the image-recording layer by an optical densitometer or a spectrophotometer according to a reflection method using an integrating sphere.

### <Sensitizing dye absorbing light of 360 nm to 450 nm>

The sensitizing dye absorbing light of 360 to 450 nm to be used in the invention preferably has an absorption maximum in a wavelength range of 360 to 450 nm. Examples of the sensitizing dye include merocyanine dyes represented by the following formula (I), benzopyranes or coumarins represented by the following formula (II), aromatic ketones represented by the following formula (III), anthracenes represented by the following formula (IV) and so on.

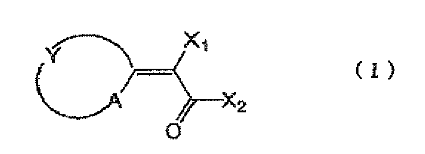

In this formula, A represents a sulfur atom or NR₆; R₆ represents a monovalent non-metallic atomic group; Y represents a non-metallic atomic group forming a basic nucleus of the dye together with adjacent A and the adjacent carbon atom; and X₁ and X₂ each independently represents a monovalent non-metallic atomic group or X₁ and X₂ may be bonded to each other to form an acidic nucleus of the dye.

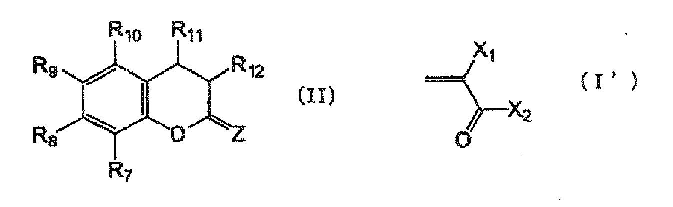

In these formulae, =Z represents a carbonyl group, a thiocarbonyl group, an imino group or an alkylydene group represented by the partial structural formula (I') described above; X₁ and X₂ have the same meanings as defined in the formula (I) respectively; and R₇ to R₁₂ each independently represents a monovalent non-metallic atomic group.

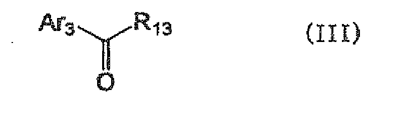

In this formula, Ar₃ represents an aromatic group or a heteroaromatic group which may have a substituent; and R₁₃ represents a monovalent non-metallic atomic group. R₁₃ preferably represents an aromatic group or a heteroaromatic group. Ar₃ and R₁₃ may be bonded each other to form a ring.

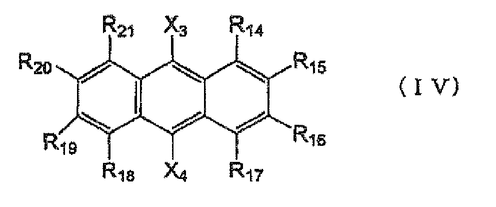

In this formula, X₃, X₄ and R₁₄ to R₂₁ each independently represents a monovalent non-metallic atomic group. Preferably, X₃ and X₄ each independently represents an electron-donating group having a negative Hammett substituent constant.

In the formulae (I) to (IV), preferable examples of the monovalent non-metallic atomic group represented by any one of X₁ to X₄ and R₆ to R₂₁ include a hydrogen atom, an alkyl group (for example, a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group, a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbaanoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group or a 3-butynyl group), an aryl group (for example, a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxyphenylcarbonyl group, a phenoxycarbonylphenyl group, an N-phenylearbamoylphenyl group, a phenyl group, a cyanophenyl group, a sulfophenyl group, a sulfonatophenyl group, a phosphonophenyl group or a phosphonatophenyl group), a heteroaryl group (for example, thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane or phenoxazine), an alkenyl group (for example, a vinyl group, a 1-propenyl group, a 1-butenyl group, a cinnamyl group or a 2-chloro-1-ethenyl group), an alkynyl group (for example, an ethynyl group, a 1-propynyl group, a 1-butynyl group or a trimethylsilylethynyl group), a halogen atom (for example, -F, -Br, -Cl or -I), a hydroxyl group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylearbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsnlfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and its conjugated base group (hereinafter referred to as a "phosphonato group"), a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and its conjugated base group (hereinafter referred to as an "alkylphosphonato group"), a monoarylphosphono group (-PO₃H(aryl)) and its conjugated base group (hereinafter referred to as an "arylphosphonato group"), a phosphonooxy group (-OPO₃H₂) and its conjugated base group (hereinafter referred to as a "phosphonatooxy group"), a dialkylphosphonooxy group (-OPO₃(alkyl)₂), a diarylphosphonooxy group (-OPO₃(aryl)₂), an alkylarylphosphonooxy group (-OPO₃(alkyl)(aryl)), a monoalkylphosphonooxy group (-OPO₃H(alkyl)) and its conjugated base group (hereinafter referred to as an "alkylphosphonatooxy group"), a monoarylphosphonooxy group (-OPO₃H(aryl)) and its conjugated base group (hereinafter referred to as an "arylphosphonatooxy group"), a cyano group and a nitro group. Among the above-described groups, a hydrogen atom, an alkyl group, an aryl group, a halogen atom, an alkoxy group and an acyl group are particularly preferred.

The basic nucleus of the dye formed by Y together with the adjacent A and the adjacent carbon atom in the formula (I) includes, for example, a 5-membered, 6-membered or 7-membered, nitrogen-containing or sulfur-containing heterocyclic ring, and is preferably a 5-membered or 6-membered heterocyclic ring.

As the nitrogen-containing heterocyclic ring, use can be appropriately made of those which are known to constitute basic nuclei in merocyanine dyes described in, for example, L.G. Broker et al, J. Am. Chem. Soc., Vol. 73, p. 5326 to 5358 (1951) and references cited therein. Specific examples thereof include thiazoles (for example, thiazole, 4-methylthiazole, 4-phenylthiazole, 5-methylthiazole, 5-phenylthiazole, 4,5-dimethylthiazole, 4,5-diphenylthiazole, 4,5-di(p-methoxyphenyl)thiazole or 4-(2-thienyl)thiazole); benzothiazoles (for example, benzothiazole, 4-chlorobenzothiazole, 5-chlorobenzothiazole, 6-chlorobenzothiazole, 7-chlorobenzothiazole, 4-methylbenzothiazole, 5-methylbenzolthiazole, 6-methylbenzothiazole, 5-bromobenzothiazole, 4-phenylbenzothiazole, 5-phenylbenzothiazole, 4-methoxybenzothiazole, 5-methoxybenzothiazole, 6-methoxybenzothiazole, 5-iodobenzothiazole, 6-iodobenzothiazole, 4-ethoxybenzothiazole, 5-ethoxybenzothiazole, tetrahydrobenzothiazole, 5,6-dimethoxybenzothiazole, 5,6-dioxymethylenebenzothiazole, 5-hydroxybenzothiazole, 6-hydroxybenzothiazole, 6-dimethylaiminobenzothiazole or 5-ethoxycarbonylbenzothiazole); naphthothiazoles (for example, naphtho[1,2]thiazole, naphtho[2,1]thiazole, 5-methoxynaphtho[2,1]thiazole, 5-ethoxynaphtho[2,1]thiazole, 8-methoxynaphtho[1,2]thiazole or 7-methoxynaphtho[1,2]thiazole); thianaphtheno-7',6',4,5-thiazoles (for example, 4'-methoxythianaphtheno-7',6',4,5-thiazole); oxazoles (for example, 4-methyloxazole, 5-methyloxazole, 4-phenyloxazole, 4,5-diphenyloxazole, 4-ethyloxazole, 4,5-dimethyloxazole or 5-phenyloxazole); benzoxazoles (for example, benzoxazole, 5-chlorobenzoxazole, 5-methylbenzoxazole, 5-phenylbenzaxazole, 6-methylbenzoxazole, 5,6-dimethylbenzoxazole, 4,6-dimethylbenzoxazole, 6-methoxybenzoxazole, 5-methoxybenzoxazole, 4-ethoxybenzoxazole, 5-chlorobenzoxazole, 6-methoxybenzoxazole, 5-hydroxybenzoxazole or 6-hydroxybenzoxazole); naphthoxazoles (for example, naphth[1,2]oxazole or naphth[2,1]oxazole); selenazoles (for example, 4-methylselenazole or 4-phenylselenazole); benzoselenazoles (for example, benzoselenazole, 5-chlorobenzoselenazole, 5-methoxybenzoselenazole, 5-hydroxybenzoselenazole or tetrahydrobenzoselenazole); naphthoselenazoles (for example, naphtho[1,2]selenazole or naphtho[2,1]selenazole); thiazolines (for example, thiazoline or 4-methylthiazoline); 2-quinolines (for example, quinoline, 3-methylquinoline, 5-methylquinoline, 7-methylquinoline, 8-methylquinoline, 6-chloroquinoline, 8-chloroquinoline, 6-methoxyquinoline, 6-ethoxyquinoline, 6-hydroxyquinoline or 8-hydroxyquinoline); 4-quinolines (for example, quinoline, 6-methoxyquinoline, 7-methylquinoline or 8-methylquinoline); 1-isoquinolines (for example, isoquinoline or 3,4-dihydroisoquinoline); 3-isoquinolines (for example, isoquinoline); benzimidazoles (for example, 1,3-diethylbenzimidazole or 1-ethyl-3-phenylbenzimidazole); 3,3-dialkylindolenines (for example, 3,3-dimethylindolenine, 3,3,5-trimethylindolenine or 3,3,7-trimethylindolenine); 2-pyridines (for example, pyridine or 5-methylpyridine); and 4-pyridines (for example, pyridine).

Examples of the sulfur-containing heterocyclic ring include dithiol partial structures in dyes described in JP-A-3-296759.

Specific examples thereof include benzodithiols (for example, benzodithiol, 5-t-butylbenzodithiol or 5-methylbenzodithiol); naphthodithiols (for example, naphtho[1,2]dithiol or naphtho[2,1]dithiol); and dithiols (for example, 4,5-dimethyldithiols, 4-phenyldithiols, 4-methoxycarbonyldithiols, 4,5-dimethoxycarbonyldithiols, 4,5-ditrifluoromethyldithiol, 4,5-dicyanodithiol, 4-methoxycarbonylmethyldithiol or 4-carboxymethyldithiol).

In the above description concerning the heterocyclic ring, the names of heterocyclic mother skeletons are used for convenience and by convention. In the case of constituting the basic nucleus partial structure in the sensitizing dye, the heterocyclic ring is introduced in the form of a substituent of alkylydene type where a degree of unsaturation is decreased one step. For example, a benzothiazole skeleton is introduced as a 3-substituted-2(3H)-benzothiazolilydene group.

Among the compounds having an absorption maximum in a wavelength range of 360 nm to 450 nm as the sensitizing dyes, dyes represented by the following formula (V) are more preferable in view of high sensitivity.

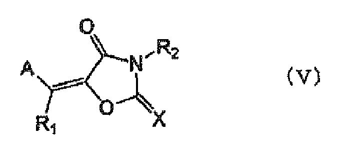

In the formula (V), A represents an aromatic cyclic group or a heterocyclic group which may have a substituent; X represents an oxygen atom, a sulfur atom or =N(R₃); and R₁, R₂ and R₃ each independently represents a hydrogen atom or a monovalent non-metallic atomic group, or A and R₁ or R₂ and R₃ may be bonded to each other to form an aliphatic or aromatic ring.

Next, the formula (V) will be described in greater detail. R₁, R₂ and R₃ each independently represents a hydrogen atom or a monovalent non-metallic atomic group, preferably a substituted or unsubstituted alkyl group, a substituted or unsubstituted alkenyl group, a substituted or unsubstituted aryl group, a substituted or unsubstituted heteroaryl group, a substituted or unsubstituted alkoxy group, a substituted or unsubstituted alkylthio group, a hydroxyl group or a halogen atom.

Now, preferable examples of R₁, R₂ and R₃ will be specifically described below. Preferable examples of the alkyl group include a straight chain, branched or cyclic alkyl group having from 1 to 20 carbon atoms. Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group and a 2-norbomyl group. Among them, a straight chain alkyl group having from 1 to 12 carbon atoms, a branched alkyl group having from 3 to 12 carbon atoms and a cyclic alkyl group having from 5 to 10 carbon atoms are more preferable.

As the substituent for the substituted alkyl group, use is made of a monovalent non-metallic atomic group exclusive of a hydrogen atom. Preferable examples thereof include a halogen atom (for example, -F, -Br, -Cl or -I), a hydroxyl group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and its conjugated base group (hereinafter referred to as a "phosphonato group"), a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and its conjugated base group (hereinafter referred to as an "alkylphosphonato group"), a monoarylphosphono group (-PO₃H(aryl)) and its conjugated base group (hereinafter referred to as an "arylphosphonato group"), a phosphonooxy group (-OPO₃H₂) and its conjugated base group (hereinafter referred to as a "phosphonatooxy group"), a dialkylphosphonooxy group (-OPO₃(alkyl)₂), a diarylphosphonooxy group (-OPO₃(aryl)₂), an alkylarylphosphonooxy group (-OPO₃(alkyl)(aryl)), a monoalkylphosphonooxy group (-OPO₃H(alkyl)) and its conjugated base group (hereinafter referred to as an "alkylphosphonatooxy group"), a monoarylphosphonooxy group (-OPO₃H(aryl)) and its conjugated base group (hereinafter referred to as an "arylphosphonatooxy group"), a cyano group, a nitro group, an aryl group, a heteroaryl group, an alkenyl group and an alkynyl group.

In these substituents, specific examples of the alkyl group include those described for the alkyl group above. Specific examples of the aryl group include a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a phenyl group, a cyanophenyl group, a sulfophenyl group, a sulfonatophenyl group, a phosphonophenyl group and a phosphonatophenyl group.

Examples of the heteroaryl group which is preferable as R₁, R₂ and R₃ include a monocyclic or polycyclic aromatic cyclic group containing at least one of a nitrogen atom, an oxygen atom and a sulfur atom. Examples of especially preferable heteroaryl group include thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane or phenoxazine. These groups may be benzo-fused or may have a substituent.

Also, examples of the alkenyl group which is preferable as R₁, R₂ and R₃ include a vinyl group, a 1-propenyl group, a 1-butenyl group, a cinnamyl group and a 2-chloro-1-ethenyl group. Examples of the alkynyl group include an ethynyl group, a 1-propynyl group, a 1-butynyl group and a trimethylsilylethynyl group. Examples of G1 in the acyl group (G1CO-) include a hydrogen atom and the above-described alkyl group and aryl group. Among these substituents, a halogen atom (for example, -F, -Br, -Cl or -I), an alkoxy group, an aryloxy group, an alkylthio group, an arylthio group, an N-alkylamino group, an N,N-dialkylamino group, an acyloxy group, an N-alkylcarbamoyloxy group, an N-arylcarbamoyloxy group, an acylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfamoyl group, an N,N-dialkylsulfamoyl group, an N-arylsulfamoyl group, an N-alkyl-N-arylsulfamoyl group, a phosphono group, a phosphonato group, a dialkylphosphono group, a diarylphosphono group, a monoalkylphosphono group, an alkylphosphonato group, a monoarylphosphono group, an arylphosphonato group, a phosphonooxy group, a phosphonatooxy group, an aryl group and an alkenyl group are more preferable.

On the other hand, as an alkylene group in the substituted alkyl group, a divalent organic residue resulting from elimination of any one of hydrogen atoms on the above-described alkyl group having from 1 to 20 carbon atoms can be enumerated. Examples of preferable alkylene group include a straight chain alkylene group having from 1 to 12 carbon atoms, a branched alkylene group having from 3 to 12 carbon atoms and a cyclic alkylene group having from 5 to 10 carbon atoms.

Specific examples of the preferable substituted alkyl group represented by any of R₁, R₂ and R₃, which is obtained by combining the above-described substituent with the alkylene group, include a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group and a 3-butynyl group.

Specific examples of the aryl group which is preferable as R₁, R₂ and R₃ include a fused ring formed from one to three benzene rings and a fused ring formed from a benzene ring and a 5-membered unsaturated ring. Specific examples thereof include a phenyl group, a naphthyl group, an anthryl group, a phenanthryl group, an indenyl group, an acenaphthenyl group and a fluorenyl group. Among these groups, a phenyl group and a naphthyl group are more preferable.

Specific examples of the substituted aryl group which is preferable as R₁, R₂ and R₃ include aryl groups having a monovalent non-metallic atomic group other than a hydrogen atom as a substituent on the ring-forming carbon atom of the above-described aryl group. Preferable examples of the substituent include the above-described alkyl groups and substituted alkyl groups, and the substituents described for the above-described substituted alkyl group. Specific examples of the preferable substituted aryl group include a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group, a methylthiophenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenyl-carbamoyloxyphenyl group, an acetylaminophenyl group, an N-methyl-benzoylaminophenyl group, a carboxyphenyl group, a methoxycarbonylphenyl group, an allyloxycarbonylphenyl group, a chlorophenoxycarbonylphenyl group, a carbamoylphenyl group, an N-methylcarbamoylphenyl group, an N,N-dipropylcarbamoylphenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropyl-sulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allyl group, a 1-propenylmethyl group, a 2-butenyl group, a 2-methylallylphenyl group, a 2-methylpropenylpbenyl group, a 2-propynylphenyl group, a 2-butynylphenyl group and a 3-butynylphenyl group.

Next, A in the formula (V) will be described. A represents an aromatic cyclic group or a heterocyclic group which may have a substituent. Specific examples of the aromatic cyclic group or heterocyclic group which may have a substituent include those described with respect to R₁, R₂ and R₃ in the formula (V).

The sensitizing dye represented by the formula (V) is obtained by a condensation reaction of the above-described acidic nucleus or an active methyl group-containing acidic nucleus with a substituted or unsubstituted aromatic ring or hetero ring. These dyes can be synthesized by referring to JP-B-59-28329.

Next, preferable specific examples (D1) to (D41) of the compound represented by the formula (V) will be presented. In the case where isomers with respect to a double bond connecting an acidic nucleus and a basic nucleus are present in each of the compounds, though the invention should not be construed as being limited to any one of the isomers.

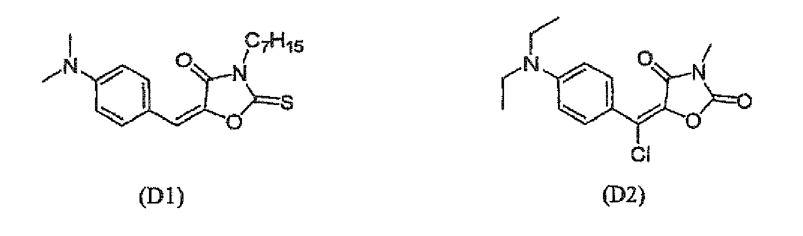

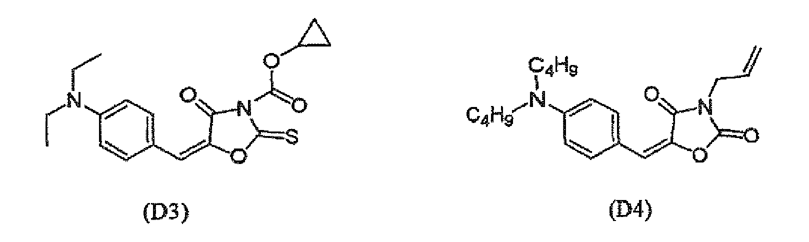

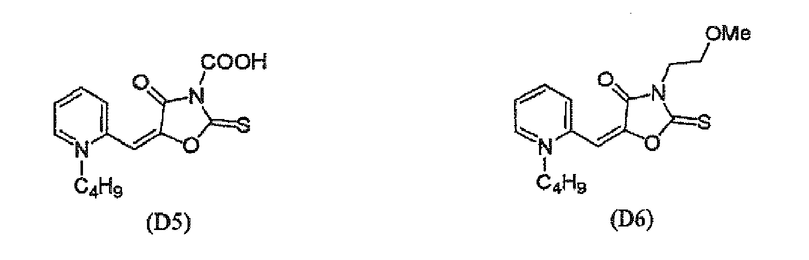

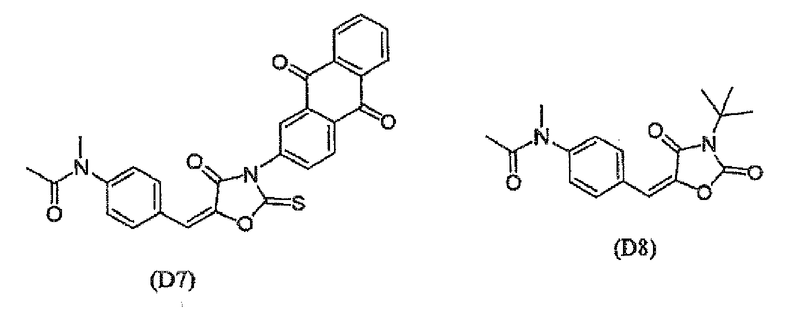

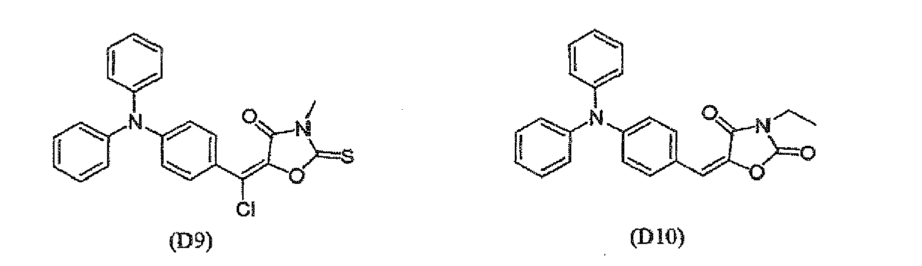

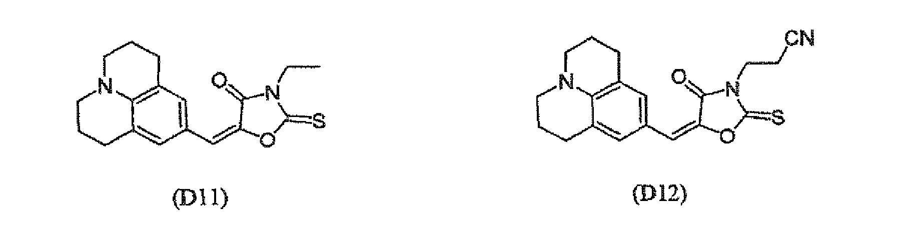

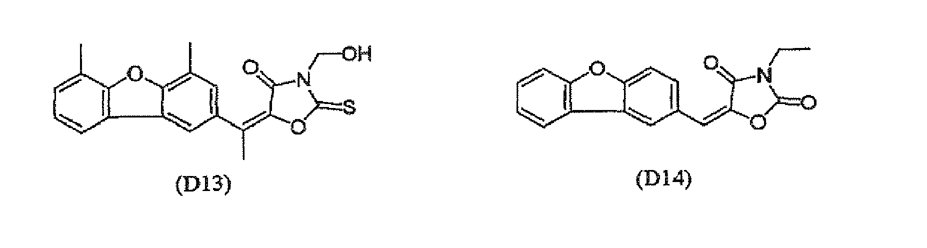

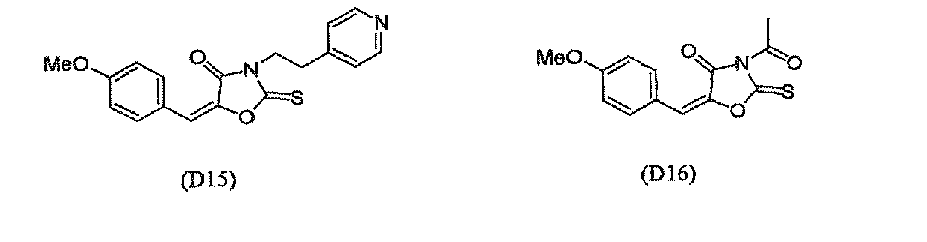

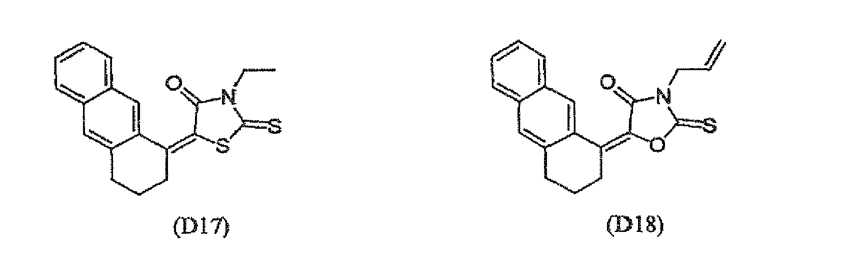

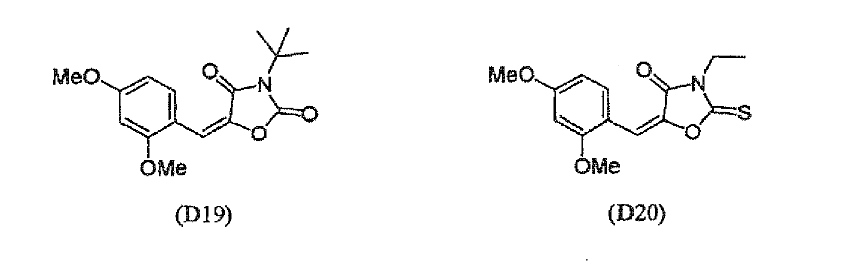

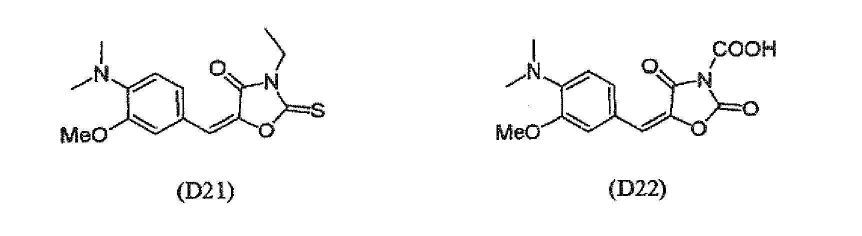

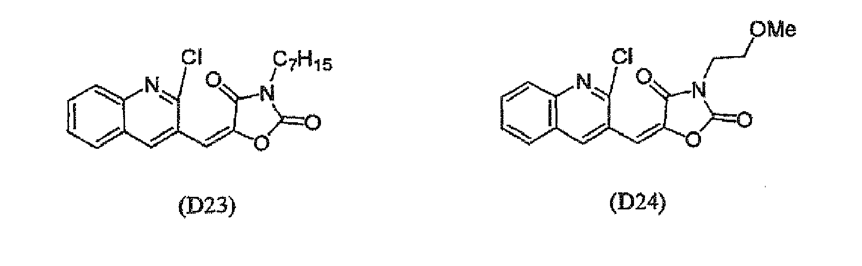

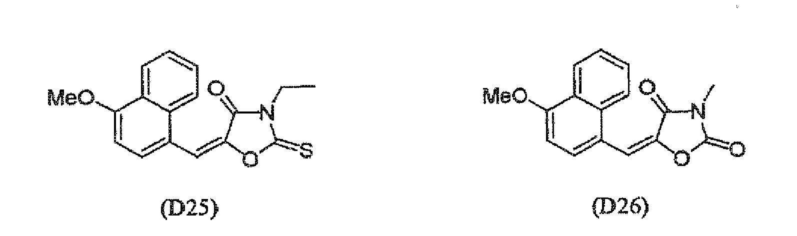

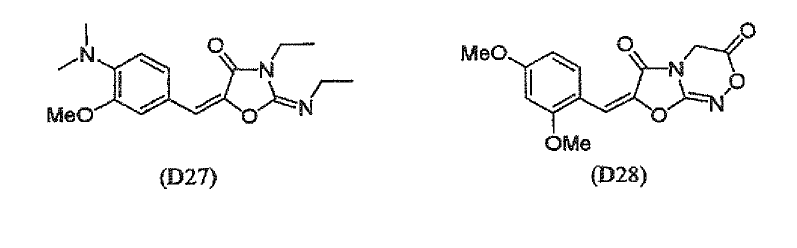

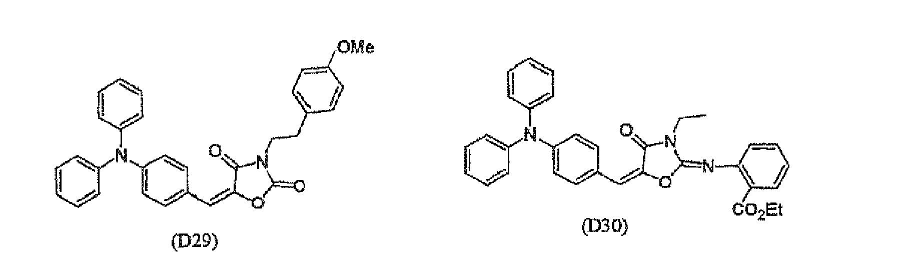

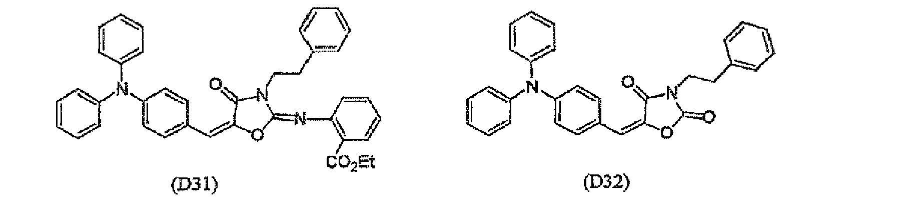

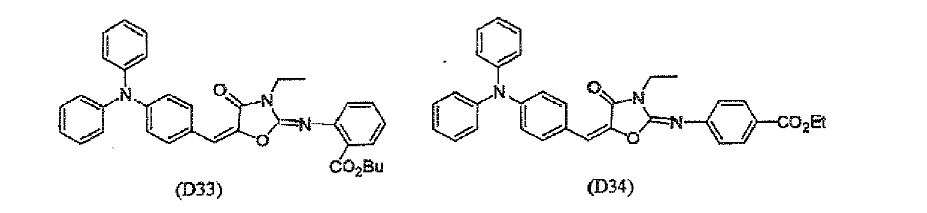

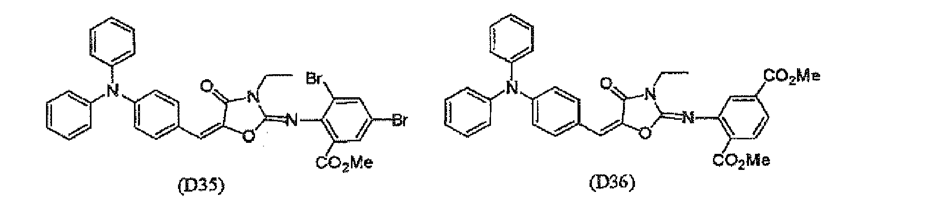

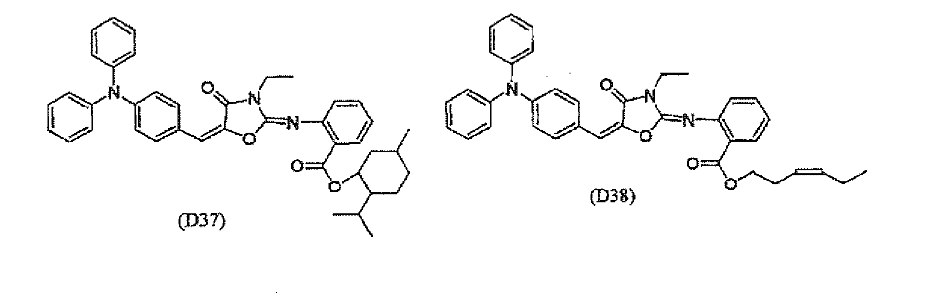

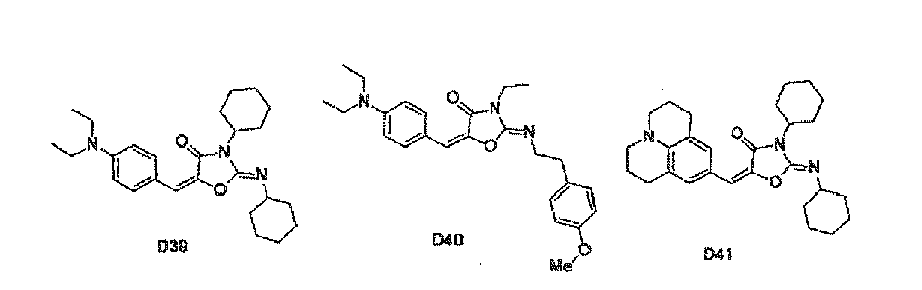

It is preferable that the sensitizing dye absorbing light of from 360 nm to 450 nm as described above is used in an amount of from 1.0 to 10.0% by mass, more preferably from 1.5 to 5.0% by mass, based on the total solid matters in the image-recording layer.

### [(B) Radical generator]

The radical generator for use in the invention means a compound that generates a radical with light energy, heat energy or both energies to initiate or accelerate polymerization of a compound having a polymerizable unsaturated group. The radical generator for use in the invention includes, for example, known thermal polymerization initiators, compounds containing a bond having small bond dissociation energy and photopolymerization initiators. The compound generating a radical preferably usable in the invention is a compound that generates a radical with heat energy to initiate or accelerate polymerization of a compound having a polymerizable unsaturated group. As the thermal radical generator according to the invention, use may be made of those appropriately selected from known polymerization initiators and compounds containing a bond having small bond dissociation energy. Either a single radical generator or a combination of two or more thereof may be used.

The radical generating compounds include, for example, organic halides, carbonyl compounds, organic peroxides, azo compounds, azido compounds, metallocene compounds, hexaarylbiimidazole compounds, organic borate compounds, disulfonic acid compounds, oxime ester compounds and onium salt compounds.

The organic halides described above specifically include, for example, compounds described in Wakabayashi et al., Bull. Chem. Soc. Japan, 42, 2924 (1969), U.S. Patent 3,905,815, JP-B-46-4605, JP-A-48-36281, JP-A-55-32070, JP-A-60-239736, JP-A-61-169835, JP-A-61-169837, JP-A-62-58241, JP-A-62-212401, JP-A-63-70243, JP-A-63-298339 and M. P. Hutt, Journal of Heterocyclic Chemistry, 1, No. 3 (1970). Particularly, oxazole compounds and s-triazine compounds each substituted with a trihalomethyl group are exemplified.

More preferably, s-triazine derivatives in which at least one of mono-, di- and tri-halogen substituted methyl groups is connected to the s-triazine ring are exemplified. Specific examples thereof include 2,4,6-tris(monochloromethyl)-s-triazine, 2,4,6-tris(dichloromethyl)-s-triazine, 2,4,6-tris(trichloromethyl)-s-triazine, 2-methyl-4,6-bis(trichloromethyl)-s-triazine, 2-n-propyl-4,6-bis(trichloromethyl)-s-triazine, 2-(α,α,β-trichloroethyl)-4,6-bis(trichloromethyl)-s-triazine, 2-phenyl-4,6-bis(trichloromethyl)-s-triazine, 2-(p-methoxyphenyl)-4,6-bis(trichloromethyl)-s-triazine, 2-(3,4-epoxyphenyl)-4,6-bis(trichloromethyl)-s-triazine, 2-(p-chlorophenyl)-4,6-bis(trichloromethyl)-s-triazine, 2-(p-bromophenyl)-4,6-bis(trichloromethyl)-s-triazine, 2-(p-fluorophenyl)-4,6-bis(trichloromethyl)-s-triazine, 2-(p-trifluoromethylphenyl)-4,6-bis(trichloromethyl)-s-triazine, 2-(2,6-dichlorophenyl)-4,6-bis(trichloromethyl)-s-triazine, 2-(2,6-difluorophenyl)-4,6-bis(trichloromethyl)-s-triazine, 2-(2,6-dibromophenyl)-4,6-bis(trichloromethyl)-s-triazine, 2-(4-biphenytyl)-4,6-bis(trichloromethyl)-s-triazine, 2-(4'-chloro-4-biphenylyl)-4,6-bis(trichloromethyl)-s-triazine, 2-(p-cyanophenyl)-4,6-bis(trichloromethyl)-s-triazine, 2-(p-acerylphenyl)-4,6-bis(trichloromethyl)-s-triazine, 2-(p-ethoxycarbonylphenyl)-4,6-bis(trichloromethyl)-s-triazine, 2-(p-phenoxycarbonylphenyl)-4,6-bis(trichloromethyl)-s-triazine, 2-(p-methylsulfonylphenyl)-4,6-bis(trichloromethyl)-s-triazine, 2-(p-dimethylsulfoniumphenyl)-4,6-bis(trichloromethyl)-s-triazine tetrafluoroborate, 2-(2,4-difluorophenyl)-4,6-bis(trichloromethyl)-s-triazine, 2-(p-diethoxyphosphorylphenyl)-4,6-bis(trichloromethyl)-s-triazine, 2-[4-(4-hydroxyphenylcarbonylamino)phenyl-4,6-bis(trichloromethyl)-s-triazine, 2-[4-(p-methoxyphenyl)-1,3-butadienyl]-4,6-bis(trichloromethyl)-s-triazine, 2-styryl-4,6-bis(trichloromethyl)-s-triazine, 2-(p-methoxystyryl)-4,6-bis(trichloromethyl)-s-triazine, 2-(p-i-propyloxystyryl)-4,6-bis(trichloromethyl)-s-triazine, 2-(p-tolyl)-4,6-bis(trichloromethyl)-s-triazine, 2-(4-methoxynaphthyl)-4,6-bis(trichloromethyl)-s-triazine, 2-phenylthio-4,6-bis(trichloromethyl)-s-triazine, 2-benzylthio-4,6-bis(trichloromethyl)-s-triazine, 2,4,6-tris(dibromomethyl)-s-triazine, 2,4,6-tris(tribromomethyl)-s-triazine, 2-methyl-4,6-bis(tribromomethyl)-s-triazine, 2-methoxy-4,6-bis(tribromethyl)-s-triazine, 2-(o-methoxystyryl)-5-trichloromethyl-1,3,4-oxadiazole, 2-(3,4-epoxystyryl)-5-trichloromethyl-1,3,4-oxadiazole, 2-[3,4-phenyl-2-(4-methoxyphenyl)vinyl]-5-trichloromethyl-1,3,4-oxadiazole, 2-(p-hydroxystyryl)-5-trichloromethyl-1,3,4-oxadiazole, 2-(3,4-dihydroxystyryl)-5-trichloromethyl-1,3,4-oxadiazole and 2-(p-t-butoxystyryl)-5-trichloromethyl-1,3,4-oxadiazole.

The carbonyl compounds described above include, for example, benzophenone derivatives, e.g., benzophenone, Michler's ketone, 2-methylbenzophenone, 3-methylbenzophenone, 4-methylbenzophenone, 2-chlorobenzophenone, 4-bromobenzophenone or 2-carboxybenzophenone; acetophenone derivatives, e.g., 2,2-dimethoxy-2-phenylacetophenone, 2,2-diethoxyacetophenone, 1-hydroxycyclohexylphenyl ketone, α-hydroxy-2-methylphenylpropanone, 1-hydroxy-1-methylethyl-(p-isopropylphenyl) ketone, 1-hydroxy-1-(p-dodecylphenyl) ketone, 2-methyl-(4'-(methylthio)phenyl)-2-morpholino-1-propanone or 1,1,1,-trichloromethyl-(p-butylphenyl) ketone; thioxantone derivatives, e.g., thioxantone, 2-ethylthioxantone, 2-isopropylthioxantone, 2-chlorothioxantone, 2,4-dimetylthioxantone, 2,4-dietylthioxantone or 2,4-diisopropylthioxantone; and benzoic acid ester derivatives, e.g., ethyl p-dimethylaminobenzoate or ethyl p-diethylaminobenzoate.

Examples of the azo compounds described above include azo compounds described in JP-A-8-108621.

Examples of the organic peroxides described above include trimethylcyclohexanone peroxide, acetylacetone peroxide, 1,1-bis(tert-butylperoxy)-3,3,5-trimethylcyclohexane, 1,1-bis(tert-butylperoxy)cyclohexane, 2,2-bis(tert-butylperoxy)butane, tert-butyl hydroperoxide, cumene hydroperoxide, diisopropylbenzene hydroperoxide, 2,5-dimethylhexane-2,5-dihydroperoxide, 1,1,3,3-tetramethylbutyl hydroperoxide, tert-butylcumyl peroxide, dicumyl peroxide, 2,5-dimethyl-2,5-di(tert-butylperoxy)hexane, 2,5-oxanoyl peroxide, succinic peroxide, benzoyl peroxide, 2,4-dichlorobenzoyl peroxide, diisopropylperoxy dicarbonate, di-2-ethylhexylperoxy dicarbonate, di-2-ethoxyethylperoxy dicarbonate, dimethoxyisopropylperoxy carbonate, di(3-methyl-3-methoxybutyl) peroxydicarbonate, tert-butyl peroxyacetate, tert-butyl peroxypivalate, tert-butyl peroxyneodecanoate, tert-butyl peroxyoctanoate, tert-butyl peroxylaurate, tersyl carbonate, 3,3' ,4,4' -tetra(tert-butylperoxycarbonyl)benzophenone, 3,3' ,4,4' -tetra(tert-hexylperoxycarbonyl)benzophenone, 3,3',4,4'-tetra(p-isopropylcumylperoxycarbonyl)benzophenone, carbonyl di(tert-butylperoxydihydrogen diphthalate) and carbonyl di(tert-hexylperoxydihydrogen diphthalate).

Examples of the metallocene compounds described above include various titanocene compounds described in JP-A-59-152396, JP-A-61-151197, JP-A-63-41484, JP-A-2-249, JP-A-2-4705 and JP-A-5-83588, for example, dicyclopentadienyl-Ti-bisphenyl, dicyclopentadienyl-Ti-bis-2,6-difluorophen-1-yl, dicyclopentadienyl-Ti-bis-2,4-difluorophen-1-yl, dicyclopentadienyl-Ti-bis-2,4,6-trifluorophen-1-yl, dicyclopentadienyl-Ti-bis-2,3,5,6-tetrafluorophen-1-yl, dicyclopentadienyl-Ti-bis-2,3,4,5,6-pentafluorophen-1-yl, dimethylcyclopentadienyl-Ti-bis-2,6-difluorophen-1-yl, dimethylcyclopentadienyl-Ti-bis-2,4,6-trifiuorophen-1-yl, dimethylcyclopentadienyl-Ti-bis-2,3,5,6-tetrafluorophen-1-yl, dimethylcyclopentadienyl-Ti-bis-2,3,4,5,6-pentafluorophen-1-yl, dicyclopentadienyl-Ti-bis-2,6-difluoro-3-(pyrrol-1-yl)phen-1-yl, and iron-arene complexes described in JP-A-1-304453 and JP-A-1-152109.

Examples of the hexaarylbiimidazole compounds described above include various compounds described in JP-B-6-29285 and U.S. Patents 3,479,185, 4,311,783 and 4,622,286, specifically, for example, 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole or 2,2'-bis(o-trifluoromethylphenyl)-4,4',5,5'-tetraphenylbiimidazole.

Examples of the organic borate compounds described above include organic borates described in JP-A-62-143044, JP-A-62-154242, JP-A-9-188685, JP-A-9-188686, JP-A-9-188710, JP-A-2000-131837, JP-A-2002-107916, Japanese Patent 2,764,769, JP-A-2002-116539 and Martin Kunz, Rad Tech '98, Proceeding, April 19-22 (1998), Chicago; organic boron sulfonium complexes or organic boron oxosulfonium complexes described in JP-A-6-157623, JP-A-6-175564 and JP-A-6-175561; organic boron iodonium complexes described in JP-A-6-175554 and JP-A-6-175553; organic boron phosphonium complexes described in JP-A-9-188710; and organic boron transition metal coordination complexes described in JP-A-6-348011, JP-A-7-128785, JP-A-7-140589, JP-A-7-306527 and JP-A-7-292014.

Examples of the disulfone compounds described above include compounds described in JP-A-61-166544 and JP-A-2002-328465.

Examples of the oxime ester compounds described above include compounds described in J. C. S. Perkin II, 1653-1660 (1979), J. C. S. Perkin II, 156-162 (1979), Journal of Photopolymer Science and Technology, 202-232 (1995) and JP-A-2000-66385; and compounds described in JP-A-2000-80068. Specific examples thereof include compounds represented by the following structural formulae:

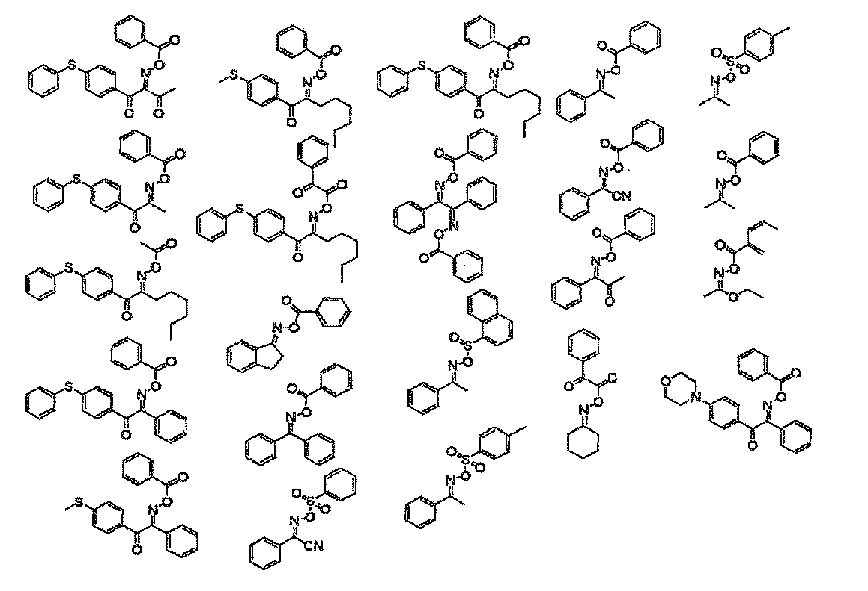

Examples of the onium salt compounds described above include diazonium salts described in S. I. Schlesinger, *Photogr. Sci. Eng*., 18, 387 (1974) and T. S. Bal et al., *Polymer*, 21, 423 (1980); ammonium salts described in U.S. Patent 4,069,055 and JP-A-4-365049; phosphonium salts described in U.S. Patents 4,069,055 and 4,069,056; iodonium salts described in European Patent 104,143, U.S. Patents 339,049 and 410,201, JP-A-2-150848 and JP-A-2-296514; sulfonium salts described in European Patents 370,693, 390,214, 233,567, 297,443 and 297,442, U.S. Patents 4,933,377, 161,811, 410,201, 339,049, 4,760,013, 4,734,444 and 2,833,827 and German Patents 2,904,626, 3,604,580 and 3,604,581; selenonium salts described in J.V Crivello et al., Macromolecules, 10 (6), 1307 (1977) and J.V Crivello et al., J. Polymer Sci., Polymer Chem. Ed., 17, 1047 (1979); and arsonium salts described in C.S. Wen et al., Teh, Proc. Conf. Rad. Curing ASIA, p. 478, Tokyo, Oct. (1988).

Particularly, in view of reactivity and stability, the oxime ester compounds and diazonium compounds, iodonium compounds and sulfonium compounds described above are enumerated as preferable examples.

The onium salts preferably usable in the invention include onium salts represented by the following formulae (RI-I) to (RI-III):

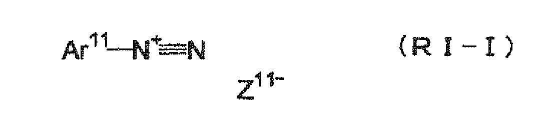

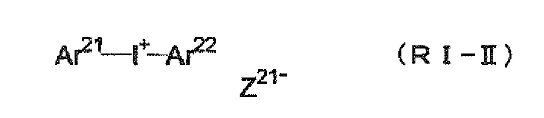

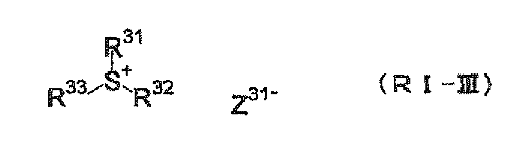

In formula (RI-I), Ar¹¹ represents an aryl group having 20 or less carbon atoms, which may have 1 to 6 substituents. Preferable example of the substituent includes an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxy group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido group or arylamido group having from 1 to 12 carbon atoms, a carbonyl group, a carboxyl group, a cyano group, a sulfonyl group, an thioalkyl group having from 1 to 12 carbon atoms and an thioaryl group having from 1 to 12 carbon atoms. Z¹¹⁻ represents a monovalent anion and specific examples thereof include a halogen ion, a perchlorate ion, a hexafluorophosphate ion, a tetrafluoroborate ion, a sulfonate ion, a sulfinate ion, a thiosulfonate ion and a sulfate ion. From the standpoints of stability and visibility of printed images, a perchlorate ion, a hexafluorophosphate ion, a tetrafluoroborate ion, a sulfonate ion or a sulfinate ion is preferable.

In the formula (RI-II), Ar²¹ and Ar²² each independently represents an aryl group having 20 or less carbon atoms, which may have 1 to 6 substituents. Preferable example of the substituent includes an alkyl group having from 1 to 12 carbon atoms, an alkenyl group having from I to 12 carbon atoms, an alkynyl group having from 1 to 12 carbon atoms, an aryl group having from 1 to 12 carbon atoms, an alkoxy group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido group or arylamido group having from 1 to 12 carbon atoms, a carbonyl group, a carboxyl group, a cyano group, a sulfonyl group, an thioalkyl group having from 1 to 12 carbon atoms and an thioaryl group having from 1 to 12 carbon atoms. Z²¹⁻ represents a monovalent anion and specific examples thereof include a halogen ion, a perchlorate ion, a hexafluorophosphate ion, a tetrafluoroborate ion, a sulfonate ion, a sulfinate ion, a thiosulfonate ion and a sulfate ion. From the standpoint of stability and visibility of printed images, a perchlorate ion, a hexafluorophosphate ion, a tetrafluoroborate ion, a sulfonate ion, a sulfinate ion or a carboxylate ion is preferable.

In the formula (RI-III), R³¹, R³² and R³³ each independently represents an aryl group having 20 or less carbon atoms, which may have 1 to 6 substituents, an alkyl group, an alkenyl group or an alkynyl group and is preferably an aryl group from the standpoints of reactivity and stability. Preferable example of the substituent includes an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxy group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido group or arylamido group having from 1 to 12 carbon atoms, a carbonyl group, a carboxyl group, a cyano group, a sulfonyl group, an thioalkyl group having from 1 to 12 carbon atoms and an thioaryl group having from 1 to 12 carbon atoms. Z³¹⁻ represents a monovalent anion and specific examples thereof include a halogen ion, a perchlorate ion, a hexafluorophosphate ion, a tetrafluoroborate ion, a sulfonate ion, a sulfinate ion, a thiosulfonate ion and a sulfate ion. From the standpoint of stability and visibility of printed images, a perchlorate ion, a hexafluorophosphate ion, a tetrafluoroborate ion, a sulfonate ion, a sulfinate ion or a carboxylate ion is preferable. Carboxylate ions described in JP-A-2001-343742 are more preferable, and carboxylate ions described in JP-A-2002-148790 are particularly preferable.

Specific examples of the onium salt compound preferably usable as the radical generator in the invention will be presented below, but the invention should not be construed as being limited thereto.

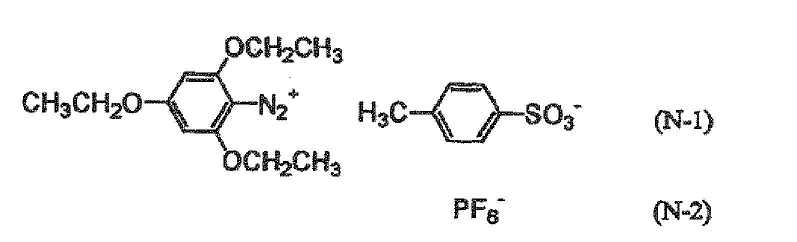

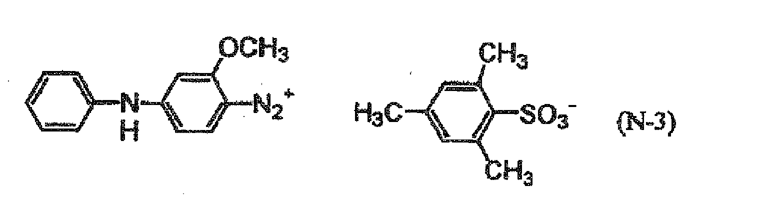

ClO₄⁻ (N-4)

PF₆⁻ (N-5)

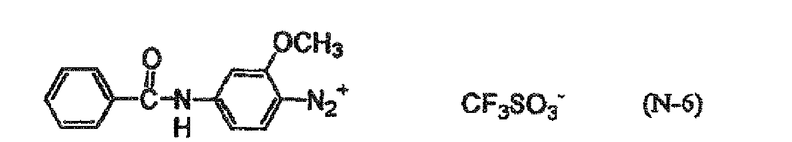

BF₄⁻ (N-7)

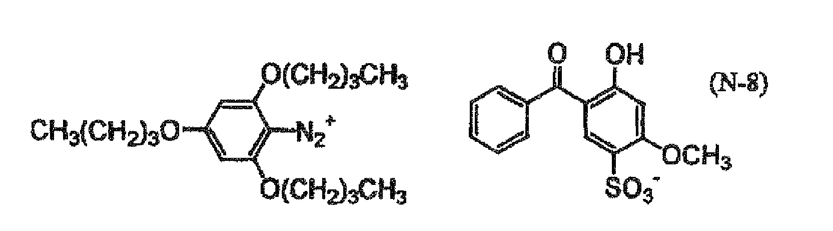

ClO₄⁻ (N-9)

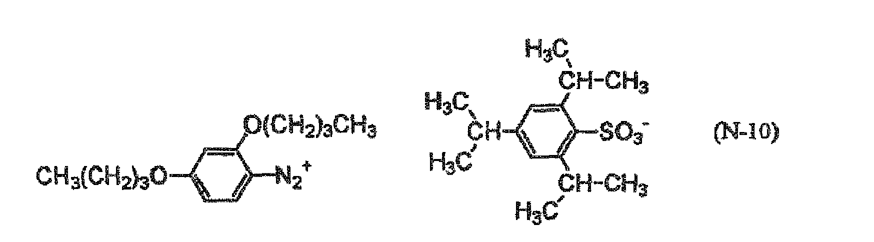

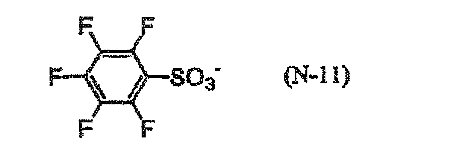

PF₆⁻ (N-12)

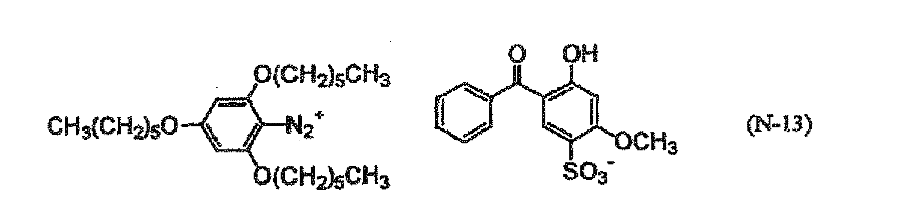

ClO₄⁻ (N-14)

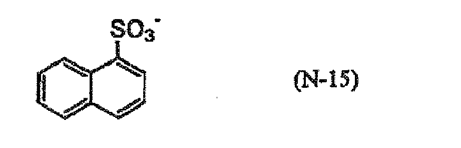

PF₆⁻ (N-16)

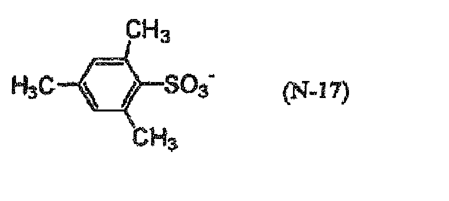

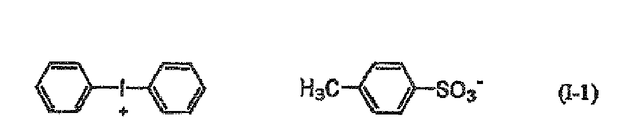

PF₆⁻ (I-2)

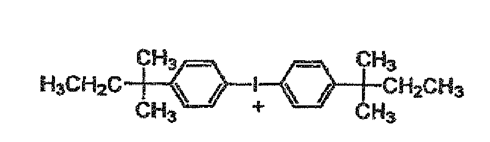

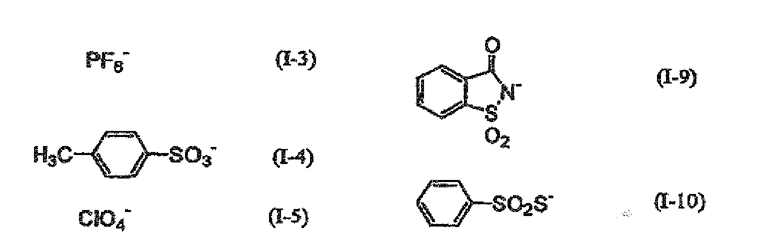

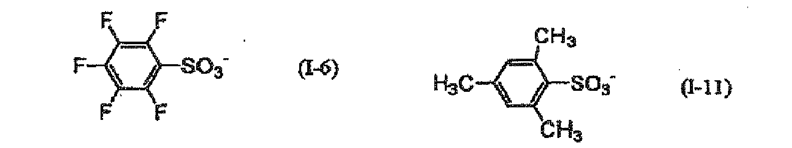

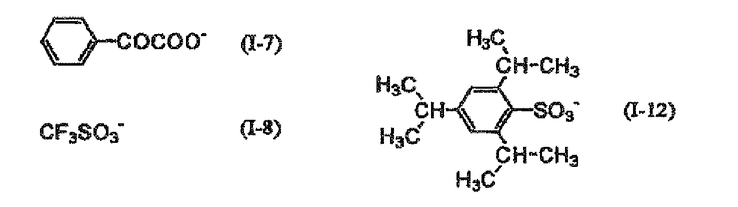

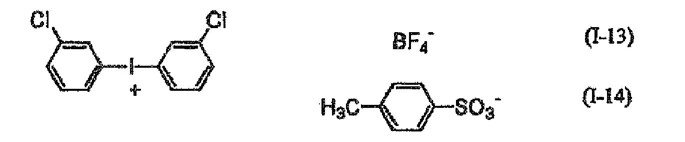

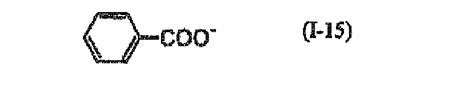

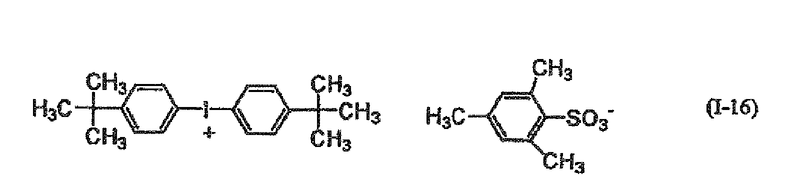

ClO₄⁻ (I-17)

PF₆⁻ (I-18)

C₄F₉SO₃⁻ (I-19)

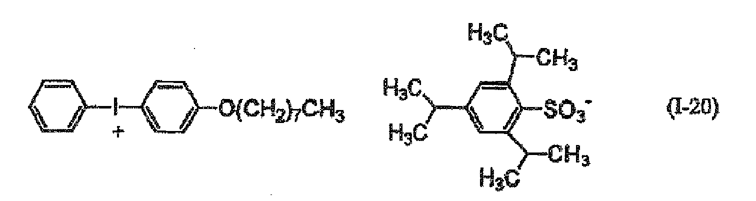

CF₃COO⁻ (I-21)

CF₃SO₃⁻ (I-22)

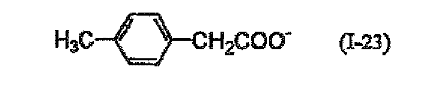

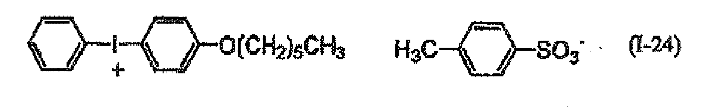

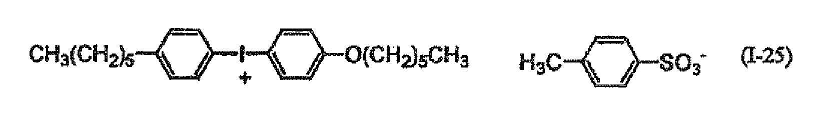

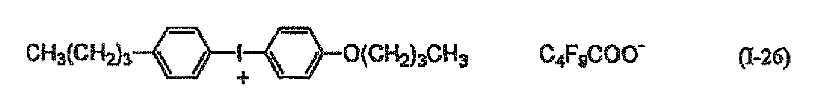

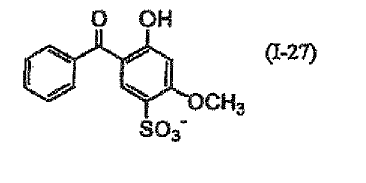

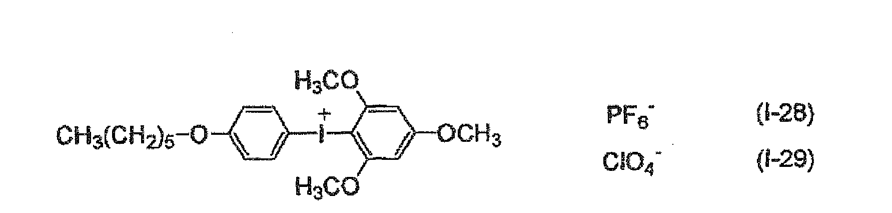

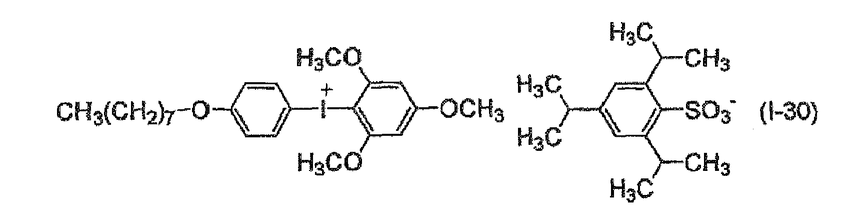

PF₆⁻ (I-31)

C₄F₉SO₃⁻ (I-32)

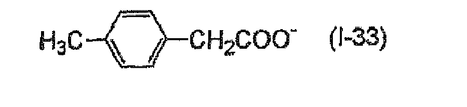

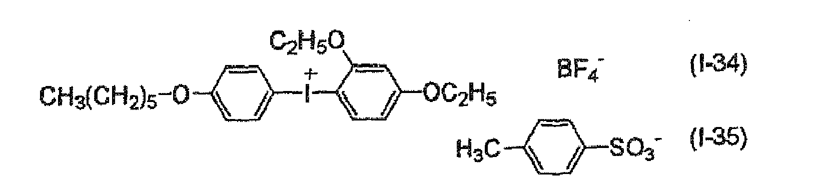

PF₆⁻ (I-36)

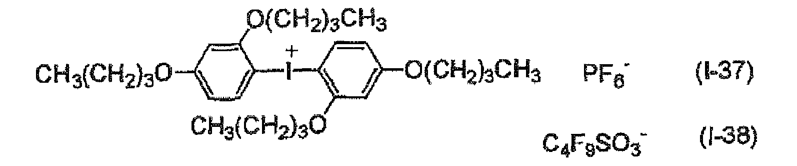

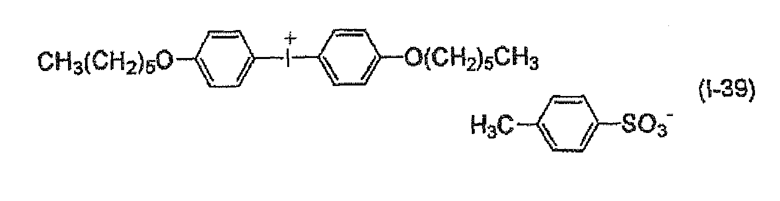

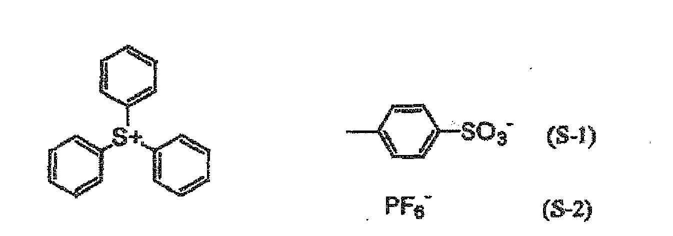

ClO₄⁻ (S-3)

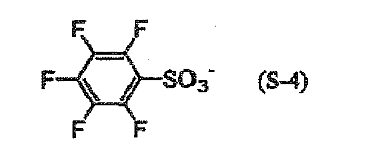

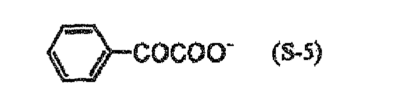

CF₃SO₃⁻ (S-6)

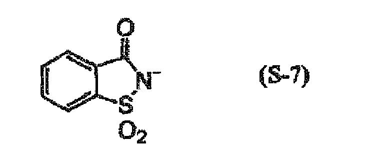

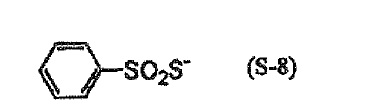

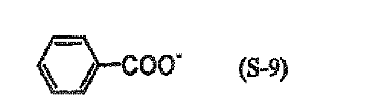

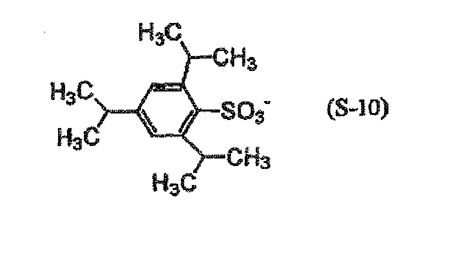

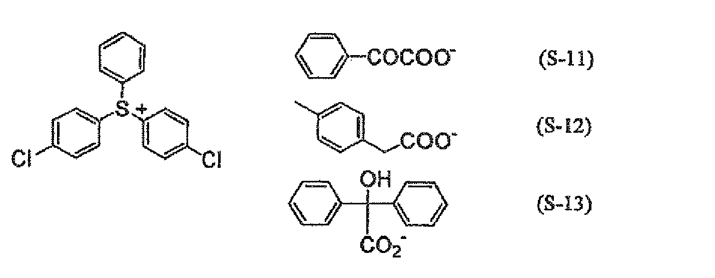

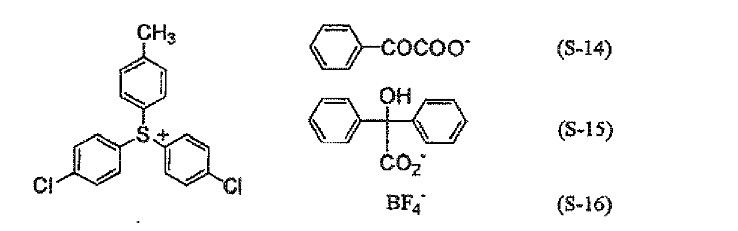

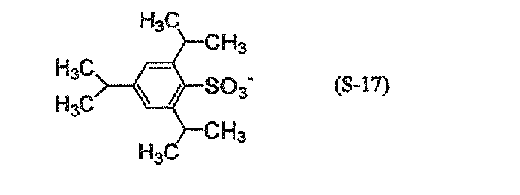

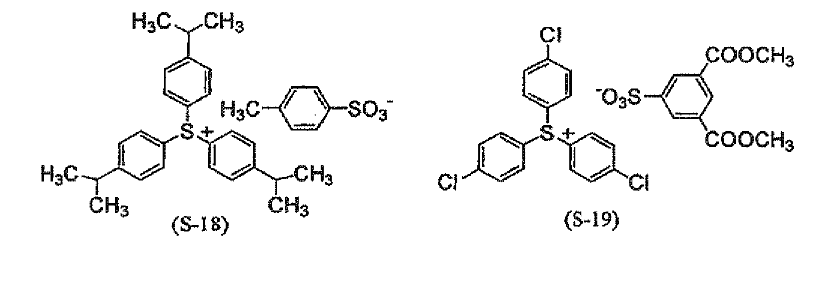

It is also possible to use a polymerization initiator having an adinium structure represented by the following formula (RI-IV). In this formula, R¹, R², R³, R⁴, R⁵ and R⁶ each independently represents a hydrogen atom, a halogen atom or a monovalent substituent, and X⁻ represents an anion.

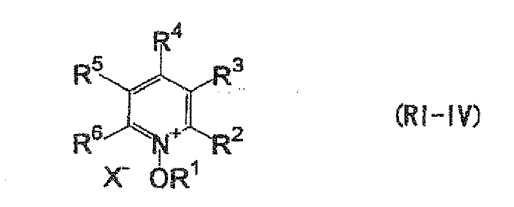

Examples of the above monovalent substituent include a halogen atom, an amino group, a substituted amino group, a substituted carbonyl group, a hydroxyl group, a substituted oxy group, a thiol group, a thioether group, a silyl group, a nitro group, a cyano group, an alkyl group, an alkenyl group, an aryl group, a heterocyclic group, a sulfo group, a substituted sulfonyl group, a sulfonato group, a substituted sulfinyl group, a phosphono group, a substituted phosphono group, a phosphonato group and a substituted phosphonato group. These substituents may have an additional substituent, if it can be introduced thereinto.

The compound represented by the formula (RI-IV) includes a (polymeric) compound having two or more cation moieties in which the skeletons of a specific structure (cation moiety) of the compound represented by the formula (RI-IV) are bonded together via R¹. Such a compound is appropriately usable.

Moreover, the compound represented by the formula (RI-IV) may be a (polymeric) compound which is introduced into a polymer chain via any one of R¹ to R⁶. Such a compound can be cited as a preferred embodiment.

Next, specific examples of the compound represented by the formula (RI-IV) [Exemplary Compounds A-1 to A-34] will be presented, but the invention should not be construed as being limited thereto.

| | | logP |
|---|---|---|
| A-1 | 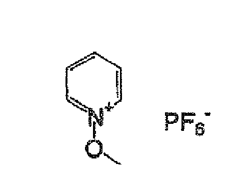 | 0. 916 |
| A-2 | 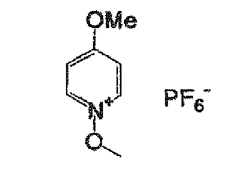 | 0. 835 |
| A-3 | 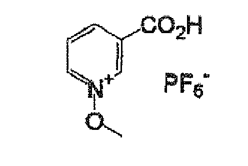 | 0. 659 |
| A-4 | 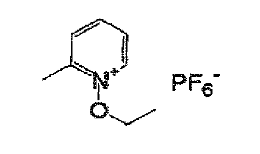 | 1. 415 |
| A-5 | 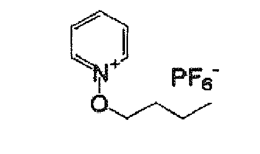 | 2. 503 |
| A-6 | 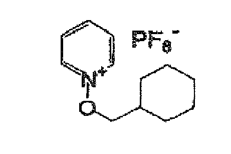 | 3. 566 |
| A-7 | 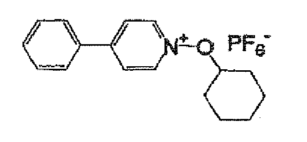 | 5. 545 |
| A-8 | 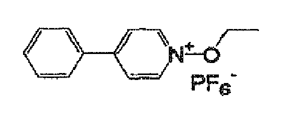 | 3. 333 |
| A-9 | 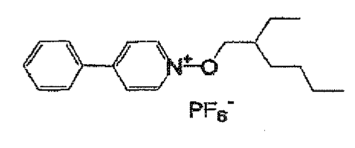 | 6. 377 |
| A- 10 | 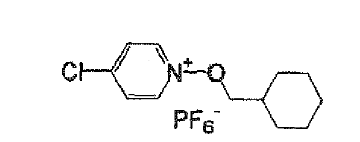 | 4. 279 |
| A- 11 | 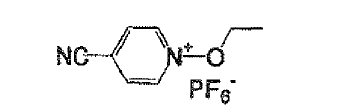 | 0. 878 |
| A- 12 | 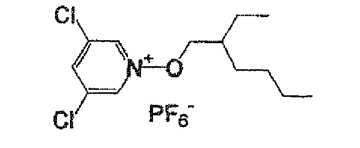 | 5. 915 |
| A- 13 | 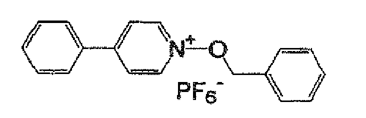 | 4. 752 |
| A- 14 | 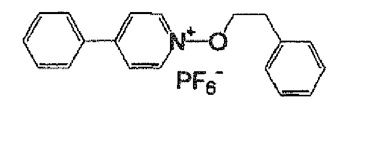 | 4. 901 |
| A- 15 | 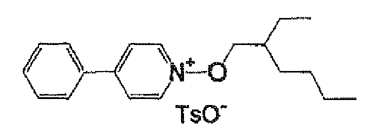 | 6. 377 |
| A- 16 | 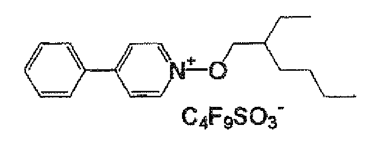 | 6. 377 |
| A- 17 | 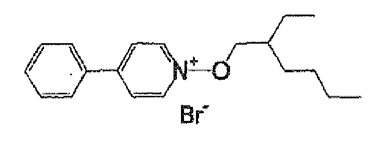 | 6. 377 |
| A- 18 | 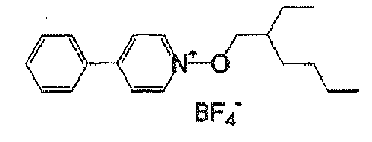 | 6. 377 |
| A- 19 | 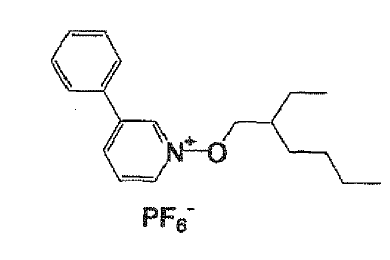 | 6. 377 |
| A- 20 | 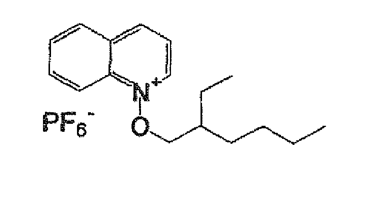 | 6. 223 |
| A- 21 | 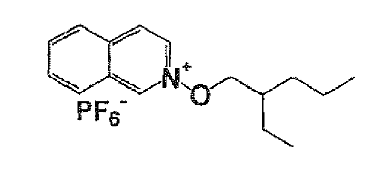 | 5. 663 |
| A- 22 | 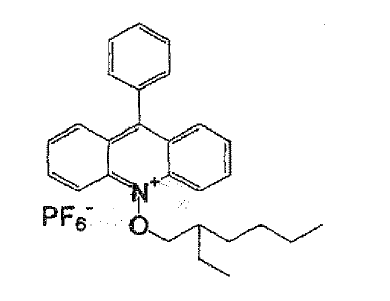 | 9. 441 |
| A- 23 | 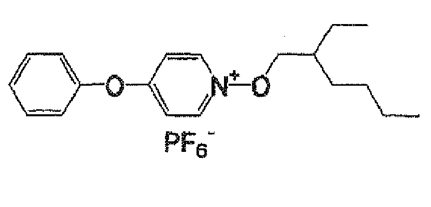 | 6. 587 |
| A- 24 | 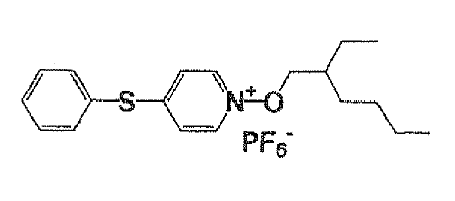 | 6. 827 |
| A- 25 | 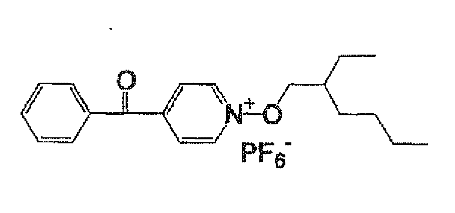 | 5. 527 |
| A- 26 | 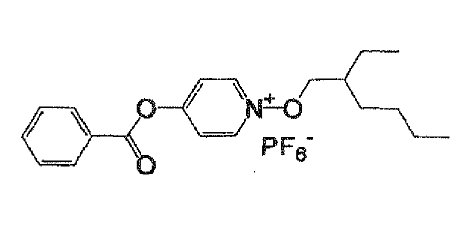 | 5. 967 |
| A- 27 | 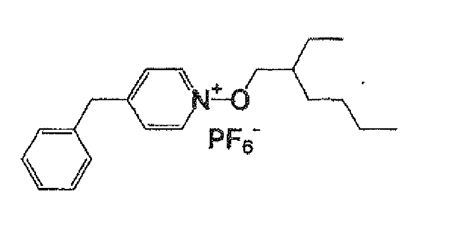 | 6. 556 |
| A- 28 | 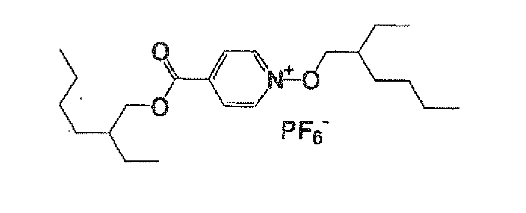 | 8. 031 |
| A- 29 | 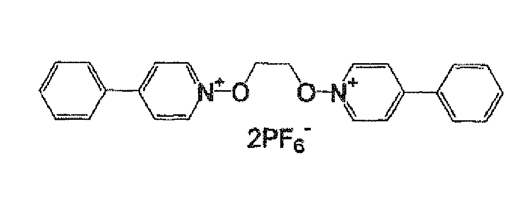 | 5. 821 |
| A- 30 | 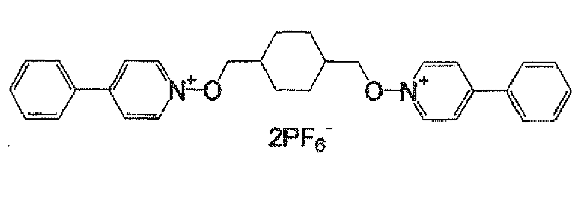 | 6. 935 |
| A- 31 | 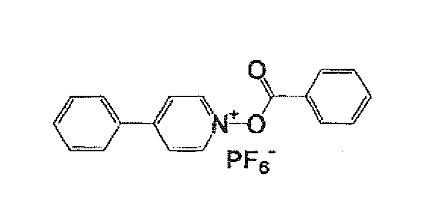 | 4. 668 |
| A- 32 | 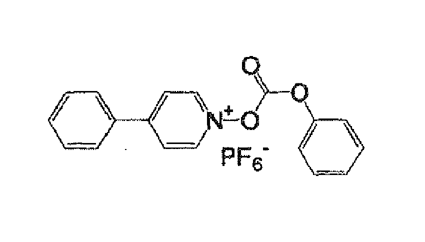 | 4. 239 |
| A-33 | 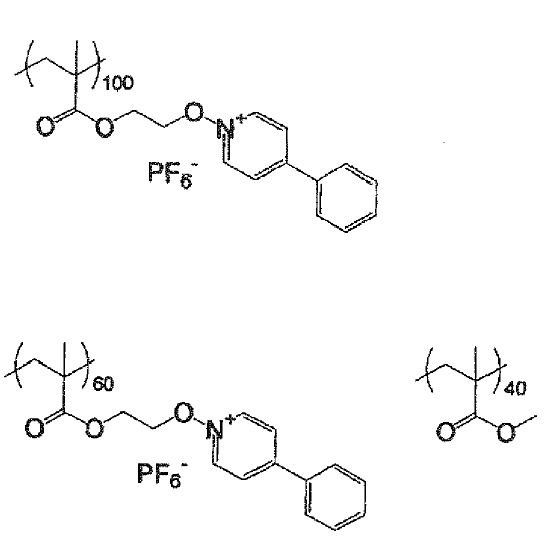 | |
| A- 34 | | |

Although the radical generator is not restricted to those cited above, a triazine initiator, an organic halogen compound, an oxime ester compound, a diazonium salt, an iodonium salt or a sulfonium salt is more preferred particularly from the viewpoints of reactivity and stability. Among these radical generators, an onium salt having an inorganic ion (for example, PF₆⁻ or BF₄⁻) as the counter ion is preferable from the viewpoint of combining with an infrared absorbing agent and improving the visibility of printed images. As the onium, diaryl iodonium is preferable because of being excellent in color developing properties.

The radical generator can be added ordinarily in an amount from 0.1 to 50% by mass, preferably from 0.5 to 30% by mass and particularly preferably from 0.8 to 20% by mass, based on the total solid content constituting the image-recording layer. In the above-described range, good sensitivity and good stain resistance in the non-image area at the time of printing can be achieved. Either a single radical generator or a combination of two or more thereof may be used. Also, the radical generator may be added together with other components in one layer or may be added to a different layer separately provided.

### [(D) Polymerizable monomer]

The polymerizable monomer usable in the invention is, for example, an addition-polymerizable compound having at least one ethylenically unsaturated double bond and it is selected from compounds having at least one, preferably two or more, terminal ethylenically unsaturated double bonds. Such compounds are widely known in the field of art and they can be used in the invention without any particular limitation. The compound is in a chemical form of, for example, a monomer, a prepolymer, i.e., a dimer, a trimer or an oligomer, or a mixture thereof or a copolymer thereof. Examples of the monomer and copolymer thereof include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with an aliphatic polyhydric alcohol compound and amides of an unsaturated carboxylic acid with an aliphatic polyvalent amine compound are used. It is also preferable to use an addition reaction product of an unsaturated carboxylic acid ester or amide having a nucleophilic substituent, for example, a hydroxy group, an amino group or a mercapto group, with a monofunctional or polyfunctional isocyanate or epoxy, or a dehydration condensation reaction product of the unsaturated carboxylic acid ester or amide with a monofunctional or polyfunctional carboxylic acid. Furthermore, use can be preferably made of an addition reaction product of an unsaturated carboxylic acid ester or amide having an electrophilic substituent, for example, an isocyanato group or an epoxy group with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol. In addition, compounds in which the unsaturated carboxylic acid described above is replaced by an unsaturated phosphonic acid, styrene, vinyl ether or the like can also be used.

Specific examples of the monomer, which is an ester of an aliphatic polyhydric alcohol compound with an unsaturated carboxylic acid, include acrylic acid esters, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, polyester acrylate oligomer or isocyanuric acid EO modified triacrylate; methacrylic acid esters, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane or bis[p-(methacryloxyethoxy)phenyl]dimethylmethane; itaconic acid esters, for example, ethylene glycol diitaconate, propylene glycol diitaconate, 1,3-butanediol diitaconate, 1,4-butanediol diitaconate, tetraethylene glycol diitaconate, pentaerythritol diitaconate or sorbitol tetraitaconate; crotonic acid esters, for example, ethylene glycol dicrotonate, tetramethylene glycol dicrotonate, pentaerythritol dicrotonate or sorbitol tetradicrotonate; isocrotonic acid esters, for example, ethylene glycol diisocrotonate, pentaerythritol diisocrotonate or sorbitol tetraisocrotonate; and maleic acid esters, for example, ethylene glycol dimaleate, triethylene glycol dimaleate, pentaerythrital dimaleate and sorbitol tetramaleate.

Other examples of the ester, which can be preferably used, include aliphatic alcohol esters described in JP-B-51-47334 and JP-A-57-196231; esters having an aromatic skeleton described in JP-A-59-5240, JP-A-59-5241 and JP-A-2-226149; and esters containing an amino group described in JP-A-1-165613. Furthermore, it is also possible to use a mixture of the ester monomers as described above.

Specific examples of the monomer, which is an amide of an aliphatic polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide. Other preferable examples of the amide monomer include amides having a cyclohexylene structure described in JP-B-54-21726.

It is also preferable to use urethane type addition polymerizable monomers produced using an addition reaction between an isocyanate and a hydroxy group, and specific examples thereof include vinylurethane compounds having two or more polymerizable vinyl groups per molecule obtained by adding a vinyl monomer containing a hydroxy group represented by formula (a) shown below to a polyisocyanate compound having two or more isocyanate groups per molecule, described in JP-B-48-41708.

CH₂=C(R⁴)COOCH₂CH(R⁵)OH (a)

wherein R⁴ and R⁵ each independently represents H or CH₃.

Also, use can be preferably made of urethane acrylates described in JP-A-51-37193, JP-B-2-32293 and JP-B-2-16765, and urethane compounds having an ethylene oxide skeleton described in JP-B-58-49860, JP-B-56-17654, JP-B-62-39417 and JP-B-62-39418. Furthermore, a photopolymerizable composition having remarkably excellent photosensitive speed can be obtained by using an addition polymerizable compound having an amino structure or a sulfide structure in its molecule, described in JP-A-63-277653, JP-A-63-260909 and JP-A-1-105238.

Other examples include polyfunctional acrylates and methacrylates, for example, polyester acrylates and epoxy acrylates obtained by reacting an epoxy resin with acrylic acid or methacrylic acid, described in JP-A-48-64183, JP-B-49-43191 and JP-B-52-30490. Moreover, there can be enumerated unsaturated compounds described in JP-B-46-43946, JP-B-1-40337 and JP-B-1-40336, and vinylphosphonic acid type compounds described in JP-A-2-25493. In some cases, structure containing a perfluoroalkyl group described in JP-A-61-22048 can be preferably used. Moreover, it is possible to use photocurable monomers or oligomers described in Nippon Secchaku Kyokaishi (Journal of Japan Adhesion Society), Vol. 20, No. 7, pages 300 to 308 (1984).

Details of the method of using the polymerizable monomer, namely, selection of the structure, individual or combination use, an amount added or the like, can be appropriately arranged depending on the characteristic design of the final lithographic printing plate precursor. For instance, the selection can be made from the following standpoints.

In view of the sensitivity, a structure having a large content of unsaturated groups per molecule is preferred and in many cases, a bifunctional or more functional compound is preferred. In order to increase the strength of image area, that is, hardened layer, a trifunctional or more functional compound is preferred. A combined use of compounds different in the functional number or in the kind of polymerizable group (for example, an acrylic acid ester, a methacrylic acid ester, a styrene compound or a vinyl ether compound) is an effective method for controlling both the sensitivity and the strength.

The selection and use method of the polymerizable monomer are also important factors for the compatibility and dispersibility with other components (for example, a binder polymer, a polymerization initiator or a coloring agent) in the image-recording layer. For instance, the compatibility may be improved in some cases by using the compound of low purity or using two or more kinds of the compounds in combination. A specific structure may be selected for the purpose of improving an adhesion property to a support or a protective layer as will be described hereinafter.

The polymerizable monomer is preferably used in an amount from 5 to 80% by mass, more preferably from 25 to 75% by mass, based on the nonvolatile component of the image-recording layer. Either a single polymerizable monomer or a combination of two or more thereof may be used. With respect to the method of using the polymerizable monomer, the structure, blend and amount added can be appropriately selected by taking account of the extent of polymerization inhibition due to oxygen, resolution, fogging property, change in refractive index, surface tackiness and the like. Further, it is possible in some cases to employ a layer construction, for example, an undercoat layer or an overcoat layer, and a coating method.

### [Other components in image-recording layer]

The image-recording layer of the invention may further contain various components if required. Next, these components will be illustrated.

### <1> Microcapsules and microgel

In the invention, several embodiments can be employed in order to incorporate the above-described constituting components of the image-recording layer and other constituting components described hereinafter into the image-recording layer. One embodiment is the image-recording layer of molecular dispersion type prepared by dissolving the constituting components in an appropriate solvent to coat as described, for example, in JP-A-2002-287334. Another embodiment is the image-recording layer of microcapsule type prepared by encapsulating all or part of the constituting components into microcapsule to incorporate into the image-recording layer as described, for example, in JP-A-2001-277740 and JP-A-2001-277742. In the image-recording layer of microcapsule type, the constituting components may be present outside the microcapsules. It is a more preferable embodiment of the image-recording layer of microcapsule type that the hydrophobic constituting components are encapsulated in microcapsules and the hydrophilic constituting components are present outside the microcapsules.

As a still another embodiment, the image-recording containing cross-linking resin particles, i.e., a microgel can be cited. The microgel can contain a part of the constituting components therein and/or on the surface thereof. From the viewpoints of image formation sensitivity and printing durability, a particularly preferable embodiment is one wherein a reactive microgel is formed by having the polymerizable monomer (D) on the surface.

In order to achieve more preferable on-machine developability, the image-recording layer is preferably the image-recording layer of microcapsule type or microgel type.

As the method of preparing the microcapsules or microgel of the constituting components of the image-recording layer, known methods can be used.

Methods of producing the microcapsules include, for example, a method of utilizing coacervation described in U.S. Patents 2,800,457 and 2,800,458; a method of using interfacial polymerization described in U.S. Patent 3,287,154, JP-B-38-19574 and JP-B-42-446; a method of using deposition of polymer described in U.S. Patents 3,418,250 and 3,660,304; a method of using an isocyanate polyol wall material described in U.S. Patent 3,796,669; a method of using an isocyanate wall material described in U.S. Patent 3,914,511; a method of using a urea-formalriehyde-type or urea-formaldehyde-resorcinol-type wall-forming material described in U.S. Patens 4,001,140, 4,087,376 and 4,089,802; a method of using a wall material, for example, a melamine-formaldehyde resin or hydroxycellulose described in U.S. Patent 4,025,445; an *in situ* method by monomer polymerization described in JP-B-36-9163 and JP-B-51-9079; a spray drying method described in British Patent 930,422 and U.S. Patent 3,111,407; and an electrolytic dispersion cooling method described in British Patents 952,807 and 967,074, though the invention should not be construed as being limited thereto.

A preferable microcapsule wall usable in the invention has a three-dimensional crosslinkage and has a solvent-swellable property. From this point of view, a preferable wall material of the microcapsule includes polyurea, polyurethane, polyester, polycarbonate, polyamide and a mixture thereof, and polyurea and polyurethane are particularly preferred. Further, a compound having a crosslinkable functional group such as an ethylenically unsaturated bond, which can be introduced into the binder polymer as will be described hereinafter, may be introduced into the microcapsule wall.

On the other hand, as a method of preparing the microgel there may be used granulation using interfacial polymerization described in JP-B-38-19574 and JP-B-42-446 or granulation using non-aqueous dispersion polymerization described in JP-A-5-61214. However, the invention should not be construed as being limited to any one of the isomers.

As the above-described method utilizing interfacial polymerization, use may be made of the known microcapsule producing methods that are cited above.

The microgel preferably usable in the invention is one that is produced by granulation using interfacial polymerization and has a three-dimensional crosslinkage. From this standpoint of view, the material to be used herein is preferably polyurea, polyurethane, polyester, polycarbonate, polyamide or a mixture thereof, particularly preferably polyurea or polyurethane.

The average particle diameter of the above-described microcapsules or microgel is preferably from 0.01 to 3.0 µm, more preferably from 0.05 to 2.0 µm, and particularly preferably from 0.10 to 1.0 µm. Within this range, a good resolution and a good age stability can be obtained.

### <2> Binder polymer

The image-recording layer of the invention may contain a binder polymer to improve the film strength of the image-recording layer. The binder polymer usable in the invention can be selected from those heretofore known without restriction, and a polymer having a film forming property is preferable. Examples of the binder polymer include acrylic resins, polyvinyl acetal resins, polyurethane resins, polyurea resins, polyimide resins, polyamide resins, epoxy resins, methacrylic resins, polystyrene resins, novolac type phenolic resins, polyester resins, synthesis rubbers and natural rubbers.

The binder polymer may have a crosslinkability in order to improve the film strength of the image area. In order to impart the crosslinkability to the binder polymer, a crosslinkable functional group such as an ethylenically unsaturated bond is introduced into the main chain or side chain of the polymer. The crosslinkable functional group may be introduced by copolymerization.

Examples of the polymer having an ethylenically unsaturated bond in the main chain thereof include poly-1,4-butadiene and poly-1,4-isoprene.

Examples of the polymer having an ethylenically unsaturated bond in the side chain thereof include a polymer of an ester or amide of acrylic acid or methacrylic acid, which is a polymer wherein the ester or amide residue (R in -COOR or -CONHR) has an ethylenically unsaturated bond.

Examples of the residue (R as described above) having an ethylenically unsaturated bond include -(CH₂)ₙCR¹=CR²R³, -(CH₂O)ₙCH₂CR¹=CR²R³, -(CH₂CH₂O)ₙCH₂CR¹=CR²R³, -(CH₂)ₙNH-CO-O-CH₂CR¹=CR²R³, -(CH₂)ₙ-O-CO-CR¹=CR²R³ and -(CH₂CH₂O)₂-X (wherein R¹ to R³ each represents a hydrogen atom, a halogen atom or an alkyl group having from 1 to 20 carbon atoms, an aryl group, alkoxy group or aryloxy group, or R¹ and R² or R¹ and R³ may be bonded together to form a ring; n represents an integer of 1 to 10; and X represents a dicyclopentadienyl residue).

Specific examples of the ester residue include -CH₂CH=CH₂ (described in JP-B-7-21633), -CH₂CH₂O-CH₂CH=CH₂, -CH₂C(CH₃)=CH₂, -CH₂CH=CH-C₆H₅, -CH₂CH₂OCOCH=CH-C₆H₅, -CH₂CH₂-NHCOO-CH₂CH=CH₂ and -CH₂CH₂O-X (wherein X represents a dicyclopentadienyl residue).

Specific examples of the amide residue include -CH₂CH=CH₂, -CH₂CH₂-Y (wherein Y represents a cyclohexene residue) and -CH₂CH₂-OCO-CH=CH₂.

The binder polymer having crosslinkability is hardened, for example, by adding a free radical (a polymerization initiating radical or a growing radical of a polymerizable compound during polymerization) to the crosslinkable functional group of the polymer and allowing the occurrence of addition polymerization between the polymers directly or through a polymerization chain of the polymerizable compound to form crosslinkage between the polymer molecules. Alternately, it is hardened by generation of a polymer radical upon extraction of an atom in the polymer (for example, a hydrogen atom on a carbon atom adjacent to the functional crosslinkable group) by a free radial and connecting the polymer radicals with each other to form cross-linkage between the polymer molecules.

The content of the crosslinkable group in the binder polymer (content of the radical polymerizable unsaturated double bond determined by iodine titration) is preferably from 0.1 to 10.0 mmol, more preferably from 1.0 to 7.0 mmol and most preferably from 2.0 to 5.5 mmol, per gram of the binder polymer. Within the above-described range, a good sensitivity and a good storage stability can be achieved.

From the standpoint of improvement in the on-machine developability of the unexposed area of the image-recording layer, it is preferred that the binder polymer has high solubility or dispersibility in an ink and/or dampening water. In order to improve the solubility or dispersibility in the ink, it is preferable that the binder polymer is oleophilic. In order to improve the solubility or dispersibility in the dampening water, it is preferable that the binder polymer is hydrophilic. Therefore, it is also effective in the invention that an oleophilic binder polymer and a hydrophilic binder polymer are used in combination.

Preferable examples of the hydrophilic binder polymer include, a polymer having a hydrophilic group, for example, a hydroxy group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfo group or a phosphate group.

Specific examples of the hydrophilic binder polymer include gum arabic, casein, gelatin, a starch derivative, carboxymethyl cellulose and sodium salt thereof, cellulose acetate, sodium alginate, a vinyl acetate-maleic acid copolymer, a styrene-maleic acid copolymer, polyacrylic acid and a salt thereof, polymethacrylic acid and a salt thereof, a homopolymer or copolymer of hydroxyethyl methacrylate, a homopolymer or copolymer of hydroxyethyl acrylate, a homopolymer or copolymer of hydroxypropyl methacrylate, a homopolymer or copolymer of hydroxypropyl acrylate, a homopolymer or copolymer of hydroxybutyl methacrylate, a homopolymer or copolymer of hydroxybutyl acrylate, a polyethylene glycol, a hydroxypropylene polymer, polyvinyl alcohol, a hydrolyzed polyvinyl acetate having a hydrolysis degree of 60% by mole or more, preferably 80% by mole or more, polyvinyl formal, polyvinyl butyral, polyvinylpyrrolidone, a homopolymer or copolymer of acrylamide, a homopolymer or polymer of methacrylamide, a homopolymer or copolymer of N-methylolacrylamide, an alcohol-soluble nylon, and a polyether of 2,2-bis-(4-hydroxyphenyl)propane and epichlorohydrin.

The mass-average molecular weight of the binder polymer is preferably 5,000 or more, more preferably from 10,000 to 300,000. The number-average molecular weight of the binder polymer is preferably 1,000 or more, more preferably from 2,000 to 250,000. The polydispersity (weight average molecular weight/number average molecular weight) of the binder polymer is preferably from 1.1 to 10.

The binder polymer can be obtained by purchasing a marketed product or synthesizing according to conventionally known methods.

The content of the binder polymer is usually from 5 to 90% by mass, more preferably from 5 to 80% by mass, and still more preferably from 10 to 70% by mass, based on the total solid content of the image-recording layer. Within this range, a good strength of the image area and a good image-forming property can be achieved.

It is preferred that the polymerizable monomer (D) and the binder polymer are used in such amounts as to give a ratio by mass of 0.5/1 to 4/1.

### <3> Surfactant

In the image-recording layer of the invention, use can be made of a surfactant to accelerate the on-machine developability and improve the state of coated surface. Examples of usable surfactant include a nonionic surfactant, an anionic surfactant, a cationic surfactant, an amphoteric surfactant and a fluorine-based surfactant. Either one of these surfactants or a combination of two or more thereof may be used.

The nonionic surfactant usable in the invention is not particular restricted, and those hitherto known can be used. Examples of the nonionic surfactant include polyoxyethylene alkyl ethers, polyoxyethylene alkyl phenyl ethers, polyoxyethylene polystyryl phenyl ethers, polyoxyethylene polyoxypropylene alkyl ethers, glycerol fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerol fatty acid partial esters, polyoxyethylenated castor oils, polyoxyethylene glycerol fatty acid partial esters, fatty acid diethanolamides, N,N-bis-2-hydroxyalkylamines, polyoxyethylene alkylamines, triethanolamine fatty acid esters, trialylamine oxides, polyethylene glycols and copolymers of polyethylene glycol and polypropylene glycol.

The anionic surfactant usable in the invention is not particularly restricted and those hitherto known can be used. Examples of the anionic surfactant include fatty acid salts, abietic acid salts, hydroxyalkanesulfonic acid salts, alkanesulfonic acid salts, dialkylsulfosuccinic ester salts, straight-chain alkylbenzenesulfonic acid salts, branched alkylbenzenesulfonic acid salts, alkylnaphthalenesulfonic acid salts, alkylphenoxypolyoxyethylene propylsulfonic acid salts, polyoxyethylene alkylsulfophenyl ether salts, N-methyl-N-oleyltaurine sodium salt, N-alkylsulfosuccinic monoamide disodium salts, petroleum sulfonic acid salts, sulfated beef tallow oil, sulfate ester salts of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partial saponification products of styrene/maleic anhydride copolymer, partial saponification products of olefin/maleic anhydride copolymer and naphthalene sulfonate formalin condensates.

The cationic surfactant usable in the invention is not particularly restricted and those hitherto known can be used. Examples of the cationic surfactant include alkylamine salts, quaternary ammonium salts, polyoxyethylene alkyl amine salts and polyethylene polyamine derivatives.

The amphoteric surfactant usable in the invention is not particularly restricted and those hitherto known can be used. Examples of the amphoteric surfactant include carboxybetaines, aminocarboxylic acids, sulfobetaines, aminosulfuric esters, and imidazolines.

In the surfactants described above, the term "polyoxyethylene" can be replaced with "polyoxyalkylene", for example, polyoxymethylene, polyoxypropylene or polyoxybutylene, and such surfactants can also be used in the invention.

Further, preferable examples of the surfactant include a fluorine-based surfactant containing a perfluoroalkyl group in its molecule. Examples of the fluorine-based surfactant include an anionic type such as perfluoroalkyl carboxylates, perfluoroalkyl sulfonates or perfluoroalkylphosphates; an amphoteric type such as perfluoroalkyl betaines; a cationic type such as perfluoroalkyl trimethyl ammonium salts; and a nonionic type such as perfluoroalkyl amine oxides, perfluoroalkyl ethylene oxide adducts, oligomers having a perfluoroalkyl group and a hydrophilic group, oligomers having a perfluoroalkyl group and an oleophilic group, oligomers having a perfluoroalkyl group, a hydrophilic group and an oleophilic group or urethanes having a perfluoroalkyl group and an oleophilic group. Further, use can be appropriately made of fluorine-based surfactants described in JP-A-62-170950, JP-A-62-226143 and JP-A-60-168144.

Either one of these surfactants or a combination of two or more thereof may be used.

The content of the surfactant is preferably from 0.001 to 10% by mass, more preferably from 0.01 to 5% by mass, based on the total solid content of the image-recording layer.

### <4> Coloring agent

In the image-recording layer according to the invention, use can be also made of a dye having a large absorption in the visible region as the coloring agent of the image. Specific examples of the dye include Oil yellow #101, Oil yellow #103, Oil pink #312, Oil green BG, Oil blue BOS, Oil blue #603, Oil black BY, Oil black BS, Oil black T-505 (produced by Orient Chemical Industries, Ltd.), Victoria pure blue, Crystal violet (CI42555), Methyl violet (CI42535), Ethyl violet, Rhodamine B (CI45170B), Malachite green (CI42000), Methylene blue (CI52015) and dyes described in JP-A-62-293247. Further, a pigment, for example, a phthalocyanine pigment, an azo pigment, carbon black or titanium oxide can be preferably used.

It is preferred to add the coloring agent, since it contributes to the improvement in the distinction between the image area and the non-image area after the formation of image. The amount of the coloring agent added is preferably from 0.01 to 10% by mass based on the total solid content of the image-recording layer.

### <5> Print-out agent

To the image-recording layer according to the invention, a compound causing discoloration by an acid or a radical can be added in order to form a print-out image. As such a compound, use can be effectively made of various kinds of colorants, for example, dyes of diphenylmethane type, triphenylmethane type, thiazine type, oxazine type, xanthene type, anthraquinone type, iminoquinone type, azo type and azomethine type.

Specific examples thereof include dyes, for example, Brilliant green, Ethyl violet, Methyl green, Crystal violet, basic Fuchsine, Methyl violet 2B, Quinaldine red, Rose Bengal Methanyl yellow, Thimol sulfophthalein, Xylenol blue, Methyl orange, Paramethyl red, Congo red, Benzo purpurin 4B, α-Naphthyl red, Nile blue 2B, Nile blue A, Methyl violet, Malachite green, Parafuchsine, Victoria pure blue BOH (produced by Hodogaya Chemical Co., Ltd.), Oil blue #603 (produced by Orient Chemical Industries, Ltd.), Oil pink #312 (produced by Orient Chemical Industries, Ltd.), Oil red 5B (produced by Orient Chemical Industries, Ltd.), Oil scarlet #308 (produced by Orient Chemical Industries, Ltd.), Oil red OG (produced by Orient Chemical Industries, Ltd.), Oil red RR (produced by Orient Chemical Industries, Ltd.), Oil green #502 (produced by Orient Chemical Industries, Ltd.), Spiron Red BEH special (produced by Hodogaya Chemical Co., Ltd.), m-Cresol purple, Cresol red, Rhodamine B, Rhodamine 6G, Sulfo rhodamine B, Auramine, 4-p-diethylaminophenyliminonaphthoquione, 2-carboxyanilino-4-p-diethylaminophenyliminonaphthoquinone, 2-carboxystearylamino-4-p-N,N-bis(hydroxyethyl)aminophenyliminonaphthoquinone, 1-phenyl-3-methyl-4-p-diethylaminophenylimino-5-pyrazolon or 1-β-naphtyl-4-p-diethylaminophenylimino-5-pyrazolon; and a leuco dye, for example, p, p', p"-hexamethyltriaminotriphenylmethane (leuco crystal violet) or Pergascript Blue SRB (produced by Ciba Geigy Ltd.).

In addition to those described above, use can be preferably made of a leuco dye that is known as a material for heat-sensitive paper or pressure-sensitive paper. Specific examples thereof include crystal violet lactone, malachite green lactone, benzoyl leuco methylene blue, 2-(N-phenyl-N-methylamino)-6-(N-p-tolyl-N-ethyl)aminofluoran, 2-anilino-3-methyl-6-(n-ethyl-p-tolidino)fluoran, 3,6-dimethoxyfluoran, 3-(N,N-diethylamino)-5-methyl-7-(N,N-dibenzylamino)fluoran, 3-(N-cyclohexyl-N-methylamino)-6-methyl-7-anilinofluoran, 3-(N-N-diethylamino)-6-methyl-7-anilinofluoran, 3-(N,N-diethylamino)-6-methyl-7-xylidinofluoran, 3-(N,N-diethylamino)-6-methyl-7-chlorofluoran, 3-(N,N-diethylamino)-6-methoxy-7-aminofluoran, 3-(N,N-diethylanino)-7-(4-chloroanilino)fluoran, 3-(N,N-diethylamino)-7-chlorofluoran, 3-(N,N-diethylamino)-7-benzylaminofluoran, 3-(N,N-diethylamino)-7,8-benzofluoran, 3-(N,N-dibutylamino)-6-methyl-7-anilinofluoran, 3-(N,N-dibutylamino)-6-methyl-7-xylidinofluoran, 3-pipelidino-6-methyl-7-anilinofluoran, 3-pyrolidino-6-methyl-7-anilinofluoran, 3,3-bis(1-ethyl-2-methylindol-3-yl)phthalide, 3,3-bis(1-n-butyl-2-methylindol-3-yl)phthalide, 3,3-bis(p-dimethylaminophenyl)-6-dimethylaminophthalide, 3-(4-diethylamino-2-ethoxyphenyl)-3-(1-ethyl-2-methylindol-3-yl)-4-zaphthalide and 3-(4-diethylaminophenyl)-3-(1-ethyl-2-methylindol-3-yl)phthalide.

The dye that is discolored by an acid or radical is preferably added in an amount of 0.01 to 10% by mass based on the solid content of the image-recording layer.

### <6> Polymerization inhibitor

It is preferred to add a small amount of a thermal polymerization inhibitor to the image-recording layer according to the invention in order to inhibit undesirable thermal polymerization of the polymerizable monomer (D) during the production or preservation of the image-recording layer.

Preferable examples of the thermal polymerization inhibitor include hydroquinone, p-methoxyphenol, di-tert-butyl-p-cresol, pyrogallol, tert-butyl catechol, benzoquinone, 4,4'-thiobis(3-methyl-6-tert-butylphenol), 2,2'-methylenebis(4-methyl-6-tert-butylphenol) and N-nitroso-N-phenylhydroxylamine aluminum salt. The amount of the thermal polymerization inhibitor added is preferably from about 0.01 to about 5% by mass based on the total solid content of the image-recording layer.

### <7> Higher fatty acid derivative or the like

To the image-recording layer according to the invention, a higher fatty acid derivative or the like such as behenic acid or behenic acid amide may be added and localized on the surface of the image-recording layer during a drying step after coating to thereby avoid polymerization inhibition due to oxygen. The amount of the higher fatty acid derivative added is preferably from about 0.1 to about 10% by mass based on the total solid content of the image-recording layer.

### <8> Plasticizer

The image-recording layer according to the invention may contain a plasticizer to improve the on-machine developability.

Preferable examples of the plasticizer include a phthalic acid ester such as dimethyl phthalate, diethyl phthalate, dibutyl phthalate, diisobutyl phthalate, dioctyl phthalate, octylcapryl phthalate, dicyclohexyl phthalate, ditridecyl phthalate, butylbenzyl phthalate, diisodecyl phthalate or diallyl phthalate; a glycol ester such as dimethyl glycol phthalate, ehtylphtalylethyl glycolate, methylphthalylethyl glycolate, butylphthalylbutyl glycolate or triethylene glycol dicaprylate ester; a phosphoric acid ester such as tricresyl phosphate or triphenyl phosphate; an aliphatic dibasic acid ester such as diisobutyl adipate, dioctyl adipate, dimethyl sebacate, dibutyl sebacate, dioctyl azelate or dibutylmateate; polyglycidyl methacrylate, triethyl citrate, glycerol triacetyl ester and butyl laurate.

The content of the plasticizer is preferably about 30% by mass or less based on the total solid content of the image-recording layer.

### <9> Inorganic microparticle

The image-recording layer according to the invention may contain inorganic microparticles in order to increase the strength of the hardened film improve the on-machine developability.

Preferable examples of the inorganic microparticles include silica, alumina, magnesium oxide, titanium oxide, magnesium carbonate, calcium alginate and a mixture thereof. The inorganic microparticles can be used, for example, for strengthening the film or enhancing the interface adhesion property due to surface roughening.

The inorganic microparticles preferably have an average particle size from 5 nm to 10 µm, more preferably from 0.5 to 3 µm. Within the above-described range, the inorganic microparticles can be stably dispersed in the image-recording layer, maintain a sufficient film strength of the image-recording layer and form the non-image area that is excellent in hydrophilicity and suffers from little stain during printing.

The inorganic microparticles described above are easily available as a commercial product, for example, a colloidal silica dispersion.

The content of the inorganic microparticles is preferably 40% by mass or less and more preferably 30% by mass or less based on the total solid content of the image-recording layer.

### <10> Hydrophilic low molecular weight compound

The image-recording layer according to the invention may contain a hydrophilic low molecular weight compound in order to improve the on-machine developability. The hydrophilic low molecular weight compound includes a water soluble organic compound, for example, a glycol such as ethylene glycol, diethylene glycol, triethylene glycol, propylene glycol, dipropylene glycol or tripropylene glycol, or an ether or ester derivative thereof, a polyhydroxy compound such as glycerol or pentaerythritol, an organic amine compound such as triethanolamine, diethanolamine or monoethanolamine, or a salt thereof, an organic sulfonic acid compound such as toluene sulfonic acid or benzenesulfonic acid, or a salt thereof, an organic sulfamic acid such as an alkylsulfamic acid, or a salt thereof, an organic sulfuric acid such as an alkylsulfuric acid or an alkyl ether sulfuric acid or a salt thereof, an organic phosphonic acid such as phenylphosphonic acid or a salt thereof, an organic carboxylic acid such as tartaric acid, oxalic acid, citric acid, malic acid, lactic acid, gluconic acid or an amino acid, or a salt thereof.

Among these hydrophilic low molecular weight compounds, an organic sulfonic acid, an organic sulfamic acid, or sodium salt or lithium an organic sulufric acid sodium salt are preferably usable. By adding such a compound to the image-recording layer, the on-machine developability can be improved without lowering the printing tolerance.

Specific examples of the organic sulfonic acid salt include sodium normal-butylsulfonate, sodium isobutylsulfonate, sodium sec-butylsulfonate, sodium tert-butylsulfonate, sodium normal-pentylsulfonate, sodium 1-ethylpropylsulfonate, sodium normal-hexylsulfonate, sodium 1,2-dimethylpropylsulfonate, sodium 2-ethylbutylsulfonate, sodium cyclohexylsulfonate, sodium normal-heptylsulfonate, sodium normal-octylsulfonate, sodium tert-octylsulfonate, sodium normal-nonylsulfonate, sodium allylsulfonate, sodium 2-methylallylsulfonate, sodium benzenesulfonate, sodium p-toluenesulfonate, sodium p-hydroxybenzenesulfonate, sodium p-styrenesulfonate, sodium dimethyl isophthalate-5-sulfonate, disodium 1,3-benzenedisulfonate, trisodium 1,3,5-benzenetrisulfonate, sodium p-chlorobenzenesulfonate, sodium 3,4-dichlorobenzenesulfonate, sodium 1-naphthylsulfonate, sodium 2-naphthylsulfonate, sodium 4-hydroxynaphthylsulfonate, disodium 1,5-naphthyldisulfonate, disodium 2,6-naphthyldisulfonate, trisodium 1,3,6-naphthyltrisulfonate and salts containing lithium as a substitute for sodium in the above-described salts.

Specific examples of the organic sulfamic acid include sodium normal-butylsulfamate, sodium isobutylsulfamate, sodium tert-butylsulfamate, sodium normal-pentylsulfamate, sodium 1-ethylpropylsulfamate, sodium normal-hexylsulfamate, sodium 1,2-dimethylpropylsulfamate, sodium 2-ethylbutylsulfamate, sodium cyclohexylsulfamate and salts containing lithium as a substitute for sodium in the above-described salts.

Because of having a small hydrophobic moiety structure and showing little surfactant effect, these compounds are clearly distinguishable from the above-described surfactants including long-chain alkylsulfonic acid salts and long-chain alkylbenzenesulfonic acid salts as preferable examples thereof.

As the organic sulfuric acid salt, use can be particularly preferably made of a compound represented by the following formula (VI).

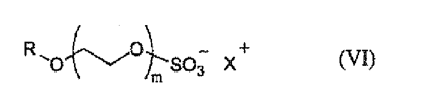

In the above formula (VI), R represents a substituted or unsubstituted alkyl group, alkenyl group, alkynyl group, aryl group or heterocyclic group; m is an integer of from 1 to 4; and X represents sodium, potassium or lithium.

It is preferable that R represents a substituted or unsubstituted, straight-chain, branched or cyclic alkyl group having 1 to 12 carbon atoms, an alkenyl group having 1 to 12 carbon atoms, an alkynyl group having 1 to 12 carbon atoms or an aryl group having not more than 20 carbon atoms. Examples of the substituent include a straight-chain, branched or cyclic alkyl group having 1 to 12 carbon atoms, an alkenyl group having 1 to 12 carbon atoms, an alkynyl group having 1 to 12 carbon atoms, a halogen atom or an aryl group having not more than 20 carbon atoms.

Preferable examples of the compound represented by the formula (VI) include sodium oxyethylene-2-ethylhexyl ether sulfate, sodium dioxyethylene-2-ethylhexyl ether sulfate, potassium dioxyethylene-2-ethylhexyl ether sulfate, lithium dioxyethylene-2-ethylhexyl ether sulfate, sodium trioxyethylene-2-ethylhexyl ether sulfate, sodium tetraoxyethylene-2-ethylhexyl ether sulfate, sodium dioxyethylene hexyl ether sulfate, sodium dioxyethylene octyl ether sulfate and sodium dioxyethylene lauryl ether sulfate. As the most preferable compounds, there can be enumerated sodium dioxyethylene-2-ethylhexyl ether sulfate, potassium dioxyethylene-2-ethylhexyl ether sulfate and lithium dioxyethylene-2-ethylhexyl ether sulfate.

The content of the hydrophilic low molecular weight compound in the image-recording layer is preferably 0.5% by mass or more but not more than 20% by mass, more preferably 1% by mass or more but not more than 10% by mass and still more preferably 2% by mass or more but not more than 8% by mass based on the total solid content of the image-recording layer. Within the above-described range, a good on-machine developability and printing durability can be established.

Either one of these hydrophilic low molecular weight compounds or a mixture of two or more kinds thereof may be used.

### <11> Oil sensitizer

In the invention, a phosphonium compound may be added, together with the specific polymer compound according to the invention, in order to improve the ink deposition properties. The phosphonium compound acts as a surface coating agent (oil sensitizer) for the inorganic stratiform compound and prevents a decrease in ink deposition properties that is caused by the inorganic stratiform compound in the course of printing. As appropriate examples of the phosphonium compound, a phosphonium compound described in JP-A-2006-297907 and a compound represented by the following formula (VII) can be cited.

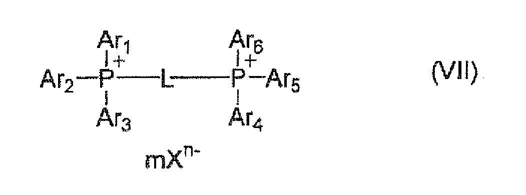

In the formula (VII),Ar₁ to Ar₆ each independently represents an aryl group or a heterocyclic group; L represents a divalent linking group; Xⁿ⁻ represents an n-valent counter anion; n represents an integer of from 1 to 3; and m represents a number satisfying n × m = 2.

Appropriate examples of the aryl group include a phenyl group, a naphthyl group, a tolyl group, a xylyl group, a fluorophenyl group, a chlorophenyl group, a bromophenyl group, a methoxyphenyl group, an ethoxyphenyl group, a dimethoxyphenyl group, a methoxycarbonylphenyl group and a dimethylaminophenyl group. Examples of the heterocyclic group include a pyridyl group, a quinolyl group, a pirimidinyl group, a thienyl group and a furyl group. L is preferably a linking group having from 6 to 15 carbon atoms, and more preferably a linking group having from 6 to 12 carbon atoms.

Preferable examples of the counter anion represented by Xⁿ⁻ include a halogen anion such as Cl⁻, Br⁻ or I⁻, a sulfonate anion, a carboxylate anion, a sulfate anion, PF₆⁻, BF₄⁻ and a perchlorate anion. Among them, a halogen anion such as Cl⁻, Br⁻ or I⁻, a sulfonate anion or a carboxylate anion is particularly preferable.

Next, specific examples of the phosphonium compound represented by the formula (VII) will be presented.

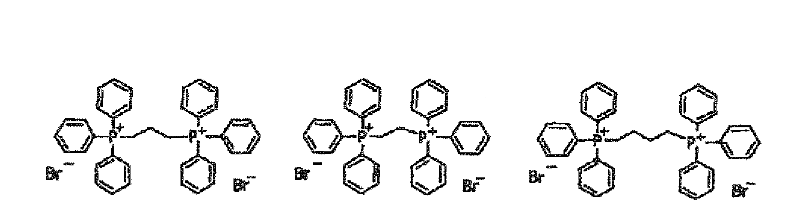

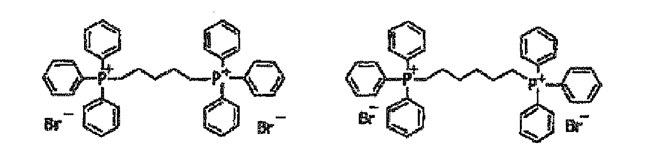

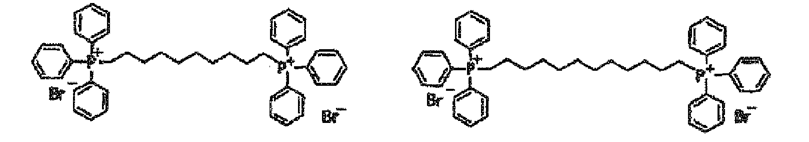

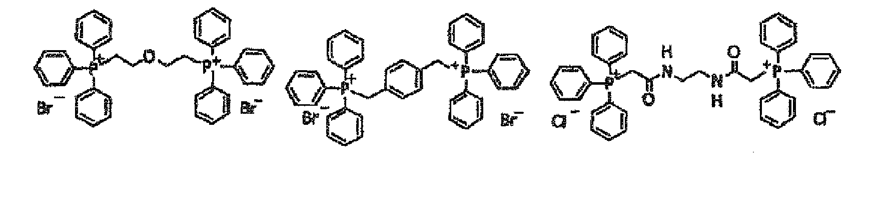

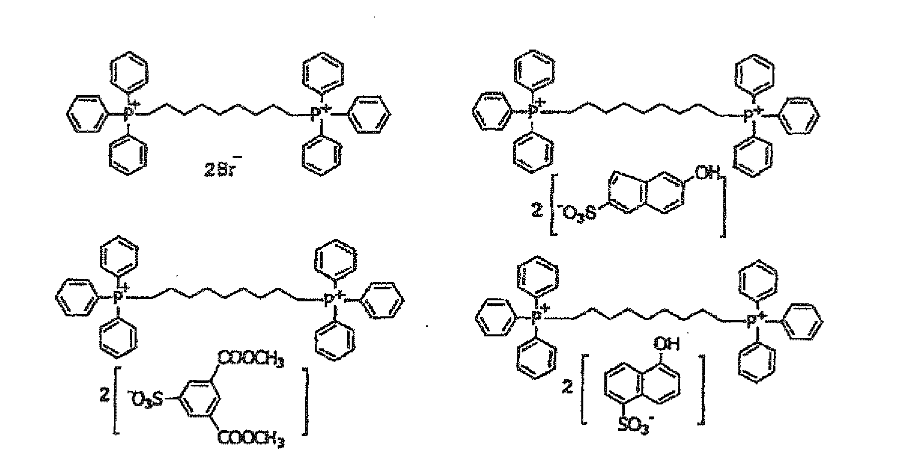

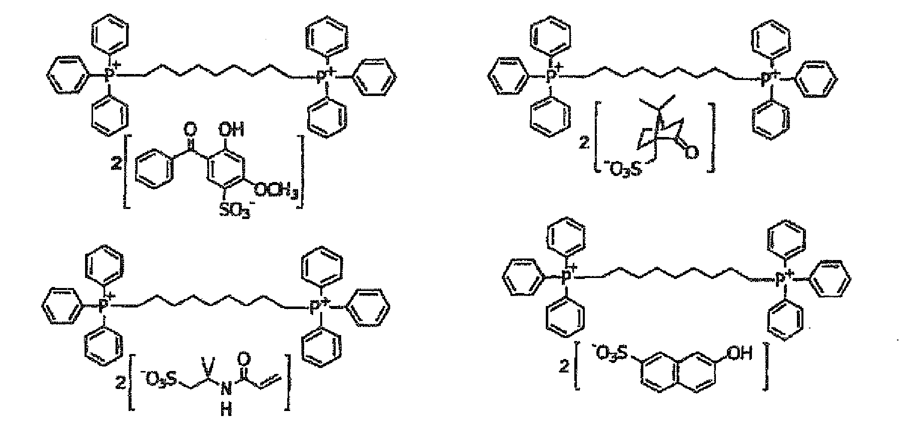

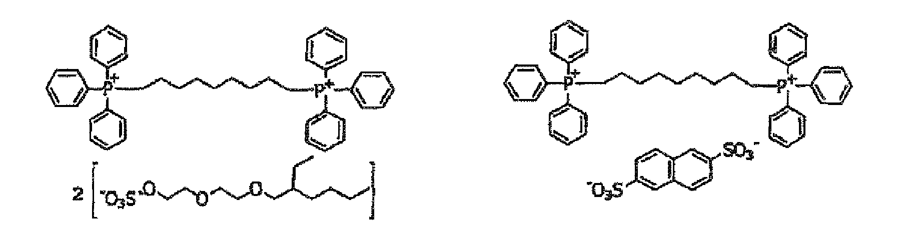

The content of the phosphonium compound in the image-recording layer is preferably 0.01% by mass or more but not more than 20% by mass, more preferably 0.05% by mass or more but not more than 10% by mass and still more preferably 0.1% by mass or more but not more than 5% by mass based on the total solid content of the image-recording layer. Within the above-described range, good ink deposition properties can be established in the course of printing.

The oil sensitizer may be added not only to the image-recording layer but also to the protective layer.

### <12> Cosensitizer

The image-recording layer of the invention may also comprise a known compound called a cosensitizer or a chain transfer agent which has a function of further improving the sensitivity or suppressing polymerization inhibition by oxygen. In the case of a lithographic printing plate precursor for blue laser light that should be highly sensitive, it is rpeferable to employ a cosensitizer.

Examples of such a compound include amines, for example, compounds described in M. R. Sander et al., Journal of Polymer Society, Vol. 10, p. 3173 (1972), JP-B-44-20189, JP-A-51-82102, JP-A-52-134692, JP-A-59-138205, JP-A-60-84305, JP-A-62-18537, JP-A-64-33104 and Research Disclosure No. 33825, and specific examples thereof include triethanolamine, ethyl p-dimethylaminobenzoate, p-formyldimethylaniline, and p-methylthiodimethylaniline.

Other examples of the above compound serving as a chain transfer agent include compounds having SH, PH, SiH or GeH in molecule. Such a compound donates hydrogen to a low active radical species to form a radical or, after being oxidized, undergoes deprotonation to form a radical.

As the chain tranfer agent in the image-recording layer of the invention, use can be preferably made of a thiol compound (for example, 2-mercaptobenzimidazole, 2-mercaptobenzothiazole, 2-mercaptobenzoxazole, 3-mercaptotriazole and 5-mercaptotetrazole).

Among all, it is particularly preferable to use a thion compound represented by the following formula (VIII) which is disclosed in JP-A-2006-091479. By using this thiol compound as a chain transfer agent, a problematic odor and a decrease in sensitivity caused by evaporation from the image-recording layer or diffusion into other layer(s) can be avoided and, as a result, a lithographic printing plate precursor which is excellent in storage stability and has a high sensitivity and good printing durability can be obtained.

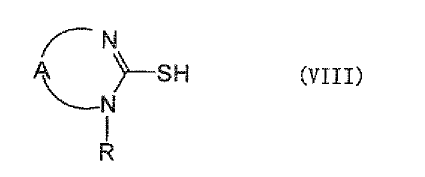

In the formula (VIII), R represents an alkyl group which may have a sustituent or an aryl group which may have a sustituent; and A represents an atomic group forming a 5- or 6-membered ring having carbon atom(s) together with the N=C-N moiety and A may have a further substituent.

More preferably, use may be made of a thiol compound represented by the following formula (VIIIA) or formula (VIIIB).

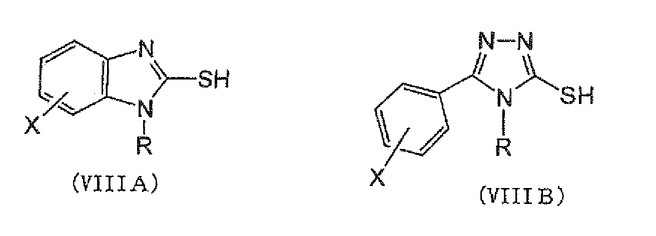

In the general formulae (VIIIA) and (VIIIB), R represents an alkyl group which may have a sustituent or an aryl group which may have a sustituent; and X represents a halogen atom, an alkoxyl group, an alkyl group which may have a sustituent or an aryl group which may have a sustituent.

Specific examples of the thiol compound include 1-methyl-2-mercaptobenzoimidazole, 1-propyl-2-mercaptobenzoimidazole, 1-hexyl-2-mercaptobenzoimidazole, 1-hexyl-2-mercapto-5-chlorobenzoimidazole, 1-pentyl-2-mereaptobenzoimidazole, 1-octyl-2-mercaptobenzoimidazole, 1-octyl-2-mercapto-5-methoxybenzoimidazole, 1-cyclohexyl-2-mercaptobenzoimidazole, 1-phenyl-2-mercaptobenzoimidazole, 1-phenyl-2-mercapto-5-methylsulfonylbenzoimidazole, 1-(p-tolyl)-2-mercaptobenzoimidazole, 1-methoxyethyl-2-mercaptobenzoimidazole, 1-butyl-2-mercaptonaphthoimidazole, 1-methyl-2-mercapto-5-phenyl-1,3,5-triazole, 1-butyl-2-mercapto-5-phenyl-1,3,5-triazole, 1-heptyl-2-mercapto-5-phenyl-1,3,5-triazole, 1-phenyl-2-mercapto-5-phenyl-1,3,5-triazole, 1-benyl-2-mercapto-5-phenyl-1,3,5-triazole, 1-phenethyl-2-mercapto-5-phenyl-1,3,5-triazole, 1-cyclohexyl-2-mercapto-5-phenyl-1,3,5-triazole, 1-phenethyl-2-mercapto-5-(3-fluorophenyl)-1,3,5-triazole; 1-phenethyl-2-mercapto-5-(3-trifluoromethylphenyl)-1,3,5-triazole, 1-benzyl-2-mercapto-5-(p-tolyl)-1,3,5-triazole, 1-benzyl-2-mercapto-5-(4-methoxyphenyl)-1,3,5-triazole, 1-benzyl-2-mercapto-5-(p-trifluoromethylphenyl)-1,3,5-triazole, 1-benzyl-2-mercapto-5-(3,5-dichlorophenyl)-1,3,5-triazole, 1-phenyl-2-mercapto-5-(p-tolyl)-1,3,5-triazole, 1-phenyl-2-mercapto-5-(4-methoxyphenyl)-1,3,5-triazole, 1-(1-naphthyl)-2-mercapto-5-phenyl-1,3,5-triazole, 1-(4-bromophenyl)-2-mercapto-5-phenyl-1,3,5-triazole and 1-(4-trifluorophenyl)-2-mercapto-5-phenyl-1,3,5-triazole.

The content of the cosensitizer is preferably 0.01 to 20% by mass, more preferably 0.3 to 15% by mass and still more preferably 1.0 to 10% by mass based on the total solid content of the image-recording layer.

### <Formation of image-recording layer>

The image-recording layer according to the invention is formed by dispersing or dissolving each of the necessary constituting components described above in a solvent to prepare a coating solution and then coating the solution. The solvent used include, for example, ethylene dichloride, cyclohexanone, methyl ethyl ketone, methanol, ethanol, propanol, ethylene glycol monomethyl ether, 1-methoxy-2-propanol, 2-methoxyethyl acetate, I -methoxy-2-propyl acetate, dimethoxyethane, methyl lactate, ethyl lactate, N,N-dimethylacetamide, N,N-dimethylformamide, tetramethylurea, N-methylpyrrolidone, dimethyl sulfoxide, sulfolane, γ-butyrolactone, toluene and water, but the invention should not be construed as being limited thereto. Either one of these solvents or a mixture thereof may be used. The solid content concentration of the coating solution is preferably from 1 to 50% by mass.

The image-recording layer of the invention may also be formed by preparing plural coating solutions by dispersing or dissolving the same or different components described above into the same or different solvents and conducting repeatedly the coating and drying plural times.

The coating amount of the image-recording layer (solid content) formed on a support after drying may be varied according to the intended purpose but is preferably from 0.3 to 3.0 g/m². Within the above-described range, a good sensitivity and good film characteristics of the image-recording layer can be achieved.

Various methods can be used for the coating. Examples of the coating method include bar coater coating, spin coating, spray coating, curtain coating, dip coating, air knife coating, blade coating and roll coating.

### <Protective layer>

The lithographic printing plate precursor of the invention has a protective layer (overcoat layer) on the image-recording layer. The protective layer suppresses a reaction inhibiting image formation by blocking oxygen and, moreover, prevents the image-recording layer from scratch formation, and prevents abrasion which might occur at high-illuminance laser exposure. Next, components of the protective layer will be illustrated.

In general, a lithographic printing plate is exposed in the atmosphere. The image-forming reaction of the image-recording layer, which is induced by the exposure, might be inhibited by low-molecular weight compounds such as oxygen and basic substances in the atmosphere. The protective layer prevents the image-recording layer from contamination with these low-molecular weight compounds such as oxygen and basic substances and, in its turn, suppresses a reaction inhibiting image formation in the atmosphere. Accordingly, it is required that the protective layer has a low transmission rate of low-molecular weight compounds such as oxygen but does not substantially inhibit the transmission of light to be used in exposure, shows an excellent adhesion to the image-recording layer and can be easily removed in the on-machine development step after the exposure. Various studies have been made on such a protective layer as having these properties and reported by, for example, USP No. 3,458,311 and JP-B-55-49729.

The protective layer of the invention contains a stratiform compound. The stratiform compound comprises particles having a thin plate shape and can block oxygen in a thin layer by gas barrier properties of regulating the pathway length of gas diffusion. As the stratiform compound, an inorganic compound is preferred. Examples thereof include mica such as natural mica represented by the following formula:

A (B, C)₂₋₅ D₄ O₁₀ (OH, F, O)₂

[wherein A represents any one of Li, K, Na, Ca, Mg and an organic cation; B and C each represents any one of Fe (II), Fe(III), Mn, Al, Mg and V; and D represents Si or Al] or synthetic mica; talc represented by the following formula: 3MgO·4SiO·H₂O; teniolite; montmorillonit; saponite; hectolite; and zirconium phosphate.

Examples of the above-described natural mica include muscovite, paragonite, phlogopite, biotite and lepidolite. Examples of the synthetic mica include non-swellable mica, for example, fluorine phlogopite KMg₃(AlSi₃O₁₀)F₂ or potassium tetrasilic mica KMg_{2.5}(Si₄O₁₀)F₂, and swellable mica, for example, Na tetrasililic mica NaMg_{2.5}(Si₄O₁₀)F₂, Na or Li teniolite (Na, Li)Mg₂Li(Si₄O₁₀)F₂, or montmorillonit based Na or Li hectolite (Na, Li)_{1/8}Mg_{2/5}Li_{1/8}(Si₄O₁₀)F₂. Synthetic smectite is also useful.

Among the stratiform compounds as described above, fluorine based swellable mica, which is a synthetic stratiform compound, is particularly useful. Specifically, the swellable synthetic mica and an swellable clay mineral, for example, montmorillonit, saponite, hectoliter or bentonite have a stratiform structure comprising a unit crystal lattice layer having thickness of approximately 10 to 15 angstroms and metallic atom substitution in the lattices is extremely large in comparison with other clay minerals. As a result, the lattice layer results in lack of positive charge and to compensate it, cations, for example, Li⁺, Na⁺, Ca²⁺ or Mg²⁺, or organic cations of an amine base, a quaternary ammonium salt, a phosphonium salt or a sulfonium salt are adsorbed between the lattice layers. The stratiform compound swells with water. When share is applied under such condition, the stratiform crystal lattices are easily cleaved to form a stable sol in water. Bentonite and swellable synthetic mica strongly show the above tendency.

With respect to the shape of the stratiform compound, the thinner the thickness or the larger the plate size are preferred from the standpoint of diffusion control, so long as smoothness of coated surface and transmission of active ray are not damaged. Therefore, an aspect ratio of the stratiform compound is ordinarily 20 or more, preferably 100 or more, and particularly preferably 200 or more. The aspect ratio means a ratio of thickness to major axis of a particle and can be determined, for example, from a projection drawing of particle by a microphotography. The larger the aspect ratio brings about the greater the effect.

As for the particle size of the stratiform compound, an average major particle size is ordinarily from 0.3 to 20 µm, preferably from 0.5 to 10 µm, and particularly preferably from 1 to 5 µm. When the particle size is less than 0.3 µm, the inhibition of permeation of oxygen or water is insufficient and the effect of the invention can not be satisfactorily achieved. On the other hand, when it is larger than 20 µm, the dispersion stability of the particles in the coating solution becomes insufficient and thus results in a problem that stable coating can not be performed. An average thickness of the particles is ordinarily 0.1 µm or less, preferably 0.05 µm or less, and particularly preferably 0.01 µm or less. For example, with respect to the swellable synthetic mica that is the representative compound of the stratiform compounds, the thickness is approximately from about 1 to about 50 nm and the plain size is approximately from about 1 to about 20 µm.

By incorporating particles of the stratiform compound having such a large aspect ratio into the protective layer, strength of the coated layer increases and the penetration of oxygen or water can be effectively inhibited, thereby preventing degradation of the protective layer due to deformation. Also, even when the lithographic printing plate precursor is stored under a high humidity condition for a long period of time, degradation of the image-forming properties of the lithographic printing plate precursor due to the variation of humidity is prevented and the excellent storage stability is obtained.

Next, an example of common dispersing methods of the stratiform compound used in the protective layer will be described below. Specifically, at first, from 5 to 10 parts by mass of a swellable stratiform compound that is exemplified as a preferred stratiform compound is added to 100 parts by mass of water. After allowing the compound to adapt thoroughly to water and to be swollen, the mixture is dispersed using a dispersing machine. Examples of the dispersing machine used include a variety of mills conducting dispersion by directly applying mechanical power, a high-speed agitation type dispersing machine providing a large shear force and a dispersing machine providing ultrasonic energy of high intensity. Specific examples thereof include a ball mill, a sand grinder mill, a visco mill, a colloid mill, a homogenizer, a dissolver, a Polytron, a homomixer, a homoblender, a Keddy mill, a jet agitor, a capillary emulsifying device, a liquid siren, an electromagnetic strain type ultrasonic generator and an emulsifying device having a Polman whistle. The dispersion containing 5 to 10% by mass of the stratiform compound thus prepared, which is highly viscous or in the form of a gel, exhibits extremely good storage stability. In the preparation of a coating solution for protective layer using the dispersion, it is preferred that the dispersion is diluted with water, thoroughly stirred and then blended with a binder solution.

The content of the inorganic stratiform compound in the protective layer is preferably from 5/1 to 1/100 expressed in ratio by mass to the binder employed in the protective layer. In the case of using multiple kinds of stratiform compounds, it is also preferred that the total amount of these inorganic stratiform compounds falls within the mass ratio range as described above.

The inorganic stratiform compound may be added not only to the protective layer but also to the image-recording layer. Addition of the inorganic stratiform compound to the image-recording layer is useful in improving printing durability, polymerization efficiency (sensitivity) and temporal stability.

The content of the inorganic stratiform compound in the image-recording layer is preferably form 0.1 to 50% by mass, more preferably from 0.3 to 30% by mass and most preferably from 1 to 10% by mass based on the solid matters in the image-recording layer.

As the binder to be used in the protective layer, any water-soluble polymer and water-insoluble polymer can be appropriately selected to use. Specific examples of the binder include a water-soluble polymer such as polyvinyl alcohol, modified polyvinyl alcohol, polyvinyl pyrrolidone, polyvinyl imidazole, polyacrylic acid, polyacrylamide, partially saponified product of polyvinyl acetate, an ethylene-vinyl alcohol copolymer, a water-soluble cellulose derivative, gelatin, a starch derivative or gum arabic; and a polymer such as polyvinylidene chloride, poly(meth)acrylonitrile, polysulfone, polyvinyl chloride, polyethylene, polycarbonate, polystyrene, polyamide or cellophane. The polymers may be used in combination of two or more thereof, if desired.

Among the above-described polymers, a water-soluble polymer compound having a high crystallinity is relatively useful. Preferable examples thereof include polyvinyl alcohol, polyvinyl pyrrolidone, polyvinyl imidazole, a water-soluble acrylic resin such as polyacrylic acid, gelatin or gum arabic. From the standpoint of capability of coating with the use of water as a solvent and easiness of removal with dampening water at printing, polyvinyl alcohol, polyvinyl pyrrolidone and polyvinylimidazole are more preferably used. Among all, polyvinyl alcohol (PVA) can provide the most favorable results concerning fundamental characteristics including oxygen barrier properties, developability and removability.

The polyvinyl alcohol to be used in the protective layer may be partially substituted with ester, ether and acetal so long as it contains a substantial amount of unsubstituted vinyl alcohol units necessary for maintaining water solubility. Also, the polyvinyl alcohol may partially contain other copolymerizable components. For instance, polyvinyl alcohols of various polymerization degrees having at random a various kind of hydrophilic modified cites, for example, an anion-modified cite modified with an anion such as a carboxy group or a sulfo group, a cation-modified cite modified with a cation such as an amino group or an ammonium group, a silanol-modified cite or a thiol-modified cite, and polyvinyl alcohols of various polymerization degrees having at the terminal of the polymer having a various kind of modified cites, for example, the above-described anion-modified cite, cation modified cite, silanol-modified cite or thiol-modified cite, an alkoxy-modified cite, a sulfide-modified cite, an ester modified cite of vinyl alcohol with a various kind of organic acids, an ester modified cite of the above-described anion-modified cite with an alcohol or an epoxy-modified cite are also preferably used.

As such a polyvinyl alcohol, use can be preferably made of a compound having been hydrolyzed to an extent of 71 to 100% by mol and having a degree of polymerization of 300 to 2400. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 all produced by Kuraray Co., Ltd. Specific examples of the modified Polyvinyl alcohol include that having an anion-modified cite such as KL-318, KL-118, KM-618, KM-118 or SK-5102; that having a cation-modified cite such as C-318, C-118 8 or CM-318; that having a terminal thiol-modified cite such as M-205 or M-115; that having a terminal sulfide-modified cite such as MP-103, MP-203, MP-102 or MP-202; that having an ester-modified cite with a higher fatty acid at the terminal such as HL-12E or HL-1203; and that having a reactive silane-modified cite, for example, R-1130, R-2105 or R-2130.

With respect to other additives for the protective layer, glycerol, dipropylene glycol, etc. can be added to the water-soluble or water-insoluble polymer in an amount corresponding to several % by mass to thereby impart flexibility. Further, an anionic surfactant such as a sodium alkyl sulfate or a sodium alkyl sulfonate; an amphoteric surfactant such as an alkylamino carboxylic acid salt or an alkylamino dicarboxylic acid salt; or a non-ionic surfactant such as a polyoxyethylene alkylphenyl ether can be added. These surfactants can be added in an amount of 0.1 to 100% by mass based on the water-soluble or water-insoluble polymer as described above.

To improve the adhesion to the image-recording layer, it has been reported by, for example, JP-A-49-70702 and British Patent Laid-Open No.1303578 that sufficient adhesion can be obtained by mixing from 20 to 60% by mass of an acrylic emulsion, a water-insoluble vinyl pyrrolidone-vinyl acetate copolymer or the like in a hydrophilic polymer mainly comprising polyvinyl alcohol and coating the mixture on the image-recording layer. In the invention, any of such known techniques can be used.

Further, other functions can also be provided to the protective layer. For example, by adding a coloring agent (for example, a water-soluble dye), which is excellent in permeability for infrared ray used for the exposure and capable of efficiently absorbing light at other wavelengths, a safe light adaptability can be improved without decreasing the sensitivity.

The protective layer is formed by dispersing or dissolving the above-described components for protective layer in a solvent to prepare a coating solution for protective layer and then coating the solution on the image-recording layer followed by drying. The solvent can be appropriately selected depending on the binder. In the case of using a water-soluble polymer, it is preferable to use distilled water or purified water.

The coating solution for protective layer can contain a publicly known additive, for example, an anionic surfactant, a nonionic surfactant, a cationic surfactant or a fluorine-based surfactant for improving the coating properties, or a water-soluble plasticizer for improving the film properties. As the water-soluble plasticizer, it is possible to add, for example, propionamide, cyclohexanediol, glycerol or sorbitol. Also, a water-soluble (meth)acrylic polymer can be added. The coating solution may further contain a publicly known additive for improving the adhesion to the image-recording layer or improving the temporal stability of the coating solution.

The coating method for forming the protective layer is not particularly restricted and any publicly known method reported by, for example, USP No. 3,458,311 and JP-B-55-49729 may be used therefor. Specific examples of the method include the blade coating method, the air knife coating method, the gravure coating method, the roll coating method, the spray coating method, the dip coating method and the bar coating method.

The coating amount of the protective layer expressed in dry coating amount is preferably from 0.01 to 10 g/m², more preferably from 0.02 to 3 g/m² and most preferably from 0.02 to 1 g/m².

### <Support>

A support for use in the lithographic printing plate precursor according to the invention is not particularly restricted so long as it is a dimensionally stable plate-like material. Examples of the support include paper, paper laminated with plastic (for example, polyethylene, polypropylene or polystyrene), a metal plate (for example, aluminum, zinc or copper plate), a plastic film (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal film) and paper or a plastic film laminated or deposited with the metal described above. A preferred support includes a polyester film and an aluminum plate. Among them, the aluminum plate is preferred since it has a good dimensional stability and is relatively inexpensive.

The aluminum plate includes a pure aluminum plate, an alloy plate comprising aluminum as the main component together with a trace amount of a hetero element and a thin film of aluminum or aluminum alloy laminated with plastic. Examples of the hetero element contained in the aluminum alloy include silicon, iron, manganese, copper, magnesium, chromium, zinc, bismuth, nickel and titanium. The content of the hetero element in the aluminum alloy is preferably 10% by mass or less. Although a pure aluminum plate is preferred in the invention, it is difficult to produce a completely pure aluminum in view of the refining technique. Thus, the aluminum plate may slightly contain the hetero element. The composition of the aluminum plate is not specified and use can be appropriately made of materials that have been conventionally known and used.

The thickness of the support is preferably from 0.1 to 0.6 mm, more preferably from 0.15 to 0.4 mm.

Before using the aluminum plate, it is preferable to conduct a surface treatment such as a roughening treatment or an anodizing treatment. The surface treatment facilitates improvement in the hydrophilic property and ensures the adhesion between the image-recording layer and the support. Prior to the roughening treatment of the aluminum plate, a degreasing treatment is conducted by using, for example, a surfactant, an organic solvent or an aqueous alkaline solution for removing rolling oil on the surface thereof, if desired.

The roughening treatment of the surface of the aluminum plate may be conducted by various methods and examples thereof include a mechanical roughening treatment, an electrochemical roughening treatment (roughening treatment of electrochemically dissolving the surface) and a chemical roughening treatment (roughening treatment of chemically dissolving the surface selectively).

As the method of the mechanical roughening treatment, use can be made of a known method such as ball graining, brush graining, blast graining or buff graining. It is also possible to employ a transfer method wherein a roll having concavo-convex shape is used and the concavo-convex shape is transferred to the surface of aluminum plate during a rolling step of aluminum plate.

As examples of the electrochemical roughening treatment method, there can be enumerated a method of conducting by passing an alternating current or a direct current in an electrolyte containing an acid such as hydrochloric acid or nitric acid; and a method of using a mixed acid as described in JP-A-54-63902.

The surface-roughened aluminum plate is subjected, if desired, to an alkali etching treatment using an aqueous solution such as a potassium hydroxide or sodium hydroxide solution and further subjected to a neutralizing treatment, followed by an anodizing treatment for improving the abrasion resistance, if desired.

As the electrolyte to be used for the anodizing treatment of the aluminum plate, use can be made of various electrolytes capable of forming a porous oxide film. Ordinarily, sulfuric acid, hydrochloric acid, oxalic acid, chromic acid or a mixed acid thereof is used. The concentration of the electrolyte can be appropriately determined depending on the kind of the electrolyte.

The conditions for the anodizing treatment vary depending on the electrolyte used and, therefore, cannot be defined commonly. However, it is ordinarily preferred that the electrolyte concentration in the solution is from 1 to 80% by mass, the liquid temperature is from 5 to 70°C, the current density is from 5 to 60 A/dm², the voltage is from 1 to 100 V, and the electrolysis time is from 10 seconds to 5 minutes. The amount of the anodized film formed is preferably from 1.0 to 5.0 g/m², more preferably from 1.5 to 4.0 g/m². Within the above-described range, a good printing durability and a good scratch resistance in the non-image area of the lithographic printing plate can be achieved.

The aluminum plate, which has been subjected to the surface treatment and has the anodized film, may be used as such as the support in the invention. However, in order to further improve the adhesion property to the upper layer, the hydrophilicity, the stain resistance, the heat insulating property and so on, it is possible to conduct other treatment(s) appropriately selected from among, for example, a treatment for enlarging micropores or a sealing treatment of micropores of the anodized film as described in JP-A-2001-253181 and JP-A-2001-322365, a surface hydrophilizing treatment by immersing in an aqueous solution containing a hydrophilic compound, if desired. Needless to say, the enlarging treatment and sealing treatment are not limited to those described in the above patents and any conventionally known method may be employed therefor. For example, as the sealing treatment, use can be also made of a sealing treatment with steam, a sealing treatment with fluorozirconic acid alone, a sealing treatment with sodium fluoride or a sealing treatment with steam containing lithium chloride added thereto.

The sealing treatment to be used in the invention is not particularly limited and conventionally known methods can be employed. Among them, a sealing treatment with an aqueous solution containing an inorganic fluorine compound, a sealing treatment with water vapor and a sealing treatment with hot water are preferred. Next, these sealing treatments will be described in greater detail.

### <1> Sealing treatment with aqueous solution containing inorganic fluorine compound

As the inorganic fluorine compound used in the sealing treatment with an aqueous solution containing an inorganic fluorine compound, a metal fluoride is preferably exemplified.

Specific examples thereof include sodium fluoride, potassium fluoride, calcium fluoride, magnesium fluoride, sodium fluorozirconate, potassium fluorozirconate, sodium fluorotitanate, potassium fluorotitanate, ammonium fluorozirconate, ammonium fluorotitanate, potassium fluorotitanate, fluorozirconic acid, fluorotitanic acid, hexafluorosilicic acid, nickel fluoride, iron fluoride, fluorophosphoric acid and ammonium fluorophosphate. Among them, sodium fluorozirconate, sodium fluorotitanate, fluorozirconic acid and fluorotitanic acid are preferred.

The concentration of the inorganic fluorine compound in the aqueous solution is preferably 0.01% by mass or more, more preferably 0.05% by mass or more, from the viewpoint of satisfactory sealing micropores of the anodized film, and it is preferably 1% by mass or less, more preferably 0.5% by mass or less from the viewpoint of stain resistance.

The aqueous solution containing the inorganic fluorine compound preferably further contains a phosphate compound. When the phosphate compound is contained, the hydrophilicity on the anodized film surface is increased and thus, the on-machine developability and the stain resistance can be improved.

Preferable examples of the phosphate compound include metal phosphates, for example, an alkali metal phosphate or an alkaline earth metal phosphate.

Specific examples of the phosphate compound include zinc phosphate, aluminum phosphate, ammonium phosphate, diammonium hydrogenphosphate, ammonium dihydrogenphosphate, monoammonium phosphate, monopotassium phosphate, monosodium phosphate, potassium dihydrogenphosphate, dipotassium hydrogenphosphate, calcium phosphate, sodium ammonium hydrogenphosphate, magnesium hydrogenphosphate, magnesium phosphate, ferrous phosphate, ferric phosphate, sodium dihydrogenphosphate, sodium phosphate, disodium hydrogenphosphate, lead phosphate, diammonium phosphate, calcium dihydrogenphosphate, lithium phosphate, phosphotungstic acid, ammonium phosphotungstate, sodium phosphotungstate, ammonium phosphomolybdate, sodium phosphomolybdate, sodium phosphite, sodium tripolyphosphate and sodium pyrophosphate. Among them, sodium dihydrogenphosphate, disodium hydrogenphosphate, potassium dihydrogenphosphate and dipotassium hydrogenphosphate are preferred.

Although the combination of the inorganic fluorine compound with the phosphate compound is not particularly limited, it is preferred that the aqueous solution contains at least sodium fluorozirconate as the inorganic fluorine compound and at least sodium dihydrogenphosphate as the phosphate compound.

The concentration of the phosphate compound in the aqueous solution is preferably 0.01 % by mass or more, more preferably 0.1% by mass or more, from the viewpoint of improvement in the on-machine developability and the stain resistance, and it is preferably 20% by mass or less, more preferably 5% by mass or less, from the viewpoint of the solubility.

The ratio of the compounds in the aqueous solution is not particularly limited, and the ratio by mass of the inorganic fluorine compound to the phosphate compound is preferably from 1/200 to 10/1, more preferably from 1/30 to 2/1.

The temperature of the aqueous solution is preferably 20°C or more, more preferably 40°C or more, and it is preferably 100°C or less, more preferably 80°C or less.

The pH of the aqueous solution is preferably I or more, more preferably 2 or more, and it is preferably 11 or less, more preferably 5 or less.

The method of the sealing treatment with the aqueous solution containing the inorganic fluorine compound is not particularly limited, and examples thereof include the dipping method and the spray method. Either one of the treatments may be used once or multiple times, or two or more kinds of the treatments may be used in combination.

In particular, the dipping method is preferred. In the case of performing the treatment using the dipping method, the treating time is preferably one second or more, more preferably 3 seconds or more, and it is preferably 100 seconds or less, more preferably 20 seconds or less.

### <2> Sealing treatment with water vapor

Examples of the sealing treatment with water vapor include a method which comprises continuously or discontinuously contacting the anodized film with water vapor under elevated pressure or normal pressure. The temperature of the water vapor is preferably 80°C or more, more preferably 95°C or more, and it is preferably 105°C or less.

The pressure of the water vapor is preferably in a range from (atmospheric pressure - 50 mmAq) to (atmospheric pressure + 300 mmAq, i.e., from 1.008×10⁵ to 1.043×10⁵ Pa).

The contact time of the water vapor is preferably one second or more, more preferably 3 seconds or more, and it is preferably 100 seconds or less, more preferably 20 seconds or less.

### <3> Sealing treatment with hot water

Examples of the sealing treatment with hot water include a method which comprises dipping the aluminum plate having the anodized film formed thereon in hot water.

The hot water may contain an inorganic salt (for example, a phosphate) or an organic salt. The temperature of the hot water is preferably 80°C or more, more preferably 95°C or more, and it is preferably 100°C or less.

The dipping time of dipping the aluminum plate in hot water is preferably one second or more, more preferably 3 seconds or more, and it is preferably 100 seconds or less, more preferably 20 seconds or less.

The hydrophilizing treatment describe above includes the alkali metal silicate method as described in U.S. Patents 2,714,066, 3,181,461, 3,280,734 and 3,902,734. In this method, the support is subjected to an immersion treatment or an electrolytic treatment in an aqueous solution containing, for example, sodium silicate. In addition, examples of the hydrophilizing treatment method include a method of treating with potassium fluorozirconate as described in JP-B-36-22063 and a method of treating with polyvinylphosphonic acid as described in U.S. Patents 3,276,868, 4,153,461, and 4,689,272.

In the case of using a support having a surface with an insufficient hydrophilicity such as a polyester film as the support in the invention, it is desirable to coat a hydrophilic layer thereon to make the surface sufficiently hydrophilic. Preferable examples of the hydrophilic layer include a hydrophilic layer formed by coating a coating solution containing a colloid of an oxide or hydroxide of at least one element selected from beryllium, magnesium, aluminum, silicon, titanium, boron, germanium, tin, zirconium, iron, vanadium, antimony and a transition metal as described in JP-A-2001-199175; a hydrophilic layer containing an organic hydrophilic matrix obtained by crosslinking or pseudo-crosslinking an organic hydrophilic polymer as described in JP-A-2002-79772; a hydrophilic layer containing an inorganic hydrophilic matrix obtained by sol-gel conversion comprising hydrolysis and condensation reaction of a polyalkoxysilane with titanate, zirconate or aluminate; and a hydrophilic layer comprising an inorganic thin layer having a surface containing a metal oxide. Among them, the hydrophilic layer formed by coating a coating solution containing a colloid of silicon oxide or hydroxide is preferred.

Further, in the case of using, for example, a polyester film as the support in the invention, it is preferred to provide an antistatic layer on the hydrophilic layer side, opposite side to the hydrophilic layer or both sides thereof. When the antistatic layer is provided between the support and the hydrophilic layer, it also contributes to the improvement in the adhesion of the hydrophilic layer to the support. As the antistatic layer, use can be made of a polymer layer having microparticles of metal oxide or a matting agent dispersed therein as described in JP-A-2002-79772.

It is preferable that the support has a center line average roughness of 0.10 to 1.2 µm. Within this range, a good adhesion property to the image-recording layer, a good printing durability and a good stain resistance can be achieved.

### <Backcoat layer>

After conducting the surface treatment on the support or forming an undercoat layer as will be described hereinafter on the support, a backcoat layer can be provided on the back surface of the support, if desired.

Preferable examples of the backcoat layer include a coating layer comprising an organic polymer compound as described in JP-A-5-45885 and a coating layer comprising a metal oxide obtained by hydrolysis and polycondensation of an organic metal compound or an inorganic metal compound as described in JP-A-6-35174. Among them, use can be preferably made of an alkoxy compound of silicon such as Si(OCH₃)₄, Si(OC₂H₅)₄, Si(OC₃H₇)₄ or Si(OC₄H₉)₄, since the starting material thereof is inexpensive and easily available.

### <Undercoat layer>

In the lithographic printing plate precursor according to the invention, an undercoat layer can be provided between the support and the image-recording layer. In the lithographic printing plate precursor of the on-machine development type, it is particularly preferable to provide an undercoat layer. The undercoat layer facilitates the removal of the image-recording layer from the support in the unexposed area and thus contributes to the improvement in the on-machine developability. In the case of using infrared laser exposure, further, the formation of the undercoat layer brings about such a advantage that, since the undercoat layer acts as a heat insulating layer, heat generated upon the exposure does not diffuse into the support and is efficiently utilized so that elevate sensitivity.

Appropriate examples of a compound for the undercoat layer (undercoat compound) include a silane coupling agent having an addition-polymerizable ethylenic double bond reactive group as described in JP-A-10-282679 and a phosphorus compound having an ethylenic double bond reactive group as described in JP-A-2-304441 are preferably exemplified.

As the most preferable compound for undercoat layer, a polymer resin obtained by copolymerizing a monomer having an adsorbing group, a monomer having a hydrophilic group and a monomer having a crosslinkable group can be cited.

The essential component in the polymer resin for undercoating is an adsorbing group to the hydrophilic surface of the support. The presence/absence of the adsorptivity to the hydrophilic surface of the support can be determined, for example, by the following method.

A test compound is dissolved in a highly dissolvable solvent to prepare a coating solution. Next, the coating solution is coated and dried on a support so as to have the coating amount after drying of 30 mg/m². After thoroughly washing the support coated with the test compound using the highly dissolvable solvent, the residual amount of the test compound that has not been removed by the washing is measured to calculate the adsorption amount to the support. For measuring the residual amount, the residual amount of the test compound may be directly determined, or may be calculated by determining the amount of the test compound dissolved in the washing solution. The compound can be quantified by, for example, the X-ray fluorescence spectrometry measurement, the reflection absorption spectrometry measurement or the liquid chromatography measurement. A compound that remains in an amount of 1 mg/m² or more even after conducting the washing treatment described above is referred to as the compound having an adsorptivity to the support.

The adsorbing group to the hydrophilic surface of the support is a functional group capable of forming a chemical bond (for example, an ionic bond, a hydrogen bond, a coordinate bond or a bond with intermolecular force) with a substance (for example, metal or metal oxide) or a functional group (for example, a hydroxy group) existing on the surface of the support. It is preferable that the adsorbing group is an acid group or a cationic group.

The acid group preferably has an acid dissociation constant (pKa) of 7 or less. Examples of the acid group include a phenolic hydroxy group, a carboxyl group, -SO₃H, -OSO₃H, -PO₃H₂, -OPO₃H₂, -CONHSO₂-, -SO₂NHSO₂- and -COCH₂COCH₃. Among them, -OPO₃H₂ and -PO₃H₂ are particularly preferred. The acid group may be in the form of a metal salt.

The cationic group is preferably an onium group. Examples of the onium group include an ammonium group, a phosphonium group, an arsonium group, a stibonium group, an oxonium group, a sulfonium group, a selenonium group, a stannonium group and iodonium group. Among them, an ammonium group, a phosphonium group and a sulfonium group are preferred, an ammonium group and a phosphonium group are more preferred, and an ammonium group is most preferred.

Particularly preferable examples of the monomer having the adsorbing group include compounds represented by the following formula (UI) or (U2):

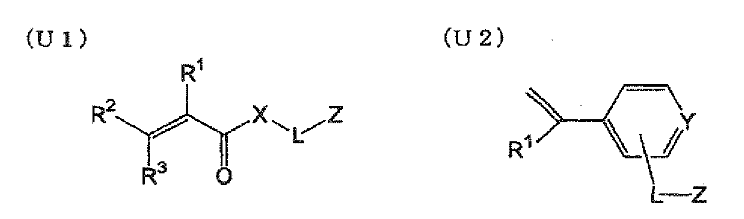

In the above formulae, R¹, R² and R³ each independently represents a hydrogen atom, halogen atom or an alkyl group having from 1 to 6 carbon atoms. It is preferable that R¹, R² and R³ each independently represents a hydrogen atom or an alkyl group having from 1 to 6 carbon atoms, more preferably a hydrogen atom or an alkyl group having from 1 to 3 carbon atoms and most preferably a hydrogen atom or a methyl group. It is particularly preferable that R² and R³ are hydrogen atoms. Z represents a functional group adsorbing to the hydrophilic surface of the support.

In the formula (U1), X represents an oxygen atom (-O-) or an imino group (-NH-). Preferably, X represents an oxygen atom. In the formula (U1), L represents a divalent linking group. It is preferred that L represents a divalent aliphatic group (for example, an alkylene group, a substituted alkylene group, an alkenylene group, a substituted alkenylene group, an alkinylene group or a substituted alkinylene group), a divalent aromatic group (for example, an arylene group or a substituted arylene group), a divalent heterocyclic group or a combination of such a group as described above with an oxygen atom (-O-), a sulfur atom (-S-), an imino group (-NH-), a substituted imino group (-NR-, wherein R represents an aliphatic group, an aromatic group or a heterocyclic group) or a carbonyl group (-CO-).

The aliphatic group may form a cyclic structure or a branched structure. The number of carbon atoms in the aliphatic group is preferably from 1 to 20, more preferably from 1 to 15, and most preferably from 1 to 10. As the aliphatic group, a saturated aliphatic group is preferred to an unsaturated aliphatic group. The aliphatic group may have a substituent. Examples of the substituent include a halogen atom, a hydroxyl group, an aromatic group and a heterocyclic group.

The number of carbon atoms in the aromatic group is preferably from 6 to 20, more preferably from 6 to 15 and most preferably from 6 to 10. The aromatic group may have a substituent. Examples of the substituent include a halogen atom, a hydroxyl group, an aliphatic group, an aromatic group and a heterocyclic group.

It is preferred that the heterocyclic group has a 5-membered or 6-membered ring as the hetero ring. Another heterocyclic ring, an aliphatic ring or an aromatic ring may be fused with the heterocyclic ring. The heterocyclic group may have a substituent. Examples of the substituent include a halogen atom, a hydroxyl group, an oxo group (=O), a thioxo group (=S), an imino group (=NH), a substituted imino group (=N-R, wherein R represents an aliphatic group, an aromatic group or a heterocyclic group), an aliphatic group, an aromatic group and a heterocyclic group.

It is preferred that L represents a divalent linking group containing a plurality of polyoxyalkylene structures. It is more preferred that the polyoxyalkylene structure is a polyoxyethylene structure. In other words, it is preferred that L contains -(OCH₂CH₂)ₙ- (wherein n is an integer of 2 or more).

In the formula (U2), Y represents a carbon atom or a nitrogen atom. In the case where Y is a nitrogen atom and L is connected to Y to form a quaternary pyridinium group, Z is not essentially required and may represents a hydrogen atom, since the quaternary pyridinium group per se exhibits the absorptivity. L represents a divalent linking group same as in formula (U1) or a single bond.

The absorbing functional group is as described above.
Next, typical examples of the compounds represented by the formula (U1) or (U2) will be presented.

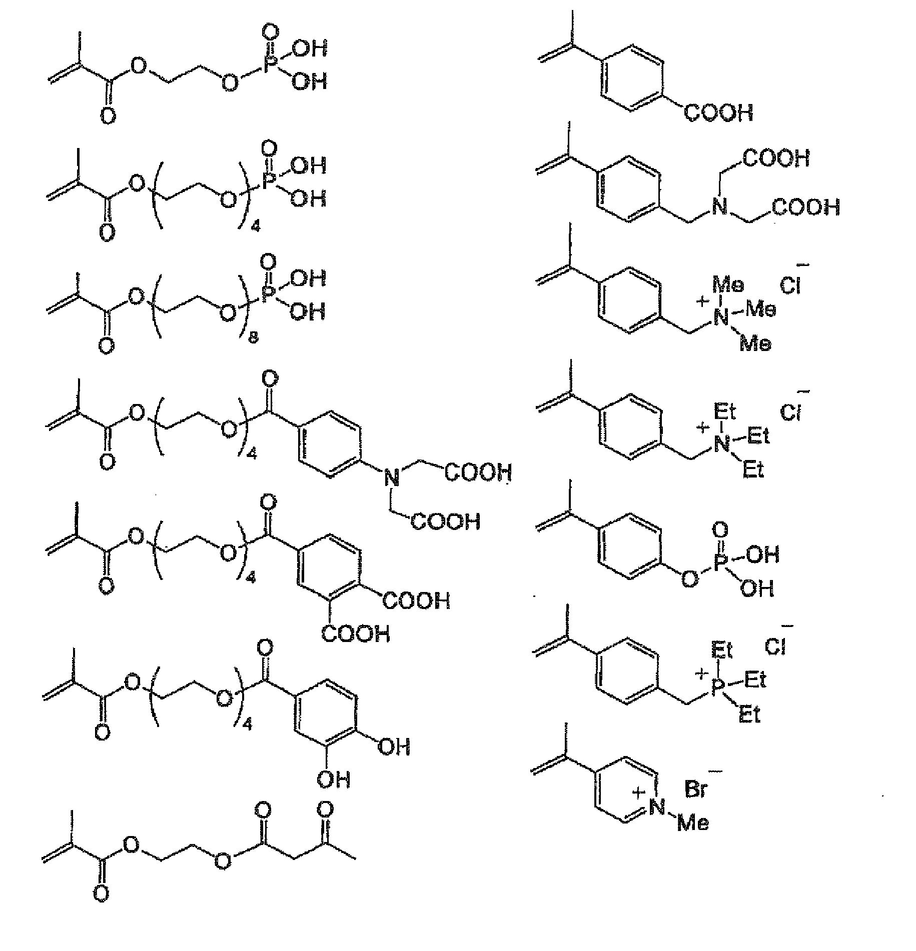

Preferable examples of the hydrophilic group in the polymer resin for the undercoat layer usable in the invention include a hydroxyl group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfo group and a phosphate group. Among them, a monomer having a sulfo group which exhibits a highly hydrophilicity is preferable. Specific examples of the monomer having a sulfo group include a sodium salt or an amine salt of methallyloxybenzenesulfonic acid, allyloxybenzenesulfonic acid, allylsulfonic acid, vinylsulfonic acid, p-styrenesulfonic acid, methallylsulfonic acid, acrylamido-t-butylsulfonic acid, 2-acrylamido-2-methylpropanesulfonic acid or (3-acryloyloxypropyl)buthylsulfonic acid. Among them, sodium salt of 2-acrylamido-2-methylpropanesulfonic acid is preferable from the viewpoint of the hydrophilicity and handling properties in the synthesis thereof.

It is preferred that the water-soluble polymer resin for the undercoat layer according to the invention has a crosslinkable group. The crosslinkable group contributes to the improvement in the adhesion to the image area. The crosslinkability can be imparted to the polymer resin for the undercoat layer by introducing a crosslinkable functional group such as an ethylenically unsaturated bond into the side chain of the polymer or by introducing a salt structure which is formed by a polar substituent of the polymer resin and a compound containing a substituent having a counter charge to the polar substituent of the polymer resin and an ethylenically unsaturated bond.

As an example of the polymer having the ethylenically unsaturated bond in the side chain of its molecule, there can be enumerated a polymer of an ester or amide of acrylic acid or methacrylic acid which is a polymer wherein the ester or amide residue (R in -COOR or -CONHR) has the ethylenically unsaturated bond.

Examples of the residue (R described above) having an ethylenically unsaturated bond include -(CH₂)ₙCR₁=CR₂R₃, -(CH₂O)ₙCH₂CR₁=CR₂R₃, -(CH₂CH₂O)ₙCH₂CR₁=CR₂R₃, -(CH₂)ₙNH-CO-O-CH₂CR₁=CR₂R₃, -(CH₂)ₙ-O-CO-CR₁=CR₂R₃ and -(CH₂CH₂O)₂-X (wherein R₁ to R₃ each represents a hydrogen atom, a halogen atom or an alkyl group having from 1 to 20 carbon atoms, an aryl group, alkoxy group or aryloxy group, or R₁ and R₂ or R₁ and R₃ may be bonded to each other to form a ring; n represents an integer of 1 to 10; and X represents a dicyclopentadienyl residue).

Specific examples of the ester residue include -CH₂CH=CH₂ (described in JP-B-7-21633), -CH₂CH₂O-CH₂CH=CH₂, -CH₂C(CH₃)-CH₂, -CH₂CH=CH-C₆H₅, -CH₂CH₂OCOCH=CH-C₆H₅, -CH₂CH₂-NHCOO-CH₂CH=CH₂ and -CH₂CH₂O-X (wherein X represents a dicyclopentadienyl residue).

Specific examples of the amido residue include -CH₂CH=CH₂, -CH₂CH₂O-Y (wherein Y represents a cyclohexene residue) and -CH₂CH₂OCO-CH=CH₂.

As the monomer having a crosslinkable group in the polymer resin for undercoat layer, use may be preferably made of an ester or an amide of acrylic acid or methacrylic acid having such a crosslinkable group as described above.

The content of the crosslinkable group in the polymer resin for undercoat layer (content of the radical polymerizable unsaturated double bond determined by iodine titration) is preferably from 0.1 to 10.0 mmol, more preferably from 1.0 to 7.0 mmol and most preferably from 2.0 to 5.5 mmol, per gram of the polymer resin. Within the above-described range, well-balanced sensitivity and stain resistance and a good storage stability can be achieved.

The mass-average molecular weight of the polymer resin for undercoat layer is preferably 5,000 or more, more preferably from 10,000 to 300,000. The number-average molecular weight of the polymer resin is preferably 1,000 or more, more preferably from 2,000 to 250,000. The polydispersity (mass- average molecular weight/number-average molecular weight) thereof is preferably from 1.1 to 10.

The polymer resin for undercoat layer may be any of a random polymer, a block polymer, a graft polymer and the like, and is preferably a random polymer.

The polymer resins for undercoat layer may be used either alone or as a mixture of two or more thereof. A coating solution for undercoat layer is obtained by dissolving the polymer resin for undercoat layer in an organic solvent (for example, methanol, ethanol, acetone or methyl ethyl ketone) and/or water. The coating solution for undercoat layer may contain an infrared absorbing agent.

In order to coat the coating solution for undercoat layer on the support, various known methods can be used. Examples of the method include bar coater coating, spin coating, spray coating, curtain coating, dip coating, air knife coating, blade coating and roll coating.

The coating amount (solid content) of the undercoat layer is preferably from 0.1 to 100 mg/m², and more preferably from 1 to 30 mg/m².

### «Printing method»

### <Exposure>

As preferable examples of the exposure light source to be used in the invention, there can be enumerated a solid laser or a semiconductor laser radiating infrared rays of 760 nm to 1,200 nm.

The output of the infrared laser is preferably 100 mW or more. It is preferable that the exposure time per pixel is not longer than 20 µsec. The irradiation energy preferably ranges from 10 to 300 mJ/cm². To shorten the exposure time, it is particularly preferable to use a multibeam laser device.

It is also possible in the invention to use a blue laser having a wavelength of 360 nm to 450 nm as the light source in image formation.

### <On-machine development>

The lithographic printing plate precursor having been exposed is mounted on the impression cylinder of a printing machine. In the case of a printing machine provided with a laser exposure device, the lithographic printing plate precursor is mounted on the impression cylinder of the printing machine and then imagewise exposed.

After imagewise exposing the lithographic printing plate precursor with a laser, a printing ink and dampening water are supplied and printing is conducted without resorting to any development step such as a wet development step. In an exposed area, the image-recording layer having been hardened by the exposure forms an oily ink-receiving area having lipophilic surface. In an unexposed area, on the other hand, the non-hardened image-recording layer is dissolved or dispersed in the supplied dampening water and/or printing ink and thus removed. In this area, therefore, the hydrophilic surface comes outward. As a result, the dampening water adheres to the hydrophilic surface thus revealed while the printing ink is deposited into the image-recording layer in the exposed area, thereby starting printing.

Although either the dampening water or the printing ink may be supplied first to the printing plate, it is preferred to supply the printing ink first so as to prevent the dampening water from contamination with the image-recording layer having been removed. As the dampening water and the printing ink, use can be made of a dampening water and a printing ink commonly employed in lithographic printing.

Thus, the lithographic printing plate precursor is on-machine developed on an offset printing machine and employed as such for printing of a number of sheets.
[0300]
[0045]

### <Development>

In the invention, it is also possible that, after exposure, the lithographic printing plate precursor is developed by using an automatic developing machine (automatic processor) and then subjected to printing.

The lithographic printing plate precursor according to the invention is imagewise exposed and then the plate is rubbed with a rubbing member in the presence of a developer of pH 2 to 10. Thus, the image-recording layer (and the protective layer, if present) in an unexposed area are removed so as to form an image on the surface of an aluminum plate support.

It is also possible to conduct water-washing before the development.

The developer to be used in the invention is an aqueous solution of pH 2 to 10. For example, water alone or an aqueous solution comprising water as the main component (containing 60% by mass or more of water) is preferred. In particular, an aqueous solution having a similar composition as publicly known dampening water, an aqueous solution containing a surfactant (anionic, nonionic, cationic, etc.) or an aqueous solution containing a water-soluble polymer compound is preferred. Among all, an aqueous solution containing both of a surfactant and water-soluble polymer compound is preferred. The pH value of the developer is preferably 3 to 8, more preferably 4 to 7.

Examples of the anionic surfactant usable in the invention include fatty acid salts, abietic acid salts, hydroxyalkanesulfonic acid salts, alkanesulfonic acid salts, dialkylsulfosuccinic ester salts, straight-chain alkylbenzenesulfonic acid salts, branched alkylbenzenesulfonic acid salts, alkylnaphthalenesulfonic acid salts, alkylphenoxypolyoxy ethylene propylsulfonic acid salts, polyoxyethylene alkylsulfophenyl ether salts, N-methyl-N-oleyltaurine sodium salt, N-alkylsulfosuccinic monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styrylphenyl ether sulfate ester salts, alkyl phosphate ester salts, polyoxyethylene alkyl ether phosphate ester salts, polyoxyethylene alkyl phenyl ether phosphate ester salts, partial saponification products of styrene/maleic anhydride copolymer, partial saponification products of olefin/maleic anhydride copolymer and naphthalene sulfonate formalin condensates. Among them, it is particularly preferable to use dialkylsulfosuccinic ester salts, alkyl sulfate ester salts and alkylnaphthalenesulfonic acid salts.

The cationic acid usable in the invention is not particularly restricted. Namely, any publicly known ones may be used. Examples thereof include alkylamine salts, quaternary ammonium salts, polyoxyethylene alkyl amine salts and polyethylene polyamine derivatives.

Examples of the nonionic surfactant usable in the invention include polyethylene glycol type higher alcohol ethylene oxide adducts, alkylphenol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, fat ethylene oxide adducts, polypropylene glycol ethylene oxide adducts, dimethylsiloxane-ethylene oxide block copolymer, dimethylsiloxane-(propylene oxide-ethylene oxide) block copolymer, polyhydric alcohol type glycerol fatty acid esters, pentaerythritol fatty acid esters, sorbitol and sorbitan fatty acid esters, sucrose fatty acid esters, polyhydric alcohol alkyl ethers and alkanolamine fatty acid amides.

Either one of these nonionic surfactants or a mixture of two or more kinds of the same may be used. In the invention, sorbitol and/or sorbitan fatty acid ester ethylene oxide adducts, polypropylene glycol ethylene oxide adducts, dimethylsiloxane-ethylene oxide block copolymer, dimethylsiloxane-(propylene oxide-ethylene oxide) block copolymer and polyhydric alcohol fatty acid esters are more preferable.

From the viewpoint of the stable solubility or miscibility in water, it is preferable that the nonionic surfactant to be used in the invention has an HLB (hydrophile-lipophile balance) value of 6 or more, still preferably 8 or more. The amount of the nonionic surfactant contained in the developer is preferably 0.01 to 10% by mass, still preferably 0.01 to 5% by mass.

Also, use can be made of acetylene glycol type and acetylene alcohol type oxyethylene adducts and fluorine-based and silicone-based surfactants.

From the viewpoint of foaming properties, a nonionic surfactant is particularly preferable as the surfactant to be used in the developer of the invention.

Examples of the water-soluble polymer compound to be used in the developer according to the invention include soybean polysaccharide, modified starch, gum arabic, dextrin, cellulose derivatives (for example, carboxymethyl cellulose, carboxyethyl cellulose and methyl cellulose) and modified products thereof, pullulan, polyvinyl alcohol and derivatives thereof, polyvinyl pyrrolidone, polyacrylamide and acrylamide copolymers, vinyl methyl ether/maleic anhydride copolymers, vinyl acetate/maleic anhydride copolymers and styrene/maleic anhydride copolymers.

As the soybean polysaccharide as described above, use can be made of publicly known ones. For example, as a commercial product, Soyafive (trade name, manufactured by Fuji Oil Co., Ltd.) is available and various grade products can be used. The soybean polysaccharide preferably usable herein is one having a viscosity in a range from 10 to 100 mPa/sec in a 10% by mass aqueous solution thereof.

As the modified starch, known modified starch can be used. The modified starch can be prepared by, for example, a method which comprises digesting starch of corn, potato, tapioca, rice, wheat or the like with the use of an acid, an enzyme, etc. to give 5 to 30 glucose residues per molecule and then adding oxypropylene thereto in an alkali.

Two or more kinds of the water-soluble polymer compounds may be used in combination. The content of the water-soluble polymer compound in the developer is preferably from 0.1 to 20% by mass, more preferably from 0.5 to 10% by mass.

The developer to be used in the invention may further contain an organic solvent. Examples of the organic solvent which can be contained include aliphatic hydrocarbons (for example, hexane, heptane, "ISOPER E, H, G" (manufactured by Esso Kagaku), gasoline, kerosene), aromatic hydrocarbons (for example, toluene, xylene), halogenated hydrocarbons (for example, methylene dichloride, ethylene dichloride, trichlene, monochlorobenzene) and polar solvents.

Examples of the polar solvent include alcohols (for example, methanol, ethanol, propanol, isopropanol, benzyl alcohol, ethylene glycol monomethyl ether, 2-ethoxy ethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methyl phenyl carbinol, n-amyl alcohol, methylamyl alcohol), ketones (for example, acetone, methyl ethyl ketone, ethyl butyl ketone, methyl isobutyl ketone, cyclohexanone), esters (for example, ethyl acetate, propyl acetate, butyl acetate, amyl acetate, benzyl acetate, methyl lactate, butyl lactate, ethylene glycol monobutyl acetate, propylene glycol monomethyl ether acetate, diethylene glycol acetate, diethyl phthalate, butyl levulinate) and others (for example, triethyl phosphate, tricresyl phosphate, N-phenyl ethanolamine, N-phenyl diethanolamine).

In the case where the organic solvent as described above is insoluble in water, it can be solubilized in water by using a surfactant or the like before using. In the case where the developer contains an organic solvent, it is preferable from the viewpoints of safety and inflammability that the concentration of the solvent is less than 40% by mass.

In addition to the components as cited above, the developer of the invention may contain an antiseptic agent, a chelating compound, a defoaming agent, an organic acid, an inorganic acid, an inorganic salt or the like.

Preferable examples of the antiseptic agent include phenol or its derivative, formalin, imidazole derivatives, sodium dehydroacetate, 4-isothiazolin-3-one derivatives, benzisotiazolin-3-one, benzotriazole derivatives, amidine guanidine derivatives, quaternary ammonium salts, pyridine derivatives, quinoline derivatives, guanidine derivatives, diazine, triazole derivatives, oxazole, oxazine derivatives and nitro bromo alcohols such as 2-bromo-2-nitropropane-1,3-diol, 1,1-dibromo-1-nitro-2-ethanol and 1,1-dibromo-1-nitro-2-propanol.

Examples of the chelating compound include ethylenediaminetetraacetic acid, potassium salt thereof, sodium salt thereof; diethylenetriaminepentaacetic acid, potassium salt thereof, sodium salt thereof; triethylenetetraminehexaacetic acid, potassium salt thereof, sodium salt thereof; hydroxyethylethylenediaminetriacetic acid, potassium salt thereof, sodium salt thereof, nitrilotriacetic acid, sodium salt thereof; 1-hydroxyethane-1,1-diphosphonic acid, potassium salt thereof, sodium salt thereof; organic phosphonic acids, for example, organic phosphonic acids such as aminotri(methylenephosphonic acid), potassium salt thereof, sodium salt thereof, and phophonoalkanetricarboxylic acids. A salt of an organic amine is also effectively usable in place of the sodium salt or potassium salt in the chelating agents as described above.

As the defoaming agent, use can be made of, for example, a commonly employed silicone-based self-emulsifying type or emulsifying type defoaming agent, and a nonionic surfactant having HLB of 5 or less. A silicone defoaming agent is preferably used. Either an emulsifying dispersing type or a solubilizing type can be used.

Examples of the organic acid include citric acid, acetic acid, oxalic acid, malonic acid, salicylic acid, caprylic acid, tartaric acid, malic acid, lactic acid, levulinic acid, p-toluenesulfonic acid, xylenesulfonic acid, phytic acid and an organic phosphonic acid. The organic acid can also be used in the form of an alkali metal salt or an ammonium salt.

Examples of the inorganic acid and inorganic salt include phosphoric acid, methaphosphoric acid, ammonium primary phosphate, ammonium secondary phosphate, sodium primary phosphate, sodium secondary phosphate, potassium primary phosphate, potassium secondary phosphate, sodium tripolyphosphate, potassium pyrophosphate, sodium hexamethaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate and nickel sulfate.

The developer described above can be used as a developer and a development replenisher for an exposed negative-working lithographic printing plate precursor. It is preferably applied to an automatic processor as will be described hereinafter. In the case of conducting the development processing using an automatic processor, the developer becomes fatigued with an increase in the processing amount. In such a case, the processing ability may be restored by using a replenisher or a fresh developer. Such a replenishment system can be preferably applied to the plate-making method of the lithographic printing plate precursor with the use of the lithographic printing plate precursor according to the invention.

The development processing using the aqueous solution having pH of 2 to 10 according to the invention is preferably performed by using an automatic processor equipped with a supplying means for a developer and a rubbing member. As the automatic processor, there can be enumerated an automatic processor in which a lithographic printing plate precursor after image-recording is subjected to a rubbing treatment while it is transporting as described in JP-A-2-220061 and JP-A-60-59351; and an automatic processor in which a lithographic printing plate precursor after image-recording placed on a cylinder is subjected to a rubbing treatment while rotating the cylinder as described in U.S. Patents 5,148,746 and 5,568,768 and British Patent 2,297,719. Among them, the automatic processor using a rotating brush roll as the rubbing member is particularly preferred.

The rotating brush roll preferably usable in the invention can be appropriately selected by taking account, for example, of scratch resistance of the image area and nerve strength of the support of the lithographic printing plate precursor.

As for the rotating brush roll, a publicly known rotating brush roll produced by implanting a brush material in a plastic or metal roller can be used. For example, use can be made of a rotating brush roll described in JP-A-58-159533 and JP-A-3-100554, or a brush roll described in JP-B-62-167253, in which a metal or plastic groove-type member having implanted therein in rows a brush material is closely radially wound around a plastic or metal roller acting as a core. As the brush material, a plastic fiber (for example, a polyester-based synthetic fiber such as polyethylene terephthalate or polybutylene terephthalate; a. polyamide-based synthetic fiber such as nylon 6.6 or nylon 6.10; a polyacrylic synthetic fiber such as polyacrylonitrile or polyalkyl(meth)acrylate; and a polyolefin-based synthetic fiber such as polypropylene or polystyrene) can be used. It is preferable to use a brush material having a fiber bristle diameter of 20 to 400 µm and a bristle length of 5 to 30 mm.

The outer diameter of the rotating brush roll is preferably from 30 to 200 nm, and the peripheral velocity at the tip of the brush rubbing the plate surface is preferably from 0.1 to 5 m/sec.

Further, it is preferred to use a plurality, that is, two or more of the rotating brush rolls.

The rotary direction of the rotating brush roll to be used in the invention may be the same direction as the transporting direction of the lithographic printing plate precursor of the invention or the opposite direction thereto. In the case of using two or more rotating brush rolls in an automatic processor as shown in Fig. 1, it is preferred that at least one rotating brush roll rotates in the same direction as the transporting direction of the lithographic printing plate precursor of the invention and at least one rotating brush roll rotates in the opposite direction thereto. Owing to such arrangement, the image-recording layer in an non-image area can be more steadily removed. Further, it is also effective that the rotating brush roll is reciprocated in the rotation axis direction of the brush roll.

Although the developing solution can be used at an arbitrary temperature, the temperature is preferably from 10°C to 50°C.

In the invention, the lithographic printing plate having been rubbed may be subsequently subjected to water washing, a drying treatment and an oil-desensitization treatment, if desired. In the oil-desensitization treatment, use can be made of a publicly known oil-desensitizing solution.

Further, in a plate-making process whereby a lithographic printing plate is obtained from the lithographic printing plate precursor according to the invention, the entire surface of the lithographic printing plate precursor may be heated, if desired, during the exposure and the development. By this heating treatment, the image-forming reaction in the image-recording layer (photosensitive layer) is accelerated to thereby bring about advantages such as improvement in the sensitivity and printing durability and stabilization of the sensitivity.

In order to improve the image strength and printing durability, it is also effective to perform entire after-heating or entire exposure of the image after the development. In usual, the heating before the development is preferably performed under a mild condition of 150°C or lower. When the temperature is too high, there arises a problem such as undesirable fogging in a non-image area. On the other hand, the heating after the development can be performed under a very strong condition. That is, the heat treatment is carried out usually within a temperature range of 200 to 500°C. When the temperature is too low, a sufficient effect of strengthening the image may not be obtained. When the temperature is excessively high, on the other hand, there arise problems of deterioration of the support and thermal decomposition of the image area.

The lithographic printing plate obtained through the above-described treatments is mounted on an off-set printing machine and subjected to printing a large number of sheets.

For removing scumming on the plate at the printing, use is made of a conventionally known plate cleaner for PS plates such as CL-1, CL-2, CP, CN-4, CN, CG-1, PC-1, SR and IC (all produced by Fuji Photo Film Co., Ltd.).

### EXAMPLES

Next, the present invention will be described in greater detail by referring to the Examples, however, the present invention should not be construed as being limited to these Examples.

### [Preparation of lithographic printing plate precursor for infrared laser]

### [Example 1]

### (1) Preparation of support 1

An aluminum plate (material: 1050) having a thickness of 0.3 mm was subjected to a degreasing treatment at 50°C for 30 seconds using a 10% by mass aqueous sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/cm³) of pumice having a median size of 25 µm, followed by thorough washing with water. The plate was subjected to etching by dipping in a 25% by mass aqueous sodium hydroxide solution of 45°C for 9 seconds, washed with water, then immersed in a 20% by mass aqueous nitric acid solution at 60°C for 20 seconds, and washed with water. The etching amount of the grained surface was about 3 g/m².

Then, using an alternating current of 60 Hz, an electrochemical roughening treatment was continuously carried out on the plate. The electrolyte used was a 1% by mass aqueous nitric acid solution (containing 0.5% by mass of aluminum ion) and the electrolyte temperature was 50°C. The electrochemical roughening treatment was conducted using an alternating current source, which provides a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/dm² in terms of the peak value of the electric current, and 5% of the electric current flowing from the electric source was divided to the auxiliary anode. The quantity of electricity in the nitric acid electrolysis was 175 C/dm² in terms of the quantity of electricity when the aluminum plate functioned as an anode. The plate was then washed with water by spraying.

The plate was further subjected to an electrochemical roughening treatment in the same manner as in the nitric acid electrolysis above using as an electrolyte, a 0.5% by mass aqueous hydrochloric acid solution (containing 0.5% by mass of aluminum ion) having temperature of 50°C and under the condition that the quantity of electricity was 50 C/dm² in terms of the quantity of electricity when the aluminum plate functioned as an anode. The plate was then washed with water by spraying. The plate was subjected to an anodizing treatment using as an electrolyte, a 15% by mass aqueous sulfuric acid solution (containing 0.5% by mass of aluminum ion) at a current density of 15 A/dm² to form a direct current anodized film of 2.5 g/m², washed with water and dried. The center line average roughness (Ra) of the substrate was measured using a stylus having a diameter of 2 µm and it was found to be 0.51 µm. An undercoat solution (1) shown below was coated on the substrate described above so as to have a dry coating amount of 6 mg/m² to thereby prepare a support.

### -Undercoat solution (1)-

| | |
|---|---|
| Undercoat compound (1) (Mw 60,000) | 0.017 g |
| Methanol | 9.00 g |
| Water | 1.00 g |

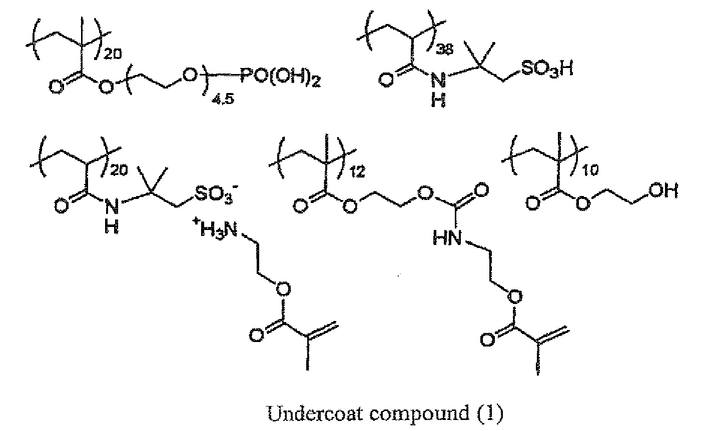

### (2) Formation of image-recording layer and protective layer

A coating solution (1) for image-recording layer having the composition shown below was bar-coated on the above-described support having the undercoat layer and dried in an oven at 100°C for 60 seconds to form an image-recording layer having a dry coating amount of 1.0 g/m². Subsequently, a coating solution (1) for protective layer having the composition shown below was bar-coated on the above-described image-recording layer and dried in an oven at 120°C for 60 seconds to form a protective layer having a dry coating amount of 0.160 g/m². Thus, a lithographic printing plate precursor (1) was obtained.

The coating solution (1) for image-recording layer was obtained by mixing the photosensitive solution with the microgel solution shown below under stirring immediately before coating.

### -Photosensitive solution-

| | |
|---|---|
| Binder polymer (1) (Mw 80,000) | 0.177 g |
| (B) Radical generator (compound I-28) | 0.142 g |
| (C) Infrared absorbing agent (1) | 0.0308 g |
| (D) Polymerizable monomer (Aronics M-315, produced by Toagosei Co., Ltd.) | 0.319 g |
| (C) Specific polymer compound (Compound 1, Mw 30,000) | 0.035 g |
| Fluorine-based surfactant (1) | 0.004 g |
| Anionic surfactant (Pionin A-24-EA: produced by Takemoto Oil and Fat Co., Ltd., 40% by mass aqueous solution) | 0.125 g |
| Methyl ethyl ketone | 2.554 g |
| 1-Methoxy-2-propanol | 7.023 g |

### -Microgel solution-

| | |
|---|---|
| Microgel dispersion (1) | 1.800 g |
| Water | 1.678 g |

Synthesis of the microgel dispersion (1) to be used in the microgel solution and the structures of other compounds will be shown below.

### -Synthesis of microgel dispersion (1)-

As oil phase components, 10.0 g of an adduct of trimethylol propane and xylene diisocyanate (Takenate D-110N, produced by Mitsui Takeda Chemical Co., Ltd., a 75% by mass ethyl acetate solution), 6.00 g of a polymerizable monomer Aronics M-215 (manufactured by Toagosei Co., Ltd.) and 0.17 g of Pionin A-41C (manufactured by Takemoto Oil and Fat Co., Ltd.) were dissolved in 16.67 g of ethyl acetate. As an aqueous phase component, 37.5 g of an aqueous 4% by mass solution of PVA-205 was prepared. The oil phase components and the aqueous phase component were mixed and emulsified by using a homogenizer at 12,000 rpm for 10 minutes. The resulting emulsion was added to 25 g of distilled water and stirred at a room temperature for 30 minutes and then at 40°C for 2 hours. The thus obtained microgel dispersion was diluted with distilled water so as to control the solid concentration thereof to 21% by mass. Thus, the microgel dispersion (1) was obtained. The average particle size of the microgel was 0.23 µm.

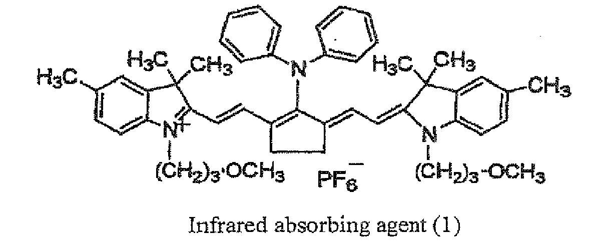

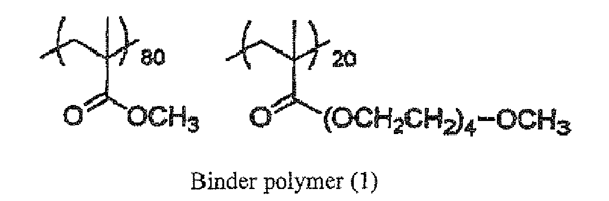

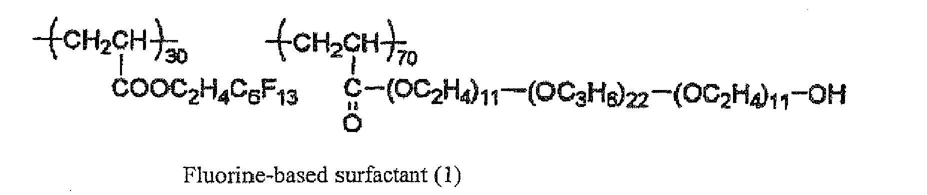

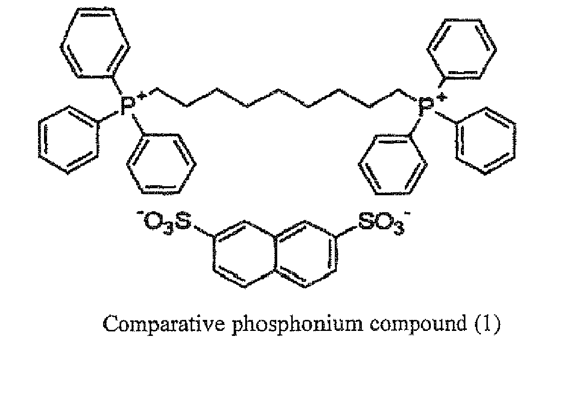

### -Coating solution (1) for protective layer-

| | |
|---|---|
| Stratiform compound dispersion shown below | 1.5 g |
| Polyvinyl alcohol (PVA105, | 0.06 g |
| manufactured by Kuraray Co., Ltd., saponification degree: 98.5% by mol, polymerization degree: 500) | |
| Polyvinyl pyrrolidone (K30, manufactured by Tokyo Kasei Kogyo Co., Ltd., Mw: 40,000) | 0.01 g |
| Vinyl pyrrolidone/vinyl acetate copolymer | 0.01 g |
| (LUVITEC VA64W, manufactured by ICP, copolymerization ratio: 6/4) | |
| Nonionic surfactant (Emalex 710, manufactured by Nihon Emulsion Co., Ltd.) | 0.013 g |
| Ion-exchanged water | 6.0 g |

### -Preparation of stratiform compound dispersion (1)-

To 193.6 g of ion-exchanged water, 6.4 g of Somacif ME-100 (manufactured by CO-OP Chemical Co., Ltd.) was added and dispersed with a homogenizer until the average particle size (determined by the laser scattering method) attained 3 µm. The inorganic particles thus dispersed had an aspect ratio of 100 or more.

### [Examples 2 to 12]

Lithographic printing plate precursors (2) to (12) were prepared in the same manner as in Example 1 except for using different kinds of the specific polymer compounds in the photosensitive solution for image-recording layer of Example 1 as listed in Table 1.

### [Comparative Example 1]

A comparative lithographic printing plate precursors (R1) was prepared in the same manner as in Example 1 except for using a phosphonium compound as a substitute for the specific polymer compound in the photosensitive solution for image-recording layer of Example 1 as listed in Table 1.

### [Evaluation of lithographic printing plate precursor]

The obtained lithographic printing plate precursors (1) to (12) and (R1) were exposed using a Trendsetter 3244 VX (manufactured by Creo Inc.) equipped with a water-cooled 40 W infrared semiconductor laser at an output of 11.7 W, an external drum speed of 250 rpm, and a resolution of 2,400 dpi. Next, the on-machine developability, ink deposition properties and printing durability were evaluated by the following methods. Table 1 summarizes the results.

### (Evaluation of on-machine developability)

An exposed lithographic printing plate precursor was not developed but mounted as such on the cylinder of an SOR-M printing machine (manufactured by Heidelberger Druckmaschinen AG). Using dampening water (EU-3, (an etchant manufactured by Fuji Photo Film Co., Ltd.)/water/isopropyl alcohol=1/89/10 by volume) and TRANS-G (N) India ink (manufactured by Dainippon Ink and Chemicals, Inc.), first the dampening water and the ink were supplied to the plate, and then printing was conducted at a press speed of 6,000 sheets per hour. The on-machine developability was measured as the number of sheets of printing paper required until the ink was no longer be transferred to unexposed area (non-image area) of the image-recording layer the printing paper. A smaller number of sheets means the better on-machine developability.

### (Evaluation of ink deposition properties)

As the increase in a number of printing, the ink-receptive properties of the image-recording layer were gradually lowered to cause decrease in the ink density on the printing papers. The ink deposition properties were evaluated as a number of printing papers wherein the ink density (reflection density) decreased by 0.1 compared with that at the initiation of printing. A larger number of sheets means the better ink deposition properties.

### (Evaluation of printing durability)

As the printing is further continued and the number of printing papers increased, the image-recording layer was gradually abraded to cause decrease in ink-receptive properties, thereby resulting in a decrease in the ink density on the printing papers. The printing durability was evaluated as a number of printing papers wherein the ink density (reflection density) decreased by 0.1 compared with that at the initiation of printing. A larger number of sheets means the better printing durability.

### [Preparation of lithographic printing plate precursor for violet laser]

### [Example 13]

### (1) Preparation of support 2

A support 2 having an undercoat layer to be used in the following experiments was prepared by the same method as in preparing the support 1 employed in Examples 1 to 12 except for forming the undercoat layer in the manner shown below.

### (Formation of undercoat layer)

An undercoat solution (2) shown below was bar-coated and dried in an oven at 80°C for 10 seconds so as to have a dry coating amount of 10 mg/m².

### -Undercoat solution (2)-

| | |
|---|---|
| Undercoat compound (2) | 0.017 g |
| Methanol | 9.00 g |
| Water | 1.00 g |

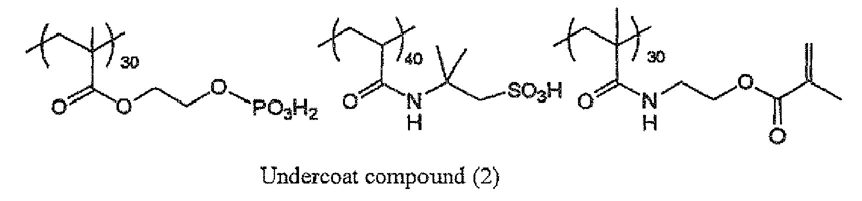

### (2) Formation of image-recording layer and protective layer

A coating solution (2) for image-recording layer having the composition shown below was bar-coated on the above-described support having the undercoat layer and dried in an oven at 70°C for 60 seconds to form an image-recording layer having a dry coating amount of 1.1 g/m². Upon this, a coating solution (2) for protective layer having the composition shown below was bar-coated and dried in an oven at 125°C for 70 seconds to form a protective layer having a dry coating amount of 0.75 g/m². Thus, a lithographic printing plate precursor (13) was obtained.

### -Coating solution (2) for image-recording layer-

| | |
|---|---|
| Binder Polymer (1) shown above (Mw 80,000) | 0.54 g |
| (D) Polymerizable monomer (iocyanuric acid EO-denatured triacrylate) (ARONIX M-315, manufactured by TOAGOSEI Co., Ltd.) | 0.40 g |
| (D) Polymerizable monomer (ethoxylated | 0.08 g |
| trimethylolpropane triacrylate; SR9035, added EO moles: 15, molecular weight 1000; manufactured by NIPPON KAYAKU Co., Ltd.) | |
| (C) Specific polymer compound (compound 3, Mw 40,000) | 0.018 g |
| (A) Sensitizing dye (1) shown below | 0.06 g |
| (B) Radical generator (1) shown below | 0.18 g |
| Cosensitizer (1) shown below | 0.07 g |
| ε-phthalocyanine pigment dispersion (pigment: 15 parts by mass, dispersant binder polymer (1): 10 parts by mass, solvent: cylohexane/methoxypropyl acetate/1-methoxy-2-propanol=15 parts by mass/20 parts by mass/-40 parts by mass) | 0.40 g |
| Heat polymerization inhibitor | 0.01 g |
| N-introsphenylhydrxylamine aluminum salt Fluorinated surfactant (1) shown above | 0.001 g |
| Polyoxyethylene-polyoxypropylene condensate (Pluronic L44, manufactured by ADEKA Co.) | 0.04 g |
| Tetraethylamine hydrochloride | 0.01 g |
| 1-Methoxy-2-propanol | 3.5 g |
| Methyl ethyl ketone | 8.0 g |

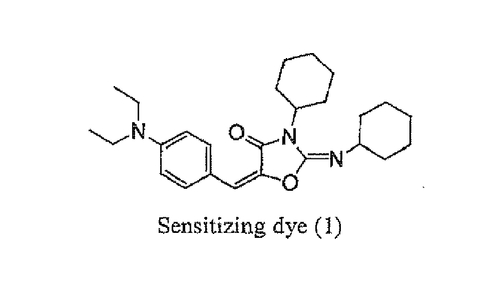

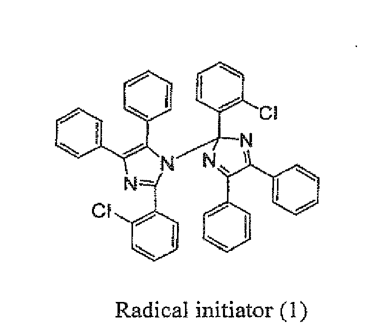

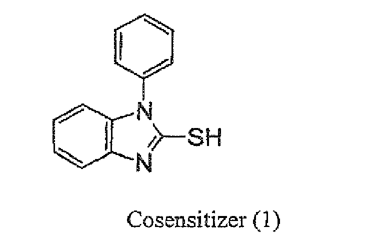

### -Coating solution (2) for protective layer-

| | |
|---|---|
| Mica dispersion (1) shown below | 13.0 g |
| Polyvinyl alcohol (saponification degree: 98.5% by mol, polymerization degree: 500) | 1.3 g |
| Sodium 2-ethylhexylsulfosuccinate | 0.2 g |
| Poly(vinylpyrrolidone/vinyl acetate (1/1) MW 70,000) | 0.05 g |
| Surfactant (Emalex 710, manufactured by Nihon Emulsion Co., Ltd.) | 0.05 g |
| Water | 133.0 g |

### -Preparation of mica dispersion (2)-

To 368 g of water, 32 g of Somacif ME-100 (manufactured by CO-OP Chemical Co., Ltd., aspect ratio: 1,000 or more) was added and dispersed with a homogenizer until the average particle size (determined by the laser scattering method) attained 0.5 µm. Thus, the mica dispersion (1) was obtained.

### [Evaluation of lithographic printing plate precursor]

### (1) Exposure

Using the lithographic printing plate precursor (13) as described above, plain dot of 35% was imaged by the quantity of printing plate exposure of 90 µJ/cm² and the resolution of the image of 2,438 dpi with the use of an FM screen (TAFFETA 20, manufactured by Fuji Photo Film Co., Ltd.).

As the exposure device, use was made of a violet semiconductor laser plate setter Vx9600 (loading InGaN system semiconductor laser, emission 405 nm ±10 nm /output 30 mW, manufactured by Fuji Film Electronic Imaging Ltd.).

### (2) Development

After the exposure, the lithographic printing plate precursor was developed using a developer (1) having the following composition on an automatic developing machine having the structure shown in Fig. 1. The developer had a pH value of about 5. The automatic developing machine was an automatic processor equipped with two rotating brush rolls. One of these rotating brush rolls, which was a brush roll having an outer diameter of 90 mm and having polybutylene terephthalate fiber bristles (fiber bristle diameter: 200 µm, fiber bristle length: 17 mm) implanted therein, was rotated in the same direction as the transporting direction of the lithographic printing plate precursor at 200 rpm (peripheral velocity at the tip of the brush: 0.94 m/sec.). The second brush roll, which was a brush roll having an outer diameter of 60 mm and having polybutylene terephthalate fiber bristles (fiber bristle diameter: 200 µm, fiber bristle length: 17 mm) implanted therein, was rotated in the opposite direction to the transporting direction at 200 rpm (peripheral velocity at the tip of the brush: 0.63 m/sec.). The lithographic printing plate precursor was transported at a velocity of 100 cm/min.

The developer was supplied on the plate by showering from a spray pipe using a circulation pump. The developer tank had a capacity of 10 L.

### -Developer (1)-

| | |
|---|---|
| Water | 100 g |
| Benzyl alcohol | 1 g |
| Polyoxyethylene naphthyl ether (average oxyethylene number n=13) | 1 g |
| Sodium salt of dioctyl sulfosuccinate | 0.5 g |
| Gum arabic | 1 g |
| Ethylene glycol | 0.5 g |
| Ammonium primary phosphate | 0.05 g |
| Citric acid | 0.05 g |
| Tetrasodium ethylenediamine tetraacetate | 0.05 g |

### (3) Printing evaluation

The developed printing plate was evaluated in the same manner as in Examples 1 to 12. Since printing was started after the completion of the development in Example 13, ink deposition properties and printing durability were exclusively evaluated. Table 1 summarizes the results.

**Table 1**

| | Specific polymer compound | | Evaluation results | | |
|---|---|---|---|---|---|
| | Compound no. | Mass-average molecular weight (x10⁴) | On-machine developability (sheets) | Ink deposition properties (sheets) | Printing durability (sheets) |
| Example 1 | 1 | 3.0 | 20 | 10000 | 60000 |
| Example 2 | 3 | 4.0 | 18 | 9000 | 60000 |
| Example 3 | 4 | 3.1 | 15 | 8000 | 60000 |
| Example 4 | 3 | 0.8 | 15 | 7000 | 60000 |
| Example 5 | 7 | 4.0 | 20 | 7000 | 60000 |
| Example 6 | 8 | 3.2 | 23 | 7000 | 60000 |
| Example 7 | 5 | 3.3 | 25 | 9000 | 60000 |
| Example 8 | 6 | 3.1 | 22 | 9000 | 60000 |
| Example 9 | 11 | 3.6 | 16 | 9000 | 60000 |
| Example 10 | 13 | 3.2 | 18 | 9000 | 60000 |
| Example 11 | 15 | 3.3 | 22 | 9000 | 65000 |
| Example 12 | 18 | 2.9 | 20 | 9000 | 60000 |
| Comp. Example 1 | Phosphonium compound (1) | - | 20 | 1000 | 60000 |
| Example 13 | 3 | 4.0 | - | 9000 | 60000 |

As Table 1 clearly shows, the lithographic printing plate precursors using the specific polymer compounds according to the invention showed high printing durability and excellent on-machine developability and ink deposition properties.

## Claims

1. A lithographic printing plate precursor comprising: a support; an image-recording layer; and a protective layer in this order, wherein the protective layer comprises a stratiform compound and the image-recording layer comprises a polymer compound having a phosphonium structure in a side chain.

2. The lithographic printing plate precursor as claimed in Claim 1, wherein the phosphonium structure is represented by the following formula (1): 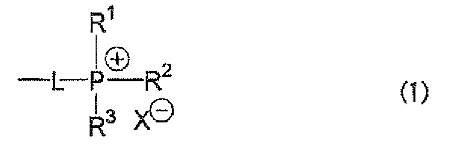 wherein R¹ to R³ each independently represents an alkyl group, an alkenyl group, an alkynyl group, an aryl group or a heterocyclic group, or at least two of R¹ to R³ may be bonded together to form a cyclic structure; X⁻ represents an anion; and L represents a linking group bonded to a main chain of the polymer.

3. The lithographic printing plate precursor as claimed in Claim 1 or 2, wherein the image-recording layer comprises a sensitizing dye, a radical generator and a polymerizable monomer.

4. The lithographic printing plate precursor as claimed in Claim 3, wherein the polymerizable monomer is an addition-polymerizable compound having at least one ethylenically unsaturated double bond.

5. The lithographic printing plate precursor as claimed in Claim 3 or 4, wherein the image-recording layer further comprises microcapsule or microgel.

6. The lithographic printing plate precursor as claimed in any one of Claims 3 to 5, wherein the image-recording layer further comprises a binder polymer.

7. The lithographic printing plate precursor as claimed in any one of Claims 3 to 6, wherein the image-recording layer further comprises a surfactant.

8. The lithographic printing plate precursor as claimed in any one of Claims 1 to 7, wherein the image-recording layer comprises the polymer compound having a phosphonium structure in a side chain in an amount of from 0.0005% by mass to 30.0% by mass based on a total solid content of the image-recording layer.

9. The lithographic printing plate precursor as claimed in any one of Claims 1 to 8, wherein the image-recording layer allows image formation by, after exposure, supplying a printing ink and dampening water to the lithographic printing plate precursor on a printing machine to remove the image-recording layer in an unexposed area.

10. A printing method comprising: a step of imagewisely exposing the lithographic printing plate precursor as claimed in Claim 9; and a printing step of supplying an oily ink and dampening water to the exposed lithographic printing plate precursor without conducting any development treatment, wherein the image-recording layer in an unexposed area is removed during the printing step.
